# EUROPEAN PATENT APPLICATION

(11) **EP 1 962 139 A1**
(43) Date of publication of application: **27.08.2008**
(21) Application number: 08003265.9
(22) Date of filing: 22.02.2008
(51) Int. Cl.: G03F 7/031, G03F 7/038

(54) **Negative resist composition and pattern forming method using the same**

(30) Priority: 23.02.2007 JP 2007043472; 08.02.2008 JP 2008029397
(71) Applicant: FUJIFILM Corporation, Minato-ku Tokyo (JP)
(72) Inventor: Hoshino, Wataru, Haibara-gun Shizuoka (JP); Wada, Kenji, Haibara-gun Shizuoka (JP)
(74) Representative: HOFFMANN EITLE

(57) **Abstract**

A negative resist composition includes: (A) a compound having at least one episulfide structure (a three-membered ring structure comprising two C atoms and one S atom); (B) an alkali-soluble resin; and (C) a compound capable of generating an acid upon irradiation with actinic rays or radiation, and a pattern forming method using the composition.

## Description

### Background of the Invention

### 1, Field of the Invention

The present invention relates to a negative resist composition used in the production of a circuit board of semiconductors such as IC, liquid crystal display devices, thermal heads and the like, and in the lithography process of other photo-applications, and a pattern forming method using the resist composition. More specifically, the present invention relates to a negative resist composition suitable for exposure by a projection exposure apparatus using a light source of emitting far ultraviolet light at a wavelength of 200 nm or less, and a pattern forming method using the resist composition.

### 2. Description of the Related Art

In recent years, the density and integration in a semiconductor device are increasingly becoming higher. To cope with this progress, finer pattern processing is required. In order to meet this requirement, the wavelength of the exposure apparatus used for photolithography becomes shorter and shorter, and studies are being made at present even on use of a short-wavelength excimer laser light (e.g., XeCl, KrF, ArF) out of far ultraviolet rays.

The resist composition includes "a positive type" using a resin sparingly-soluble or insoluble in a developer, which is exposed with radiation to make soluble the exposed area in the developer and thereby forms a pattern, and "a negative type" using a resin soluble in a developer, which is exposed with radiation to make sparingly-soluble or insoluble in the developer and thereby forms a pattern. Out of these, a positive resist composition is mainly used in practice at present.

In the fabrication of a semiconductor device or the like, various patterns such as line, trench and hole need to be formed. Higher resolution is demanded as the pattern becomes finer and in order to achieve this, a mask giving a high optical contrast is preferably used. When this mask giving a high optical contrast is used, a positive resist composition is advantageous in forming a line pattern, and a negative resist composition is advantageous in forming a trench pattern. Accordingly, for satisfying the requirement of formation of various patterns, not only a positive resist composition but also a negative resist composition are demanded to develop.

In the case of using a KrF excimer laser of emitting light at 248 nm as the exposure light source, a negative resist composition using a polymer where an acetal or ketal group is introduced as a protective group into a hydroxystyrene-based polymer having small light absorption has been proposed. This composition is suitable for exposure using a KrF excimer laser, but when an ArF excimer laser is used, sensitivity decreases due to strong absorption of light at 193 nm and a problem such as deterioration of resolution is incurred. Accordingly, such a composition is not suitable for exposure using an ArF excimer laser.

In this meaning, development of a negative resist material more reduced in the absorption of light at 193 nm and assured of both good sensitivity and high dry etching resistance is demanded, and development of a resist suitable for ArF exposure and capable of giving good sensitivity and high resolution is pressing.

As regards the resist for ArF exposure, there has been proposed a resist using a (meth)acrylic acid ester-based resin having an aliphatic group with small absorption of light at 193 nm, or a resist having introduced thereinto an alicyclic aliphatic group for imparting etching resistance. However, the introduction of an aliphatic group makes the system hydrophobic, and use of a conventional developer (tetramethylammonium hydroxide, hereinafter sometimes referred to as TMAH) incurs a problem that the resist film is separated from the substrate. In JP-A-11-15159 (the term "JP-A" as used herein means an "unexamined published Japanese patent application"), JP-A-11-71363, JP-A-11-237741, JP-A-11-305436, JP-A-2001-343748 and IP-A-2002-148805, negative resists produced by copolymerizing an aliphatic group-containing unit and a carboxylic acid moiety-containing unit and incorporating various additives to the obtained resin are used, but these resists have a problem such as failure in obtaining good resolution or occurrence of pattern collapse.

### Summary of the Invention

An object of the present invention is to solve the problems of technique for enhancing performance of microphotofabrication using far ultraviolet light, particularly, ArF excimer laser light. More specifically, the object of the present invention is to provide a negative resist composition ensuring good resolution and reduced fine line pattern collapse, and a pattern forming method using the composition.

As a result of intensive studies on constituent materials of a negative resist, the present inventors have found that the above-described object can be achieved by using specific additives, and the present invention has been accomplished based on this finding. That is, the above-described object can be attained by the following constructions.
(1) A negative resist composition, comprising:
   (A) a compound having at least one episulfide structure (a three-membered ring structure comprising two C atoms and one S atom) represented by formula (1);
   (B) an alkali-soluble resin; and
   (C) a compound capable of generating an acid upon irradiation with actinic rays or radiation: 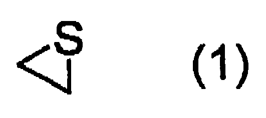
(2) The negative resist composition as described in (1) above,
   wherein the compound as the component (A) is a compound represented by formula (2): 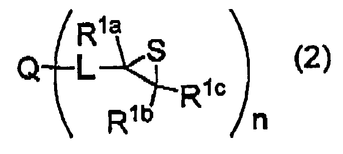 wherein R^{1a} to R^{1c} each independently represents a hydrogen atom, an alkyl group, a cycloalkyl group or an aryl group;
   L represents a single bond or a divalent organic group;
   Q represents an O atom, an S atom or an n-valent organic group;
   R^{1a}, R^{1b} or R^{1c} and L may combine with each other to form a ring;
   n represents an integer of 1 or more, provided that when Q is an O atom or an S atom, n is 2; and
   when n is an integer of 2 or more, a plurality of R^{1a}'s, R^{1b}'s, R^{1c}'s and L's may be the same or different.
(3) The negative resist composition as described in (2) above,
   wherein in formula (2), Q has an S atom and/or L has an S atom.
(4) The negative resist composition as described in (2) or (3) above,
   wherein in formula (2), n is an integer of 2 or more.
(5) The negative resist composition as described in any of (1) to (4) above,
   wherein the resin as the component (B) has solubility in an alkali developer and contains a repeating unit having a group capable of reacting with the compound having at least one episulfide structure represented by formula (1) under an action of an acid.
(6) The negative resist composition as described in any of (1) to (4) above,
   wherein the resin as the component (B) contains a repeating unit having at least one of a carboxyl group and a hydroxyl group.
(7) A pattern forming method, comprising:
   forming a resist film from the negative resist composition as described in any of (1) to (6) above; and
   exposing and developing the resist film.

### Detailed Description of the Invention

The present invention is described in detail below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

### (A) Compound having at least one episulfide structure (a three-membered ring structure comprising two C atoms and one S atom) represented by formula (1)

The negative resist composition of the present invention comprises a compound having at least one episulfide structure (a three-membered ring structure comprising two C atoms and one S atom) represented by the following formula (1).

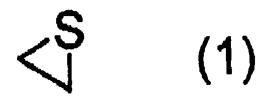

The compound having an episulfide structure for use in the present invention may have a plurality of episulfide structures and when a plurality of episulfide structures are contained, the substituent may be the same or different among the episulfide structures. In the compound having an episulfide structure, the number of episulfide structures contained is preferably from 2 to 6, more preferably from 2 to 4,

The compound having an episulfide structure for use in the present invention is preferably a compound represented by the following formula (2):

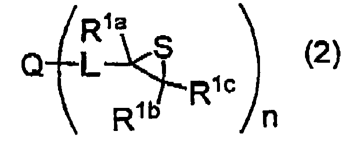

In formula (2), R^{1a} to R^{1c} each independently represents a hydrogen atom, an alkyl group, a cycloalkyl group or an aryl group.

L represents a single bond or a divalent organic group.

Q represents an O atom, an S atom or an n-valent organic group.

R^{1a}, R^{1b} or R^{1c} and L may combine with each other to form a ring.

n represents an integer of 1 or more, provided that when Q is an O atom or an S atom, n is 2.

When n is an integer of 2 or more, the plurality of R^{1a,}s, R^{1b,}s, R^{1c,}s and L's may be the same or different.

In formula (2), the alkyl group of R^{1a} to R^{1c} is preferably a linear or branched alkyl group having a carbon number of 1 to 15, and examples thereof include a methyl group, an ethyl group, an n-propyl group, an isopropyl group, an n-butyl group, an isobutyl group, a see-butyl group, a pentyl group, an isopentyl group, a neopentyl group, a tert-pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group.

The cycloalkyl group may be monocyclic or polycyclic. The monocyclic cycloalkyl group is preferably a cycloalkyl group having a carbon number of 3 to 8, and examples thereof include a cyclopropyl group, a cyclobutyl group, a cyclopentyl group, a cyclohexyl group and a cyclooctyl group. The polycyclic cycloalkyl group is preferably a cycloalkyl group having a carbon number of 6 to 20, and examples thereof include an adamantyl group, a norbornyl group, an isoboronyl group, a camphornyl group, a dicyclopentyl group, an α-pinel group, a tricyclodecanyl group, a tetracyclododecyl group and an androstanyl group.

The aryl group is preferably an aryl group having a carbon number of 6 to 14, and examples thereof include a phenyl group, a naphthyl group, an anthryl group, a phenanthryl group, a biphenylene residue (a group resulting from biphenylene being deprived of one hydrogen atom), a fluorene residue (a group resulting from fluorene being deprived of one hydrogen atom), and a pyrene residue (a group resulting from pyrene being deprived of one hydrogen atom).

In formula (2), when Q is an S atom, this may be one S atom or may be two or more bonded S atoms like a disulfide bond or a trisulfide bond.

The n-valent organic group of Q is a chain or cyclic aliphatic group or an aromatic group, and the organic group may contain an S, O or N atom therein and preferably contains an S atom. Also, the aliphatic group may be a saturated aliphatic group or an unsaturated aliphatic group.

The chain aliphatic group includes a group resulting from a linear or branched aliphatic compound being deprived of n hydrogen atoms. Specific examples of the group are set forth below, but the present invention is not limited thereto.

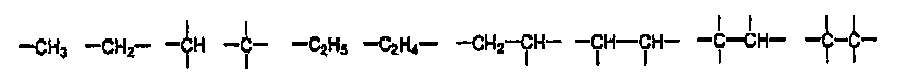

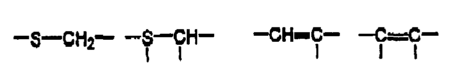

The chain aliphatic group preferably contains an S atom therein. Specific examples of the group include, but are not limited to, groups obtained by removing n hydrogen atoms from 2-thiapropane, 2-thiabutane, 3-thiapentane, 2,5-dithiapentane, 2,5-dithiahexane, 2,5-dithiaheptane, 2,6-dithiaheptane, 2,5-dithiaoctane, 2,6-dithiaoctane, 3,6-dithiaoctane, and 2,5,8-trithianonane. These aliphatic groups each may have a substituent.

The cyclic aliphatic group includes a monocyclic aliphatic group obtained by removing n hydrogen atoms from cyclobutane, cyclopentane, cyclohexane, cycloheptane or the like, and a polycyclic aliphatic group obtained by removing n hydrogen atoms from norbornane, isobornane, adamantane, bicyclooctane, tricyclodecane, tetracyclododecane, hexacycloheptadecane, spirononane, spirodecane, spiroundecane or the like. The cyclic aliphatic group may contain an S, O or N atom therein and preferably contains an S atom. In view of etching resistance, a cyclic aliphatic group is preferred, and a polycyclic aliphatic group is more preferred. Specific examples thereof include the following groups having a monocyclic or polycyclic aliphatic structure, but the present invention is not limited thereto.

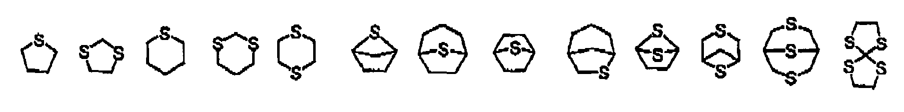

The aromatic group includes a group obtained by removing n hydrogen atoms from benzene, furan, pyrrole, thiophene or the like.

Q may be, for example, as set forth below, a structure formed by connecting a plurality of groups arbitrarily selected from an S atom, a chain aliphatic group, a cyclic aliphatic group and an aromatic group. Examples of the structure are set forth below, but the present invention is not limited thereto. In the formulae, Ra represents a hydrogen atom or an alkyl group.

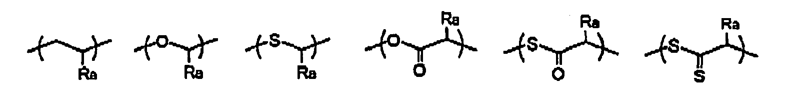

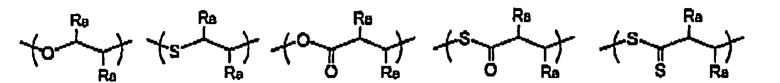

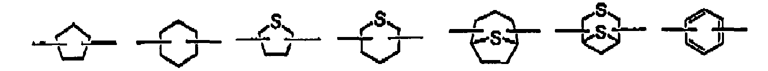

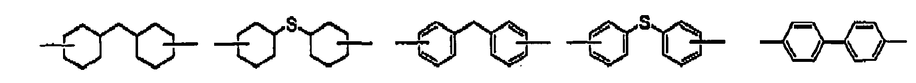

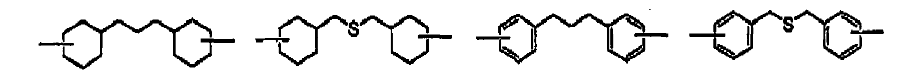

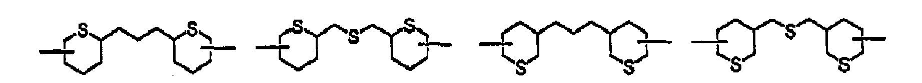

The divalent organic group of L includes a linear or cyclic aliphatic group.

The chain aliphatic group include an alkylene which may have a substituent, such as methylene, ethylene and propylene, and the chain aliphatic group preferably contains an S atom therein. Specific examples thereof include 2-thiapropylene and 2-thiabutylene.

The cyclic aliphatic group include a monocyclic aliphatic group such as cyclobutylene, cyclopentylene, cyclohexylene and cycloheptylene, and a polycyclic aliphatic group such as norbornylene, isobornylene, adamantylene, bicyclooctylene, tricyclodecanylene, tetracyclododecanylene, hexacycloheptadecanylene, spirononylene, spirodecanylene, spiroundecanylene and spirododecanylene. The cyclic aliphatic group may contain an S, O or N atom therein and preferably contains an S atom.

In formula (2), L may combine with any one of R^{a1} to R^{a3} to form a ring. Specific examples of the structure are shown below, but the present invention is not limited thereto.

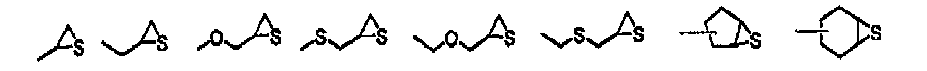

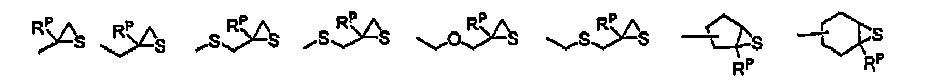

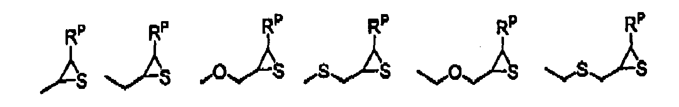

In formulae, R^{p} represents an alkyl group or a cycloalkyl group and is preferably an alkyl group having a carbon number of 1 to 30 or cycloalkyl group having a carbon number of 1 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclobutyl group, a cyclopentyl group, a cyclohexyl group, an adamantyl group, a norbornyl group and a boronyl group.

According to the present invention, a compound having an episulfide structure is added, whereby the refractive index of the resist film becomes high and a finer pattern can be formed as a resist for high refractive index mediums.

Among these compounds having an episulfide structure, from the standpoint of elevating the refractive index of the negative resist composition, a compound having one or more S atoms is preferred, a compound having from 2 to 10 S atoms is more preferred, and a compound having from 3 to 8 S atoms is still more preferred. In view of reduction of development defect and good pattern collapse margin, n is preferably an integer of 2 or more, more preferably from 2 to 6, and in view of function as a crosslinking agent and synthesis, n is yet still more preferably 3 or 4.

Examples of the compound having an episulfide structure for use in the present invention include the following compounds, but the present invention is not limited thereto:
2,3-epithiopropylthioethane, 2,3-epithiopropyloxypropane, 4-ethyl-1,2-epithiocyclohexane, 1-epithioethyl-3-thiapentane, 2,3-epithiopropylphenyl ether,
bis(2,3-epithiopropyl)sulfide, bis(2,3-epithiopropylthio)methane, 1,2-bis(2,3-epithiopropylthio)ethane, 1,2-bis(2,3-epithiopropylthio)propane, 1,3-bis(2,3-epithiopropylthio)propane, 1,3-bis(2,3-epithiopropylthio)-2-mathylpropane, 1,4-bis(2,3-epithiopropylthio)butane, 1,4-bis(2,3-epithiopropylthio)-2-methylbutane, 1-(2,3-epithiopropyl)-2-(1,2-epithiocyclohexyl-4-oxy)ethane, 1,3-bis(2,3-epithiopropylthio)butane, 1,5-bis(2,3-epithiopropylthio)pentane, 1,5-bis(2,3-epithiopropylthio)-2-methylpentane, 1,5-bis(2,3-epithiopropylthio)-3-thiapentane, 1,6-bis(2,3-epithiopropylthio)hexane, 1,6-bis(2,3-epithiopropylthio)-2-methylhexane, 1,1-bis(epithioethyl)methane, 1-(epithioethyl)-1-(2,3-epithiopropyl)methane, 1,1-bis(2,3-epithiopropyl)methane, 1-(epithioethyl)-1-(2,3-epithiopropyl)ethane, 1,2-bis(2,3-epithiopropyl)ethane, 1-(epithioethyl)-3-(2,3-epithiopropyl)butane, 1,3-bis(2,3-epithiopropyl)propane, 1-(epithioethyl)-4-(2,3-epithiopropyl)pentane, 1,4-bis(2,3-epithiopmpyl)butane, 1-(epithioethyl)-5-(2,3-epithiopropyl)hexane, 1-(epithioethyl)-2-(3,4-epithiobutyltbio)-ethane, 1-(epithioethyl)-2-[2-(3,4-epithiobutylthio)ethylthio]ethane, 3,8-bis(2,3-epithiopropylthio)-3,6-trithiaoctane, bis(2,3-epithiopropyl)disulfide, bis(2,3-epithiopropyl)trisulfide, his(2,3-epithiopropyldithio)methane, bis(2,3-epithiopropyldithio)ethane, bis(2,3-epithiopropyldithioethyl)sulfide, bis(2,3-epithiopropyldithioethyl)disulfide, 1,2-bis(2,3-epithiopropylthio)ethaue, 1,3-bis(2,3-epithiopropylthio)propane, 1,2-bis(2,3-epithiopropylthio)propane, 1-(2,3-epithiopropylthio)-2-(2,3-epithiopropylthiomethyl)propane, 1,4-bis(2,3-epithiopropylthio)butane, 1,3-bis(2,3-epithiopropylthio)butane, 1-(2,3-epithiopropylthio)-3-(2,3-epithiopropylthiomethyl)butane, 1,5-bis(2,3-epithiopropylthio)pentane, 1-(2,3-epithiopxopylthio)-4-(2,3-epithiopropylthiomethyl)pentane, 1,6-bis(2,3-epithiopropylthio)hexane, 1-(2,3-epithiopropylthio)-5-(2,3-epithiopropylthiomethyl)hexane, 1-(2,3-epithiopropylthio)-2-[(2-2,3-epithiopropylthioethyl)thio]ethane, 1-(2,3-epithiopropylthio)-2-[[2-(2-2,3-epithiopropylthioethyl)thioethyl]thio]ethane, bis(2,3-epithiopropyl)ether, bis(2,3-epithiopropyloxy)methane, 1,2-bis(2,3-epithiopropyloxy)ethane, 1,3-bis(2,3-epithiopropyloxy)propane, 1,2-bis(2,3-epithiopropyloxy)propane, 1-(2,3-epithiopropyloxy)-2-(2,3-epithiopropytoxymethyl)propane, 1,4-bis(2,3-epithiopropyloxy)butane, 1,3-bis(2,3-epithiopropyloxy)butane, 1-(2,3-epithiopropyloxy)-3-(2,3-epithiopropyloxymethyl)butane, 1,5-bis(2,3-epithiopropyl-oxy)pentane, 1-(2,3-epithiopropyloxy)-4-(2,3-epithiopropylaxymethyl)pentane, 1,6-bis(2,3-epithiopropyloxy)hexane, 1-(2,3-epithiopropyloxy)-5-(2,3-epithiopropyloxymethyl)hexane, 1-(2,3-epithiopropyloxy)-2-[(2-2,3-epithiopropyloxyethyl)oxy]ethane, 1-(2,3-epithiopropyloxy)-2-[[2-(2-2,3-epithiopropyloxyethyl)oxyethyl]oxy]ethane,
tris(2,3-epithiopropylthiomethyl)methane, 1,2,3-tris(2,3-epithiopropylthio)propane, 2,2-bis(2,3-epithiopropylthio)-1,3-bis(2,3-epithiopropylthiomethyl)propane, 2,2-bis(2,3-epithiopropylthiomethyl)-1-(2,3-epithiopropylthio)butane, 1,5-bis(2,3-epithiopropylthio)-2-10(2,3-epithiopropylthiomethyl)-3-thiapentane, 1,5-bis(2,3-epithiopropylthio)-2,4-bis(2,3-epithiopropylthiomethyl)-3-thiapentane, 1-(2,3-epithiopropylthio)-2,2-bis(2,3-epithiopxopylthiomethyl)-4-thiahexane, 1,5,6-tris(2,3-epithiopropylthio)-4-(2,3-epithiopxopylthiomethyl)-3-thiahexane, 1,8-bis(2,3-epithiopropylthio)-4-(2,3-epithiopropylthiomethyl)-3,6-dithiaoctane, 1.8-bis(2,3-epithiopropyltliio)-4,5-bis(2,3-epithiopropylthiornethyl)-3,6-dithiaoctane, 1,8-bis(2,3-epithiopropylthio)-4,4-bis(2,3-epithiopropyllhlomethyl)-3,6-dithiaoctane, 1,8-bis(2,3-epithiopropylthio)-2,5-bis(2,3-epithiopropylthiomethyl)-3,6-dithiaoetane, 1,8-bis(2,3-epithiopropylthio)-2,4,5-tris(2,3-epithiopropylthiomethyl)-3,6-dithiaoctane, 1,1,1-tris[{2-(2,3-epithiopropylthio)ethyl}thiomethyl]-2-(2,3-epithiopropylthio)ethane, 1,1,2,2-tetrakis[{2-(2,3-epithiopropylthio)ethyl}thiomethyl]ethane, 1,11-bis(2,3-epithiopropylthio)-4,8-bis(2,3-epithiopropylthiomethyl)-3,6,9-trithiaundecane, 1,11-bis(2,3-epithiopropylthio)-4,7-bis(2,3-epithiopropylthiomethyl)-3,6,9-trithiaundecane, 1,11-bis(2,3-epithiopropylthio)-5,7-bis(2,3-epithiopropylthiomethyl)-3,6,9-trithiaundecane, tetrakis(2,3-epithiopropyl)methane, 1,1,1-tris(2,3-epithiopropyl)propane, 1,3-bis(2,3-epithiopropyl)-1-(2,3-epithiopropyl)-2-thiapropane, 1,5-bis(2,3-epithiopropyl)-2,4-bis(2,3-epithiopropyl)-3-thiapentane, tetrakis(2,3-epithiopropyloxymethyl)methane, 1,1,1-tris(2,3-epithiopropyloxymethyl)propane, 1,5-bis(2,3-epithiopropyloxy)-2-(2,3-epithiopropyloxymethyl)-3-thiapentane, 1,5-bis(2,3-epithiopropyloxy)-2,4-bis(2,3-epithiopropyloxymethyl)-3-thiapentane, 1-(2,3-epithiopropyloxy)-2,2-bis(2,3-epithiopropyloxymethyl)-4-thiahexane, 1,5,6-tris(2,3-epithiopropyloxy)-4-(2,3-epithiopropyloxymethyl)-3-thiahexane, 1,8-bis(2,3-epithiopropyloxy)-4-(2,3-epithiopropyloxymethyl)-3,6-dithiaoctane, 1,8-bis(2,3-epithiopropyloxy)-4,5-bis(2,3-epithiopropyloxymethyl)-3,6-dithiaoctane, 1,8-bis(2,3-epithiopropyloxy)-4,4-bis(2,3-epithiopropyloxymethyl)-3,6-dithiaoctane, 1,8-bis(2,3-epithivpropyloxy)-2,4,5-tris(2,3-epithiopropyloxyznethyl)-3,6-dithiaoctane, 1,8-bis(2,3-epithiopropyloxy)-2,5-bis(2,3-epithiopropyloxymethyl)-3,6-dithiaoctane, 1,9-bis(2,3-epithiopmpyloxy)-5-(2,3-epithiopropyloxymethyl)-5-[(2-2,3-epithiopropyloxyet hyl)oxymethyl]-3,7-dithianonane, 1,10-bis(2,3-epithiopropyloxy)-5,6-bis[(2-2,3-epithiopropyloxyethyl)oxy]-3,6,9-tritlziadecane, 1,11-bis(2,3-epithiopropyloxy)-4,8-bis(2,3-epithiopropyloxyntethyl)-3,6,9-trithisundecane, 1,11-bis(2,3-epithiopmpyloxy)-5,7-bis(2,3-epithiopropyloxymethyl)-3,6,9-trithiaundecane, 1,11-bis(2,3-epithiopropyloxy)-5,7-[(2-2,3-epithiopropyloxyethyl)oxymethyl]-3,6,9-trithiaundecane, 1,11-bis(2,3-epithiopropyloxy)-4,7-bis(2,3-epithiopropyloxymethyl)-3,6,9-trithiaundecane, tetrakis(2,3-epithiopropylthiomethyl)metbane, tetrakis(2,3-epithiopropyldithiomethyl)methane, 1,1,1-tris(2,3-epithiopropylthiomethyl)propane, 1,2,3-tris(2,3-epithiopropyldithio)propane, 1,5-bis(2,3-epithiopropylthio)-2-(2,3-epithiopropylthiomethyl)-3-thiapentane, 1,5-bis(2,3-epithiopropylthio)-2,4-bis(2,3-epithiopropylthiomethyl)-3-thiapentane, 1,6-bis(2,3-epithiopropyldithiomethyl)-2-(2,3-epithiopropyldithioethylthio)-4-thiahexme, 1-(2,3-epithiopropylthio)-2,2-bis(2,3-epithiopropylthiomethyl)-4-thiahexane, 1,5,6-tris(2,3-epithiopropylthio)-4-(2,3-epithiopropylthiomethyl)-3-thiahexane, 1,8-bis(2,3-epithiopropylthio)-4-(2,3-epithiopropylthiomethyl)-3,6-dithiaoctone, 1,8-bis(2,3-epitbiopropylthio)-4,5-bis(2,3-epithiopropylthiomefihyl)-3,6-dithiaoctane, 1,8-bis(2,3-epithiopropylthio)-4,4-bis(2,3-epithiopropylthiomethyl)-3,6-dithiaoctane, 1,8-bis(2,3-epithiopropylthio)-2,4,5-tris(2,3-epithiopropylthiomethyl)-3,6-dithiaoctane, 1,8-bis(2,3-epithiopropylthio)-2,5-bis(2,3-epithiopropylthiomethyl)-3,6-dithiaootane, 1,9-bis(2,3-epitttiopropylthio)-5-(2,3-epithiopropylthiomethyl)-5-[(2-2,3-epithiopzropylthioethyl)thiomethyl]-3,7-dithianonane, 1,10-bis(2,3-epithiopropylthio)-5,6-bis[(2-2,3-epithlopropylthioethyl)thio]-3,6,9-trithiadecane, 1,11-bis(2,3-epithiopropylthio)-4,8-bis(2,3-epithiopropylthiomethyl)-3,6,9-trithiaundecane, 1,11-bis(2,3-epithiopropylthio)-5,7-bis(2,3-epithiopropylthiomethyl)-3,6,9-trithiaundecane, 1,11-bis(2,3-epithiopropylthio)-5,7-[(2-2,3-epithiopropylthioethyl)thiomethyl]-3,6,9-trithiaundecane, 1,11-bis(2,3-epithiopropylthio)-4,7-bis(2,3-epithiopropylthiomethyl)-3,6,9-trithiaundecane, tetra[2-(2,3-epithiopropylthio)acetylmethyl]methane, 1,1,1-tri[2-(2,3-epithiopropylthio)acetylmethyl]propane, tetra[2-(2,3-epithiopmpylthiomethyl)acetylmethyl]methane, 1,1,1-tri[2-(2,3-epithiopropylthiomethyl)acetylmethyl]propane,
1,3-bis(epithioethyl)cyclopentane, 1,3-bis(2,3-epithiopropyl)cyclopentane, 1,3-bis(2,3-epithiopropyloxy)cyclopentane, 1,3-bis(2,3-epithiopropylthio)cyclopentane, 1,3-bis(2,3-epithiopropyloxymethyl)cyclopentane, 1,3-bis(2,3-epithiopropylthiamethyl)cyclopentane, 1,3-bis(epithioethyl)cyclohexane, 1,4-bis(epithioethyl)cyclohexane, 1,3-bis(2,3-epithiopropyl)cyclohexane, 1,4-bis(2,3-epithiopropyl)cyelohexane, 1,3-bis(2,3-epithiopmpyloxy)cyclohexane, 1,4-bis(2,3-epithiopropyloxy)cyclohexane, 1,3-bis(2,3-epithiopmpylthio)cyclohexane, 1,4-bis(2,3-epithiopropylthio)cyclohexane, 1,3-bis(2,3-epithiopropyloxymethyl)cyclohexane, 1,4-bis(2,3-epithiopropyloxymethyl)cyclohexane, 1,3-bis(2,3-epithiopropylthiomethyl)cyclohexane, 1,4-bis(2,3-epithiopropylthiomethyl)-cyclohexane, 1,3,5-tris(2,3-epithiopropyl)cyclohexane, bis(2,3-epithiopropylthio) 1,3-cyclohexanedicarboxylate, bis(2,3-epithiopropylthio) 1,4-cyclohexanedicarboxylate, tris(2,3-epithiopropylthio) 1,3,5-cyclohexanetricarboxylate,
2,4-bis(epithioethyl)tetrahydrothiophene, 2,5-bis(epithioethyl)tetrahydrothiophene, 2,4-bis(2,3-epithiopropyl)tetrahydrothiophene, 2,5-bis(2,3-epithiopropyl)-tetrahydrothiophene, 2,4-bis(2,3-epithiopropyloxy)tetrahydrothiophene, 2,5-bis(2,3-epithiopropyloxy)tetrahydrothiophene, 2,4-bis(2,3-epithiopropylthio)tetrahydrothiophene, 2,5-bis(2,3-epithiopropylthio)tetrahydrothiophene, 2,4-bis(2,3-epithiopropyloxymethyl)tetrahydrothiophene, 2,5-bis(2,3-epitltiopropyloxymethyl)tetrahydrothiophene, 2,4-bis(2,3-epithiopropylthiomethyl)tetrahydrothiophene, 2,5-bis(2,3-epithiopropylthiomethyl)tetrahydrothiophene,
2,5-bis(epithioethyl)tetrahydro-2H-thiopyran, 2,6-bis(epithioethyl)tetrahydro-2H-thiopyran, 2,5-bis(2,3-epithiopropyl)tetrahydro-2H-thiopyran, 2,6-bis(2,3-epithiopropyl)tetrahydro-2H-thiopyran, 2,5-bis(2,3-epithiopropyloxy)tetrahydro-2H-thiopyran, 2,6-bis(2,3-epithiopropyloxy)tetrahydro-2H-thiopyran, 2,5-bis(2,3-epithiopropylthio)tetrahydro-2H-thiopyran, 2,6-bis(2,3-epithiopropylthio)tetrahydro-2H-thiopyran, 2,5-bis(2,3-epithiopropyloxymethyl)tetrahydxo-2H-thiopyran, 2,6-bis(2,3-epithiopropyloxymethyl)tetrahydro-2H-thiopyran, 2,5-bis(2,3-epithiopropylthiomethyl)tetrahydro-2H-thiopyran, 2,6-bis(2,3-epithiopropylthiometbyl)tetrahydro-2H-thiopyran, 2,4,6-tris(2,3-epithiopropyl)tetrahydro-2H-thiopyran,
2,5-bis(epithioethyl)-1,4-dithiane, 2,5-bis(2,3-epithiopropyl)-1,4-dithiane, 2,5-bis(2,3-epithiopropyloxymethyl)-1,4-dithiane, 2,5-bis(2,3-epithiopxopylthiomethyl)-1,4-dithiane, 2,5-bis[{2-(2,3-epithiopropylthio)ethyl}thiomethyl]-1,4-dithiane,
4-epithioethyl-1,2-epithiocyclopentane, 4-epithioethyl-1,2-epithiocyclohexane, 4-epoxy-1,2-epithiocyclopentane, 4-epoxy-1,2-epithiocyclohexane,
bis[4-(epithioethyl)cyclohexyl]metbane, bis[4-(2,3-epithiopropyl)cyclohexyl]methane, bis[4-(2,3-epithiopropyloxy)cyclohexyl]methane, bis[4-(2,3-epithiopropylthio)cyclohexyl]methane, bis[4-(2,3-epithiopropyloxylmethyl)cyclohexyl]methane, bis[3,5-bis(2,3-epithiopropyl)-cyclohexan-1-yl]methane, 2,2-bis[4-(2,3-epithiopropylthiomethyl)cyclohexyl]propane, 2,2-bis[4-(epithioethyl)cyclohexyl]propane, 2,2-bis[4-(2,3-epithiopropyl)-cyclohexyl]propane, 2,2-bis[4-(2,3-epithiopropyloxy)cyclohexyl]propane, 2,2-bis[4-(2,3-epithiopropylthio)cyclohexyl]propane, 2,2-bis[4-(2,3-epithiopropyloxymethyl)cyclohexyl]propane, 2,2-bis[4-(2,3-epithiopropylthiomethyl)cyclohexyl]propane, bis[3,5-bis(2,3-epithiopropyl)cyclohexan-1-yl]propane,
bis[4-(epithioethyl)cyclohexyl]sulfide, bis[4-(2,3-epithiopropyl)cyclohexyl]sulfide, bis[4-(2,3-epithiopropyloxy)cyclohexyl]sulfide, bis[4-(2,3-epithiopropylthio)cyclohexyl]sulfide, bis[4-(2,3-epithiopropyloxymethyl)cyclohexyl]sulfide, bis[4-(2,3-epithiopropylthiomethyl)cyclohexyl]sulfide, bis[3,5-bis(2,3-epithiopropyl)-cyclohexan-1-yl]sulfide,
bis[4-(epithioethyl)cyclohexyl]sulfone, bis[4-(2,3-epithiopropyl)cyclohexyl]sulfone, bis[4-(2,3-epithiopropyloxy)cyclohexyl]sulfone, bis[4-(2,3-epithiopxopylthio)cyclohexyl]sulfone, bis[4-(2,3-epithiopropyloxymethyl)cyclohexyl]sulfone, bis[4-(2,3-epithiopropylthiomethyl)cyclohexyl]sulfone,
1,3-bis(epithioethyl)benzene, 1,4-bis(epithioethyl)benzene, 1,3-bis(2,3-epithiopropyl)benzene, 1,4-bis(2,3-epithiopropyl)benzene, 1,3-bis(2,3-epithiopropyloxy)benzene, 1,4-bis(2,3-epithiopropyloxy)benzene, 1,3-bis(2,3-epithiopropylthio)benzene, 1,4-bis(2,3-epithiopropylthio)benzene, 1,3-bis(2,3-epithiopropyloxymethyl)benzene, 1,4-bis(2,3-epithiopropyloxymethyl)benzene, 1,3-bis(2,3-epithiopropylthiomethyl)benzene, 1,4-bis(2,3-epithiopropylthiomethyl)benzene, 1,3,5-tris(2,3-epithiopropylthio)benzene,
bis[4-(epithioethyl)phenyl]methane, bis[4-(2,3-epithiopxopyl)phenyl]methane, bis[4-(2,3-epithiopropyloxy)phenyl]methane, bis[4-(2,3-epithiopropyloxymethyl)-phenyl]methane, bis[4-(2,3-epithiopropylthio)phenyl]methane, bis[4-(2,3-epithiopropylthiomethyl)phenyl]methane, bis[3,5-bis(2,3-epithiopropyl)phenyl]suIfide,
2,2-bis[4-(epithioethyl)phenyl]propane, 2,2-bis[4-(2,3-epithiopropyl)phenyl]propane, 2,2-bis[4-(2,3-epithiopropyloxy)phenyl]propane, 2,2-bis{4-(2,3-epithiopropylthio)phenyl}propane, 2,2-bis{4-(2,3-epithiopropyloxymethyl)phenyl}propane, 2,2-bis{4-(2,3-epithiopropylthiomethyl)phenyl}propane,
bis[4-(epithioethyl)phenyl]sulfide, bis[4-(2,3-epithiopropyl)phenyl]sulfide, bis{4-(2,3-epithiopropyloxy)phenyl}sulfide, bis{4-(2,3-epithiopropylthio)phenyl}sulfide, bis{4-(2,3-epithiopropyloxymethyl)phenyl}sulfide, bis{4-(2,3-epithiopropylthiomethyl)phenyl}sulfide,
bis[4-(epithioethyl)phenyl]sulfone, bis[4-(2,3-epithiopropyl)phenyl]sulfone, bis[4-(2,3-epithiopropyloxy)phenyl]sulfone, bis{4-(2,3-epithiopropylthio)phenyl}sulfone, bis[4-(2,3-epithiopropyloxymethyl)phenyl]sulfone, bis[4-(2,3-epithiopropylthiomethyl)phenyl]sulfone,
4,4'-bis(epithioethyl)biphenyl, 4,4'-bis(2.3-epithiopmpyl)biphenyl, 4,4'-bis(2,3-epithiopropyloxy)biphenyl, 4,4'-bis(2,3-epithiopropylthio)biphenyl, 4,4'-bis(2,3-epithiopropyloxymethyl)biphenyl, and 4,4'-bis(2,3-epithiopropylthiomethyl)biphenyl.

Examples of the compound having an episulfide structure particularly suited for use in the present invention include the following compounds.

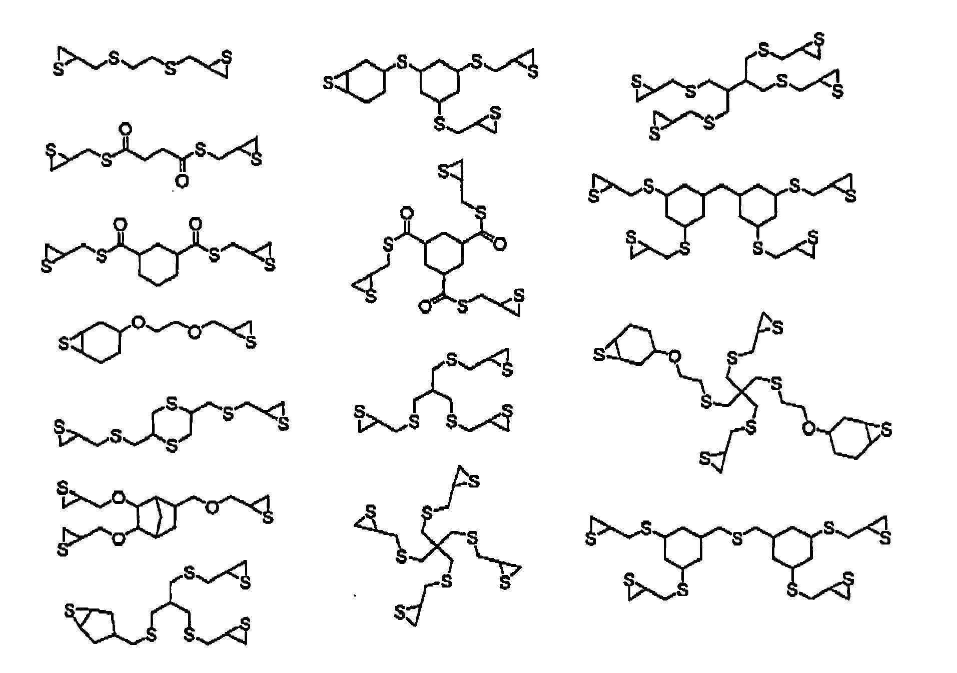

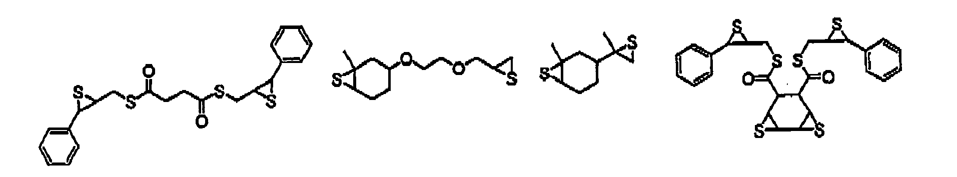

As for the compound having an episulfide structure, one compound may be used alone, or a plurality of compounds may be mixed at the same time.

The compound having an episulfide structure is preferably a compound having a molecular weight of 100 to 10,000.

The amount added of the compound having an episulfide structure is from 0.5 to 50 mass%, preferably from 1 to 30 mass%, more preferably from 2 to 20 mass%, based on the alkali-soluble resin. (In this specification, mass ratio is equal to weight ratio.)

The compound having an episulfide structure can be synthesized, as shown below, by a reaction of a corresponding epoxy compound or a ring-opened derivative thereof with potassium thiocyanate or thiourea.

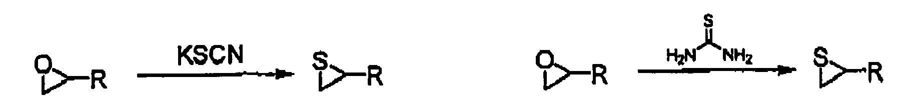

### (B) Alkali-Soluble Resin

The negative resist composition of the present invention contains an alkali-soluble resin.

The alkali-soluble resin has a group having solubility in an alkali developer (hereinafter, sometimes referred to as an "alkali-soluble group") and group capable of reacting with another functional group such as carboxyl group an hydroxy group in the crosslinking agent or resin under the action of an acid (hereinafter sometimes referred to as a "reactive group"), or has a group having solubility in an alkali developer and being capable of reacting with another functional group such as carboxyl group an hydroxy group in the crosslinking agent or resin under the action of an acid (hereinafter sometimes referred to as an "alkali-soluble•reactive group").

### Repeating unit having an alkali-soluble group, a reactive group or an alkali-soluble•reactive group:

The alkali-soluble resin preferably has a repeating unit formed of a polymerizable monomer having a group capable of polymerizing by radical polymerization or the like (hereinafter sometimes referred to as a "polymerizable group"), an alkali-soluble group and a reactive group, has a repeating unit formed of a polymerizable monomer having a polymerizable group and an alkali-soluble group, has a repeating unit formed of a polymerizable monomer having a polymerizable group and a reactive group, or has a repeating unit formed of a polymerizable monomer having a polymerizable group and an alkali-solubleareactive group

The repeating unit is preferably represented by the following formula (I-1) or (I-2):

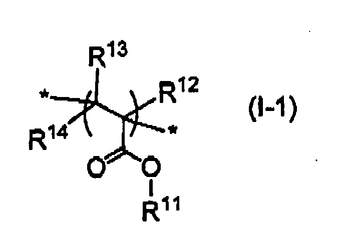

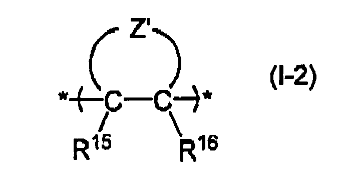

In formula (I-1), R¹², R¹³ and R¹⁴ each independently represents a hydrogen atom, a cyano group, a halogen atom or an alkyl group.

R¹¹ represents a hydrogen atom, an organic group having an alkali-soluble group and/or a reactive group, or an organic group having an alkali-soluble•reactive group.

In formula (I-2), Z' represents an atomic group for forming an alicyclic structure containing the two bonded carbon atoms (C-C).

R¹⁵ and R¹⁶ each independently represents a hydrogen atom, an organic group having an alkali-soluble group and/or a reactive group, or an organic group having an alkali-soluble•reactive group.

Formula (I-2) is preferably the following formula (I-2'-1), (I-2'-2) or (I-2'-3).

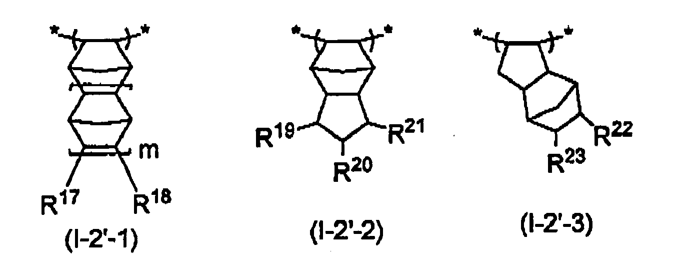

In formulae (1-2'-1) to (I-2'-3), R¹⁷, R¹⁸, R¹⁹, R²⁰, R²¹, R²² and R²³ each independently represents a hydrogen atom, an organic group having an alkali-soluble group and/or a reactive group, or an organic group having an alkali-soluble-reactive group.
m represents an integer of 0 or more.

The organic group in R¹¹ and R¹⁵ to R²³ is preferably a linear or branched aliphatic group which may have a substituent, or a monocyclic or polycyclic aliphatic group. In the linear or branched aliphatic group and the monocyclic or polycyclic aliphatic group, an ether structure or an ester structure may be contained or a plurality of alkali-soluble groups, reactive groups or alkali-soluble-reactive groups may be bonded.

The organic group may be, as shown below, a group where a linear or branched aliphatic group and a monocyclic or polycyclic aliphatic group are linked. In the formulae, a methacrylic acid skeleton, a tricyclodecane skeleton and a polynorbornene skeleton are exemplified as the structure having a polymerizable group, but the present invention is not limited thereto.

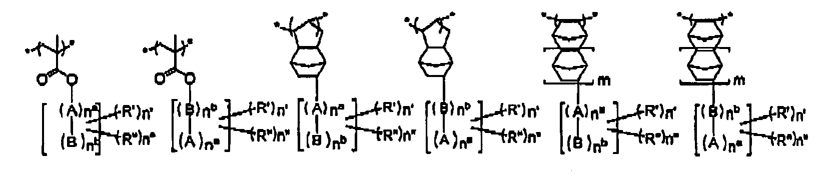

In the formulae, A represents a single bond or a liner or branched aliphatic group,
B represents a single bond or a monocyclic or polycyclic aliphatic group.
R' is an alkali-soluble group.
R" is a reactive group,

One of R' and R" may be an alkali-soluble•reactive group, with another being a hydrogen atom.
n' and n" each is an integer of 1 or more, n^{a} and n^{b} each is an integer of 0 or more, and m is an integer of 0 or more. When n^{a} and n^{b} are an integer of 2 of more, A and B may be repeated in arbitrary order. n' and n" each is preferably 1 or 2, and it is preferred that n^{a}=1 and n^{b}=0, n^{a}=0 and n^{b}=1, or n^{a}=n^{b}=1.

A is preferably a linear or branched aliphatic group having a carbon number of 1 to 30, more preferably from 1 to 10. Examples of such a linear or branched aliphatic group include chain alkylene groups (A1) to (A18) shown below. Furthermore, (2+n)-valent groups obtained by removing n hydrogen atoms from these alkylene groups are also included in A.

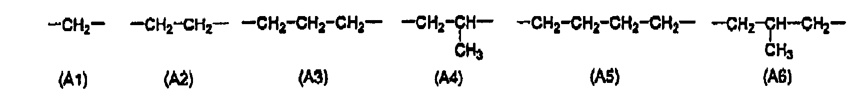

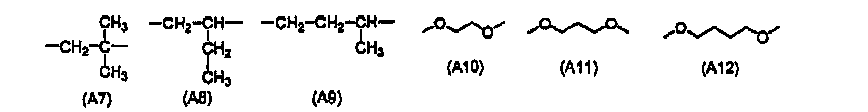

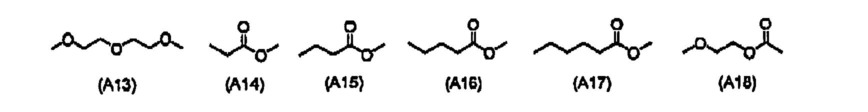

Examples of the repeating unit where a polymerizable group and an alkali-soluble group, a reactive group or an alkali-soluble•reactive group are connected through A include the following structures.

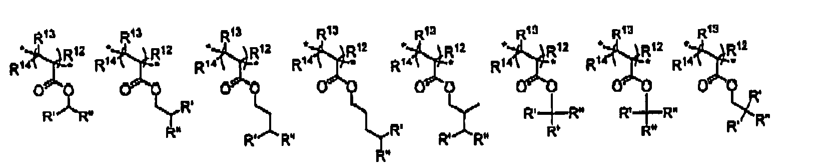

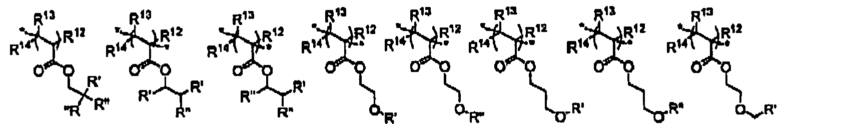

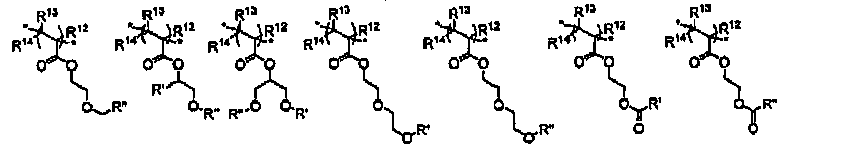

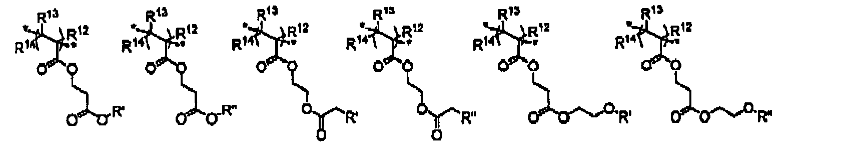

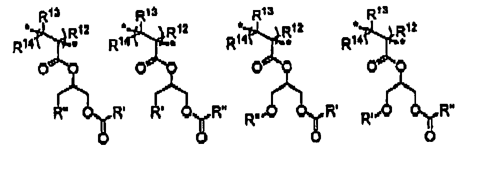

In the formulae above, R¹², R¹³ and R¹⁴ are the same as R¹², R¹³ and R¹⁴ in above formula (I-1).

R' represents, when a plurality of R's are present, each independently represents, an alkali-soluble group.

R" represents, when a plurality of R"s are present, each independently represents, a reactive group.

One of R' and R" may be an alkali-soluble•reactive group, with another being a hydrogen atom.

B is preferably a monocyclic or polycyclic aliphatic group having a carbon number of 5 to 30, more preferably from 6 to 25. Examples of such a monocyclic or polycyclic aliphatic group include alicyclic alkylene groups (B1) to (B37) shown below. Furthermore, (2+n)-valent groups obtained by removing n hydrogen atoms from these alkylene groups are also included in B. In view of etching resistance, a polycyclic aliphatic group is preferred.

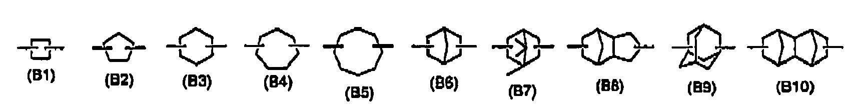

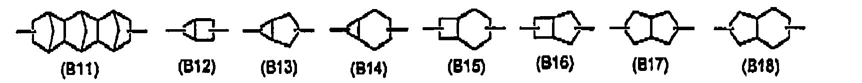

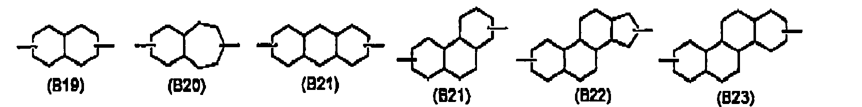

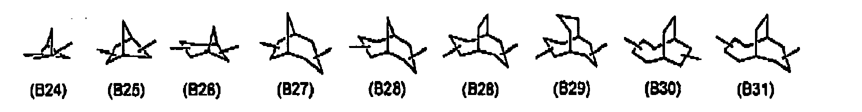

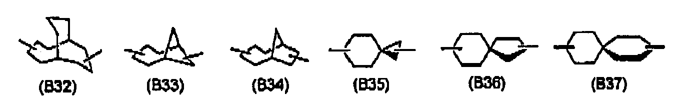

Examples of the repeating unit where a polymerizable group and an alkali-soluble group, a reactive group or an alkali-soluble-reactive group are connected through B include the following structures.

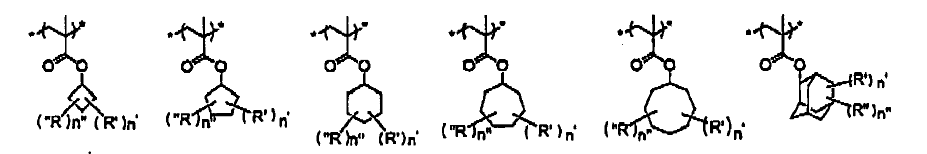

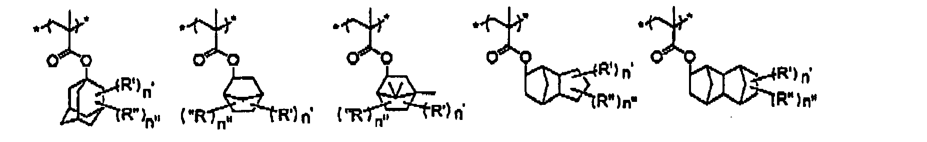

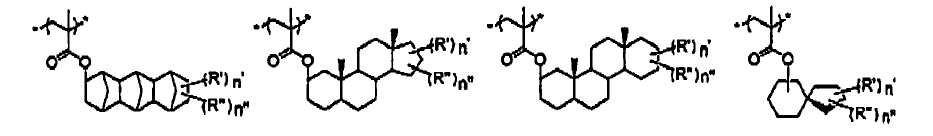

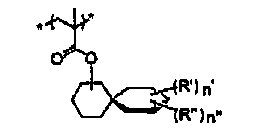

In the formulae above, R' represents, when a plurality of R's are present, each independently represents, an alkali-soluble group.

R" represents, when a plurality of R"s are present, each independently represents, a reactive group.

One of R' and R" may be an alkali-soluble•reactive group, with another being a hydrogen atom.
n' and n" each represents an integer of 0 or more, provided that n'+n" is 1 or more.

A and B may be combined to form an organic group.

### Alkali-Soluble Group:

Examples of the alkali-soluble group of R' in the structures above include, in the following compounds, an organic group containing a poly-fluorine-substituted alcohol structure, an organic group containing an carboxylic acid structure, an organic group containing a furfuryl alcohol structure, an organic structure containing an amic acid structure, an organic group containing a carbamate structure, an organic group containing a tautomeric alcohol structure, an organic group containing a thiol structure, an organic group containing a ketone oxime structure, an organic group containing an N-hydroxysuccinimide structure, and an organic group having a triazine skeleton.

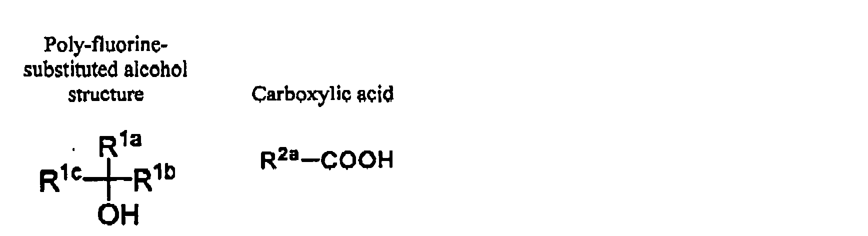

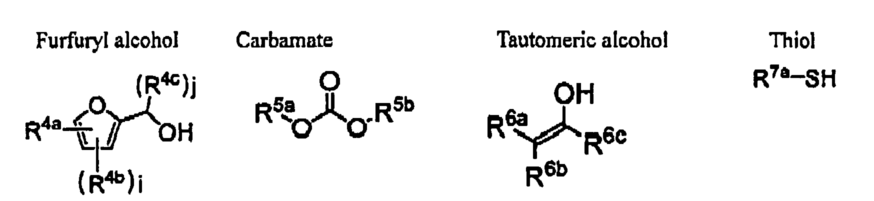

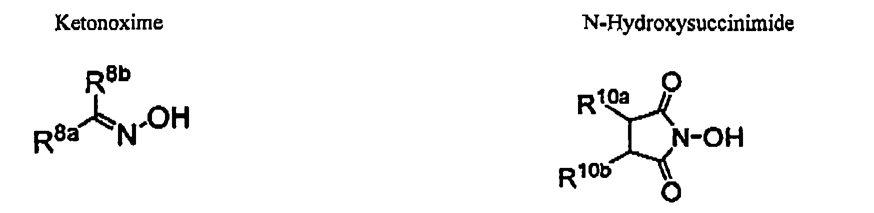

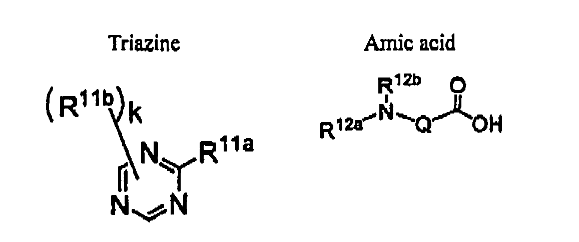

In the poly-fluorine-substituted alcohol structure, R^{1b} and R^{1c} each represents a hydrogen atom, a fluorine atom or a fluorine-substituted alkyl group and may be the same or different. In the fluorine-substituted alkyl group, it is preferred that all hydrogen atoms of the alkyl group are fluorine-substituted. R^{1b} and R^{1c} may combine with each other to form a ring. Examples of the poly-fluorine-substituted alcohol structure include the following structures.

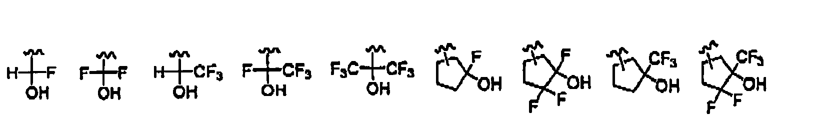

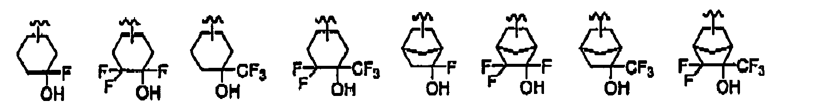

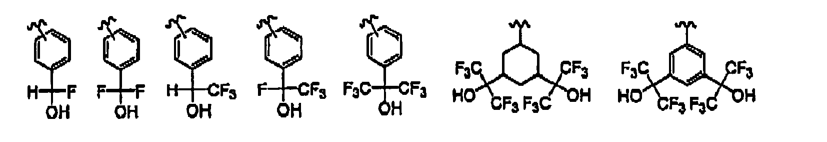

In the case where the alkali-soluble group is a poly-fluorine-substituted alcohol, a carboxylic acid, a furfuryl alcohol, a tautomeric alcohol, a thiol, a ketone oxime, an N-hydroxysuccinimide or an amic acid, the group is an alkali-soluble•reactive group capable of acting also as a reactive group.

Among these alkali-soluble groups, in view of action as a reactive group, a poly-fluoxine-substituted alcohol, a carboxylic acid, a tautomeric alcohol, a thiol, a ketone oxime, an N-hydroxysuccinimide and an amic acid are preferred, and in view of solubility in an alkali developer and prevention of swelling, a poly-fluorine-substituted alcohol and a carboxylic acid are more preferred,

### Reactive Group:

In the structures above, the reactive group of R" includes, in the compounds shown below, a carboxyl group and a hydroxyl group.

R^{13a}-OH R^{16a}-COOH

Out of these reactive groups, a hydroxyl group and a carboxyl group are an alkali-soluble•reactive group capable of acting as an alkali-soluble group.

In the structures above, R^{13a} and R^{16a} each represents a single bond or an organic group (organic structure) to be a bond with the main chain of the above resin.

In the case where the reactive group is a hydroxyl goup, the hydroxyl group may be protected by an acetal or ketal structure. By protecting the hydroxyl group with an acetal or ketal structure in this way, a hydroxyl group is generated only in the exposed area and the dissolution contract between the exposed area and the unexposed area is enhanced.

Examples of the acetal structure are set forth below.

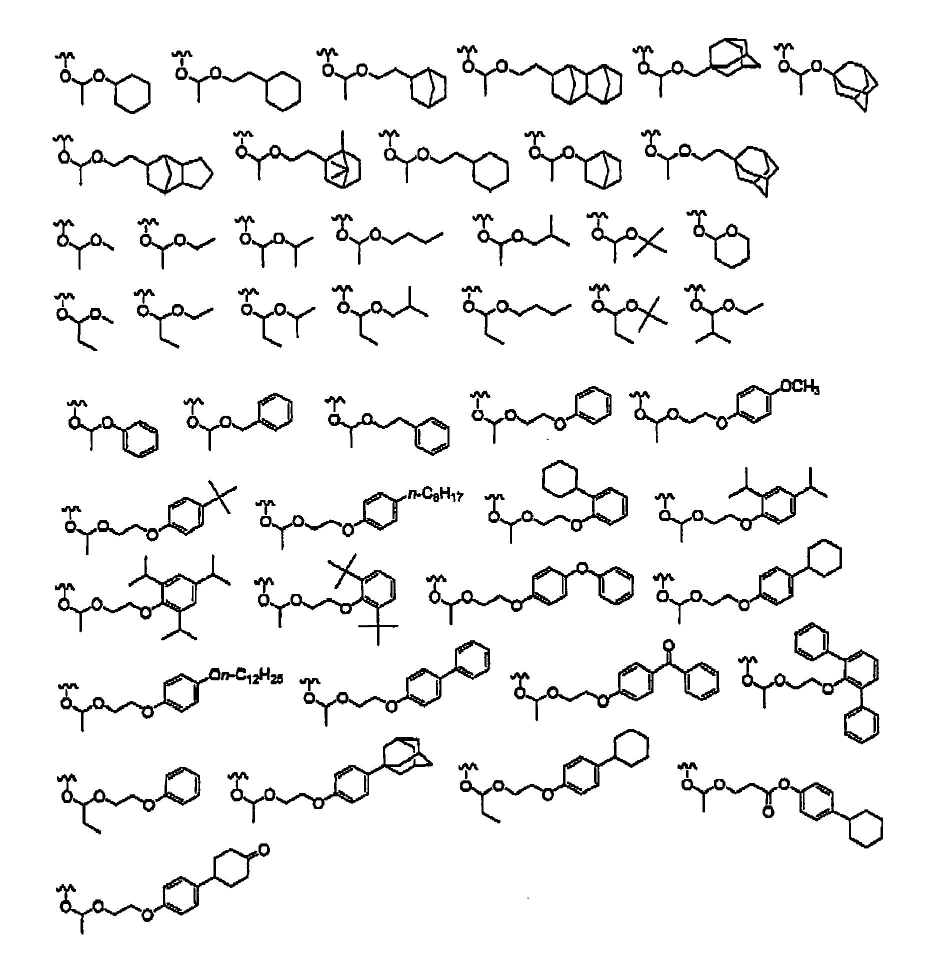

Among these partial structures, those having small absorption at 193 nm and not having an aromatic structure are preferred.

In the case where the reactive group is a carboxyl group, the carboxyl group may form an ester structure (acid-decomposable group) with an acid-leavable alkyl group. By forming an ester structure of the carboxyl group with an acid-leavable alkyl group in this way, a carboxyl group working out to a reactive group is generated only in the exposed area and therefore, the substantial content of a carboxyl group as a reactive group can be increased while suppressing the dissolution speed of the entire resist film before exposure.

Examples of such an acid-decomposable group are set forth below.

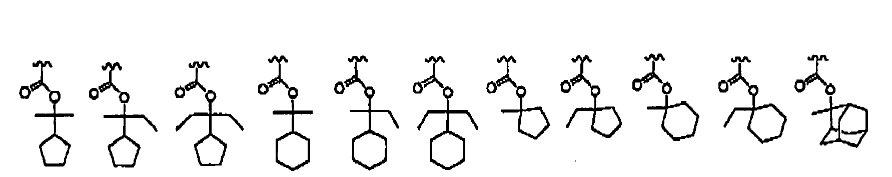

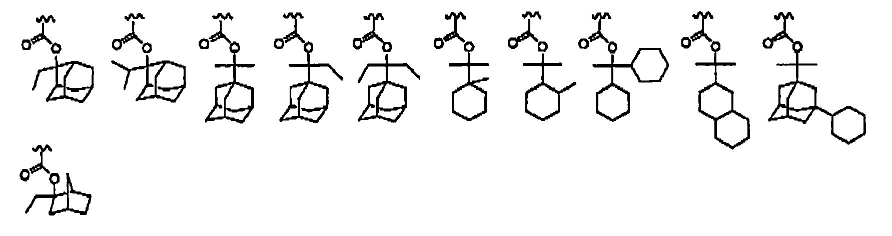

Examples of the structure of the repeating unit having an alkali-soluble group, a reactive group or an alkali-soluble reactive group for use in the present invention are set forth below, but the present invention is not limited thereto.

Also, in these examples, a methacrylic acid structure is shown as the structure having a polymerizable group, but the present invention is not limited thereto. Other examples of the structure having a polymerizable group include an acrylic acid structure, a maleic acid structure, an itaconic acid structure, a norbornene structure, a tricyclodecane structure and a tetracyclododecane structure.

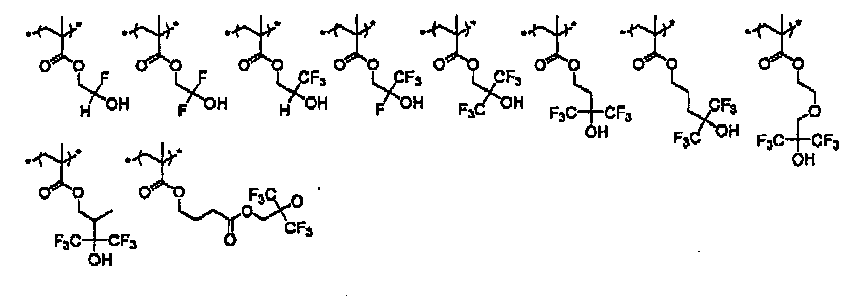

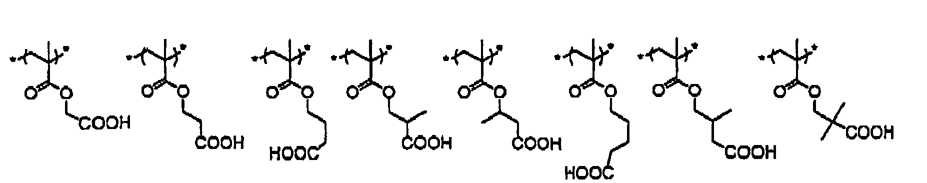

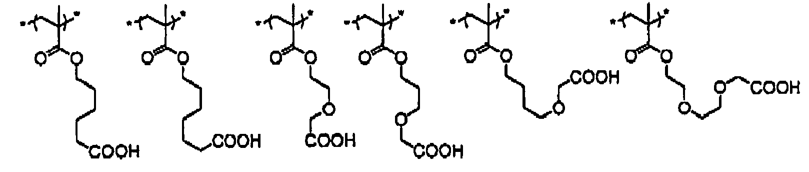

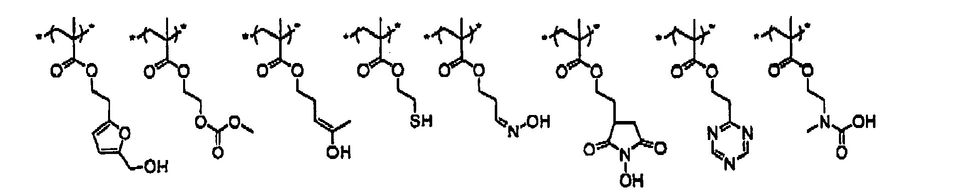

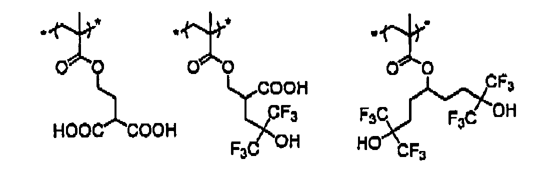

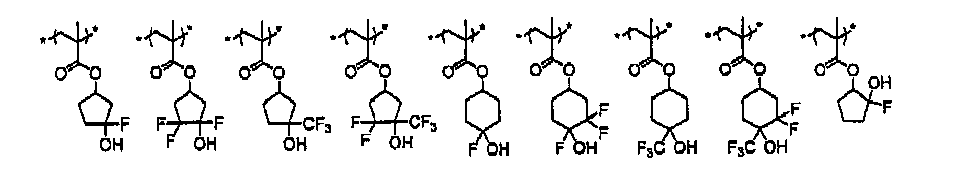

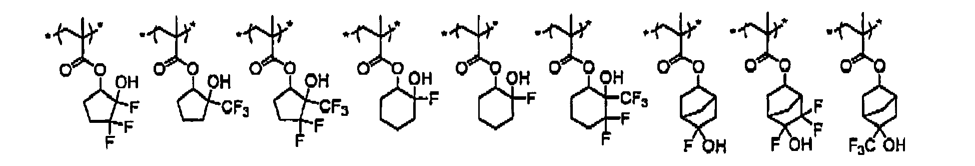

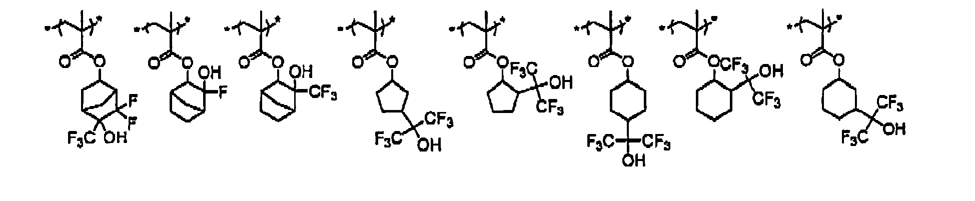

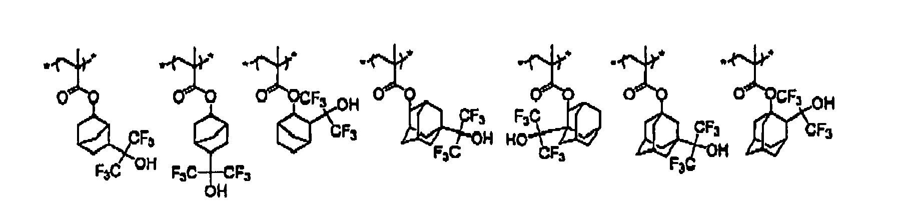

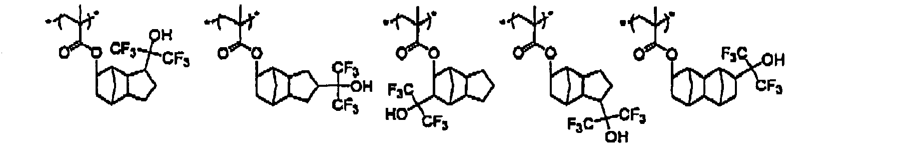

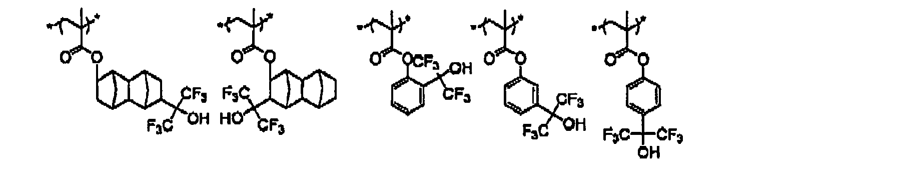

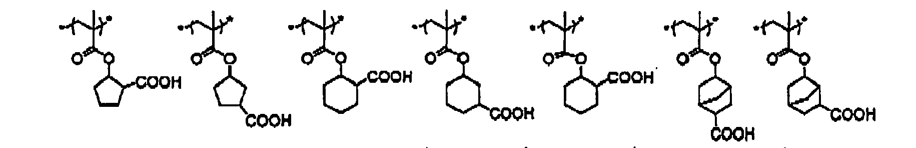

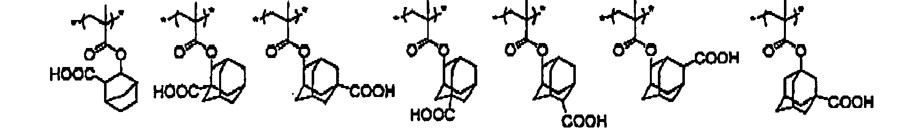

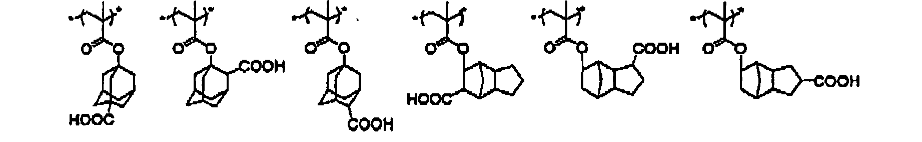

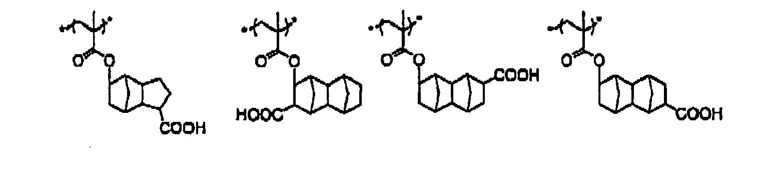

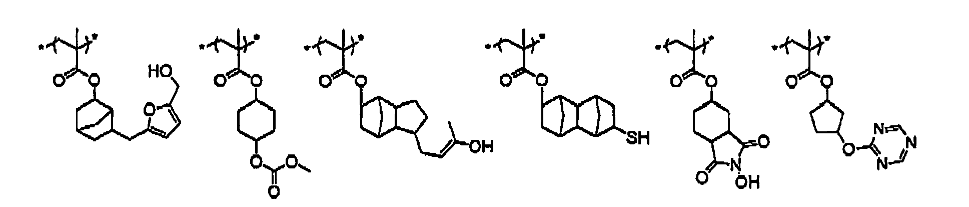

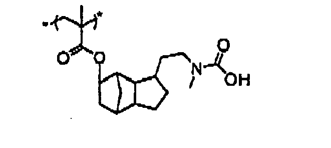

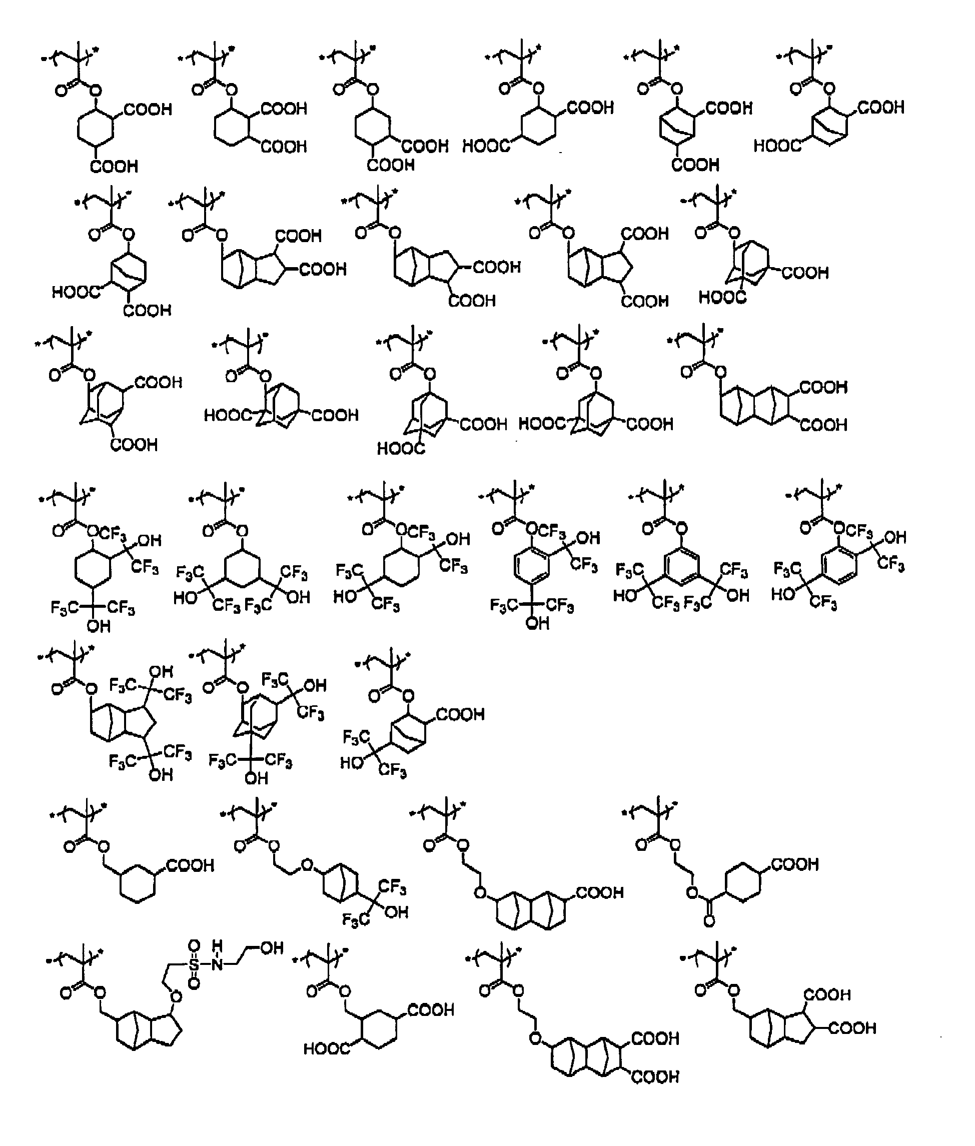

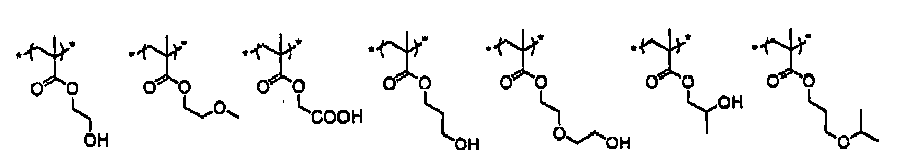

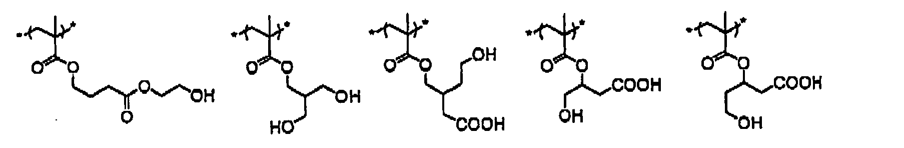

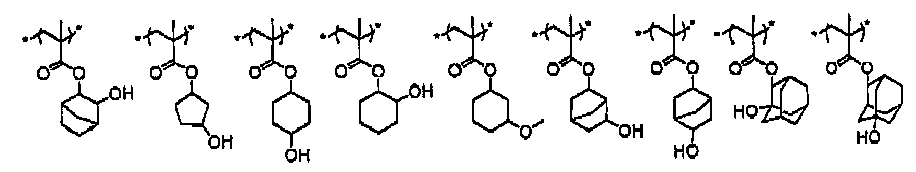

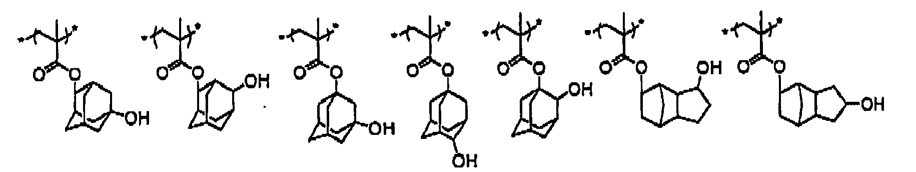

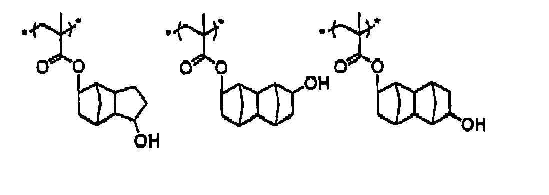

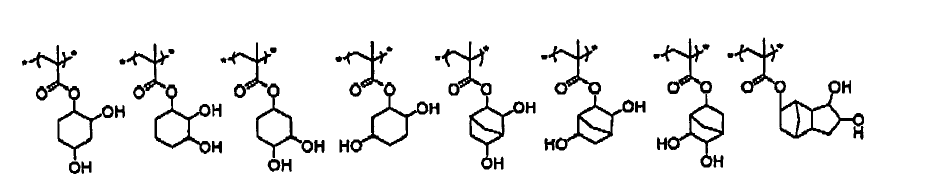

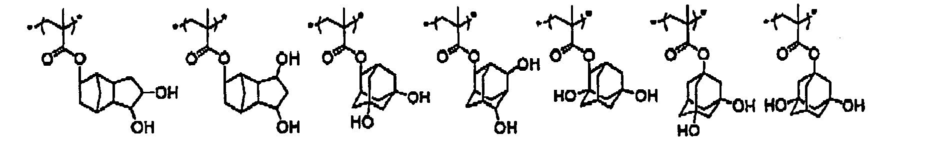

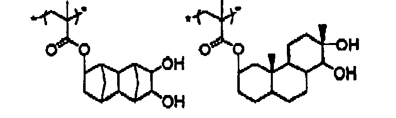

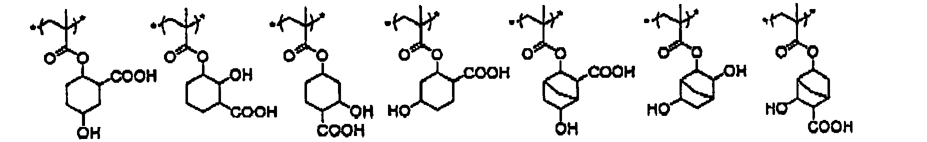

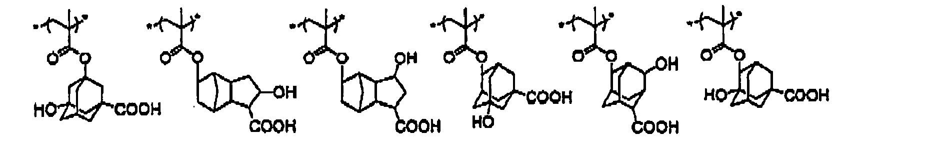

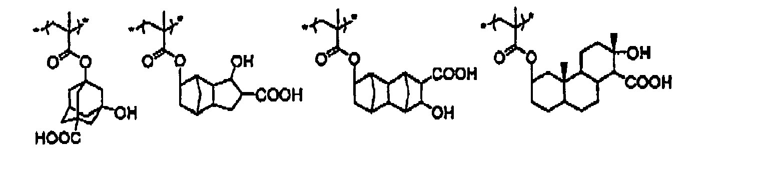

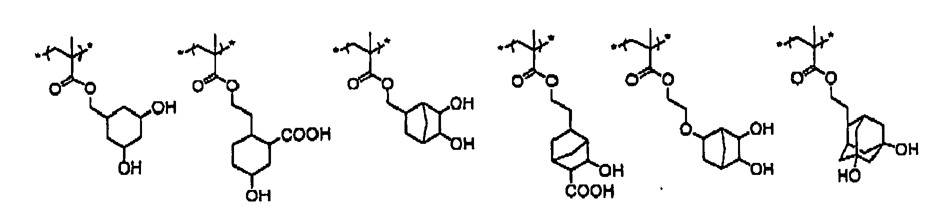

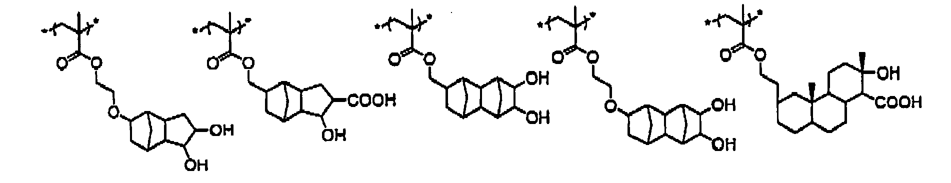

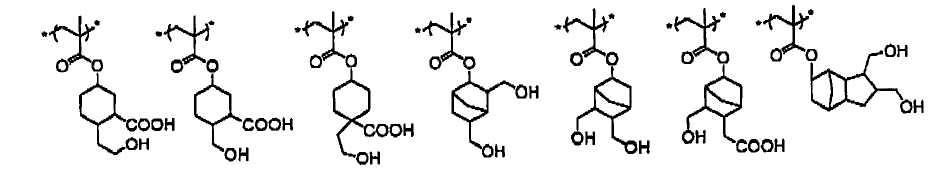

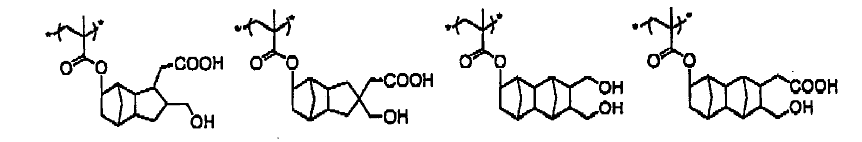

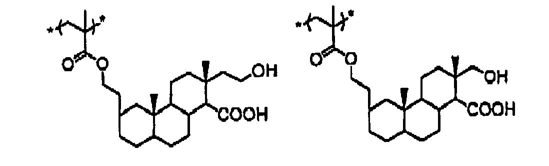

### Repeating Unit Having Aliphatic Group:

The alkali-soluble resin may contain a repeating unit having an aliphatic group. By virtue of containing a repeating unit having an aliphatic group, the dissolution speed of the resist film may be adjusted or the etching resistance may be increased.

The aliphatic group includes a linear or branched aliphatic group and a monocyclic or polycyclic aliphatic group. The aliphatic group is preferably not a group having solubility in an alkali developer but a group comprising a carbon atom and a hydrogen atom or fluorine atom. In view of etching resistance or the like, a polycyclic aliphatic group is preferred.

Examples of the linear or branched aliphatic group include methyl, ethyl, n-propyl, isopropyl, n-butyl, isobutyl, see-butyl, pentyl, neopentyl, hexyl, heptyl, octyl, nonyl, decyl, undecyl, dodecyl, tridecyl, tetradecyl, pentadecyl, hexadecyl, heptadecyl, octadecyl, nonadecyl and eicosyl groups; examples of the monocyclic aliphatic group include cyclobutyl, cyclopentyl, cyclohexyl, cycloheptyl and cyclooctyl groups; and examples of the polycyclic aliphatic group include norbornyl, isobornyl, tricyclodecanyl, tetracyclododecanyl, hexacycloheptadecanyl, adamantyl, diamantyl, spirodecanyl and spiroundecanyl groups.

Examples of the repeating unit having an aliphatic group are set forth below. In the following examples, a methacrylic acid structure is shown as the polymerizable group, but the present invention is not limited thereto.

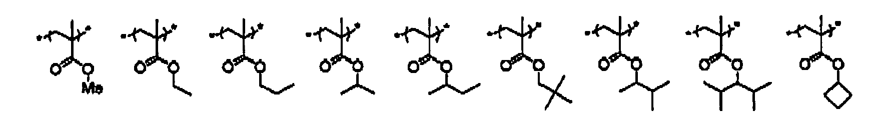

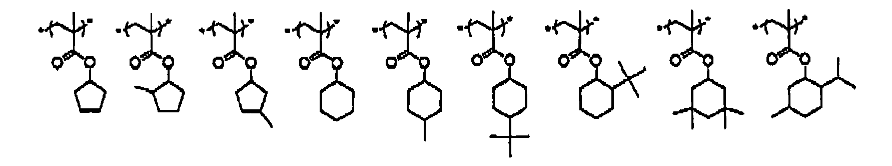

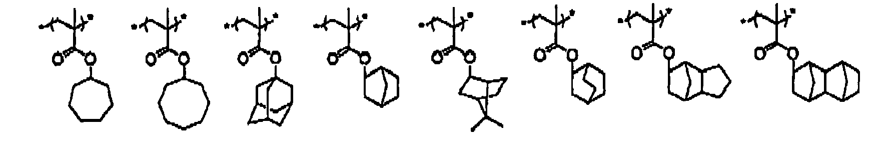

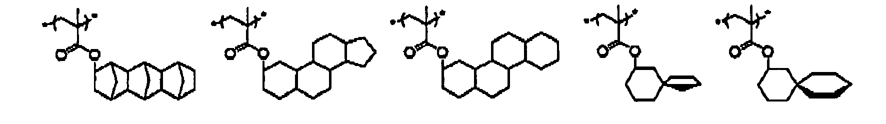

### Repeating Unit Having Lactone Structure:

The alkali-soluble resin may contain a repeating unit having a lactone structure. The lactone structure is ring-opened by the effect of an alkali developer and generates a carboxyl acid. The generated carboxylic acid affords a function of elevating the solubility in an alkali developer. At this time, the exposed area is cured resulting from the reaction of the reactive group triggered by the generated acid and allows less penetration of the developer and therefore, the solubility in an alkali developer, which is increased by the lactone structure, is not so much elevated as in the unexposed area. By virtue of the above-described action, when the resin has a lactone structure, it may be expected that the dissolution contrast between the unexposed area and the exposed area becomes higher or the exposed area is prevented from swelling, leading to enhancement of the resolving power.

As for the lactone structure, any structure may be used as long as it has a lactone structure, but a 5- to 7-membered ring lactone structure is preferred, and the lactone structure is preferably a 5- to 7-membered ring lactone structure condensed with another ring structure in the form of forming a bicyclo or spiro structure, It is more preferred to have a repeating unit having a lactone structure represented by any one of the following formulae (LCl-1) to (LCI-16). The group having a lactone structure may be bonded directly to the main chain. Among these lactone structures, preferred are (LC1-1), (LC1-4), (LCI-5). (LCI-6), (LCI-13) and (LCI-14), and more preferred is (LCl-4). By virtue of using a specific lactone structure, the line edge roughness and development defect are improved.

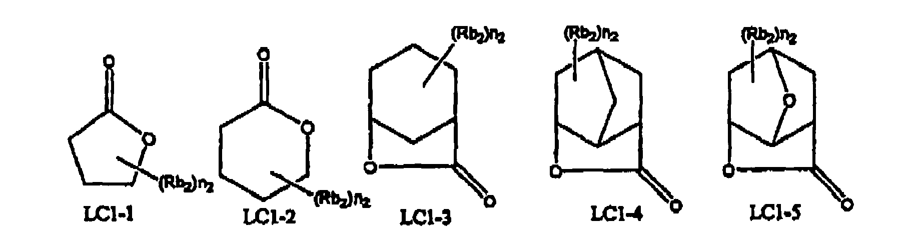

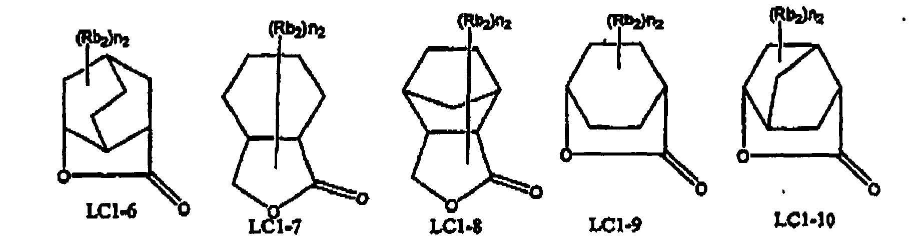

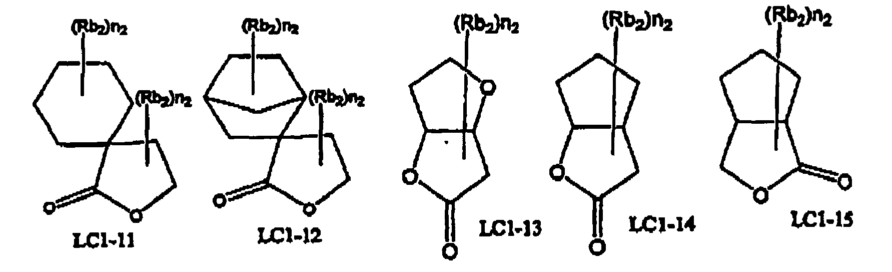

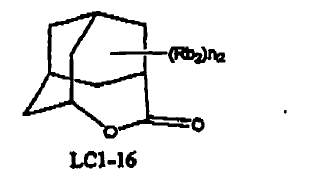

The lactone structure moiety may or may not have a substituent (Rb₂). preferred examples of the substituent (Rb₂) include an alkyl group having a carbon number of 1 to 8, a cycloalkyl group having a carbon number of 4 to 7, an alkoxy group having a carbon number of 1 to 8, an alkoxycarbonyl group having a carbon number of 1 to 8, a carboxyl group, a halogen atom, a hydroxyl group, a cyano group and an acid-decomposable group. Among these, an alkyl group having a carbon number of 1 to 4, a cyano group and an acid group are more preferred. n₂ represents an integer of 0 to 4. When n₂ is an integer of 2 or more, the plurality of substituents (Rb₂) may be the same or different and also, the plurality of substituents (Rb₂) may combine with each other to form a ring.

The repeating unit containing a group having a lactone structure represented by any one of formulae (LC1-1) to (LC1-16) includes a repeating unit represented by the following formula (AI):

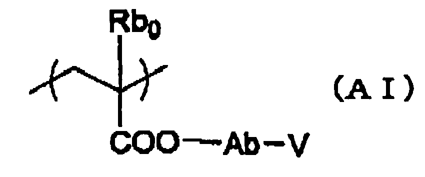

In formula (AI), Rb₀ represents a hydrogen atom, a halogen atom or an alkyl group having a carbon number of 1 to 4. Preferred examples of the substituent which the alkyl group of Rb₀ may have include a hydroxyl group and a halogen atom.

The halogen atom of Rb₀ includes a fluorine atom, a chlorine atom, a bromine atom and an iodine atom.

Rb₀ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, or a divalent group comprising a combination thereof, and is preferably a single bond or a divalent linking group represented by -Ab₁-CO₂-. Ab₁ is a linear or branched alkylene group or a monocyclic or polycyclic cycloalkylene group, preferably a methylene group, an ethylene group, a cyclohexylene group, an adamantylene group or a norbomylene group.

V represents a group represented by any one of formulae (LC1-1) to (LC1-16).

The repeating unit having a lactone structure usually has an optical isomer, but any optical isomer may be used. One optical isomer may be used alone or a mixture of a plurality of optical isomers may be used. In the case of mainly using one optical isomer, the optical purity (ee) thereof is preferably 90 or more, more preferably 95 or more.

Specific examples of the repeating unit containing a group having a lactone structure are set forth below, but the present invention is not limited thereto.

(In the formulae, Rx is H, CH₃, CH₂OH or CF₃.)

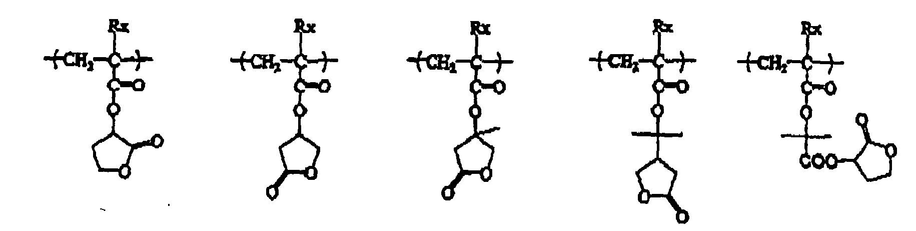

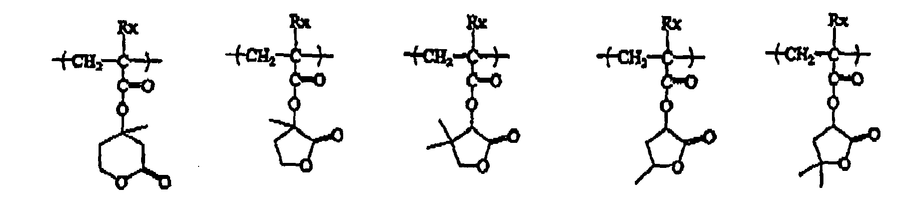

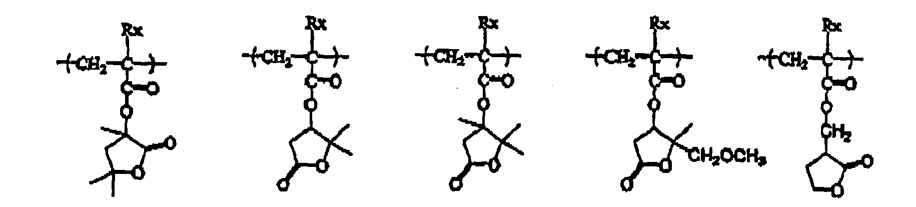

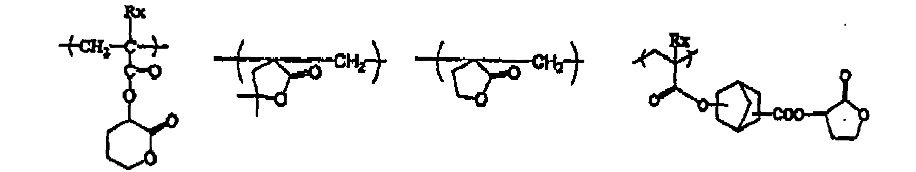

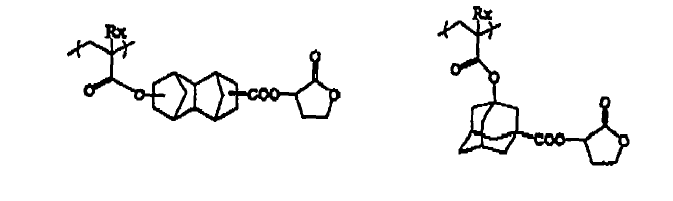

(In the formulae, Rx is H, CH₃, CH₂OH or CF₃.)

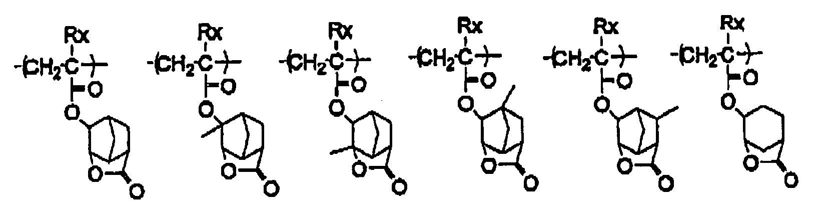

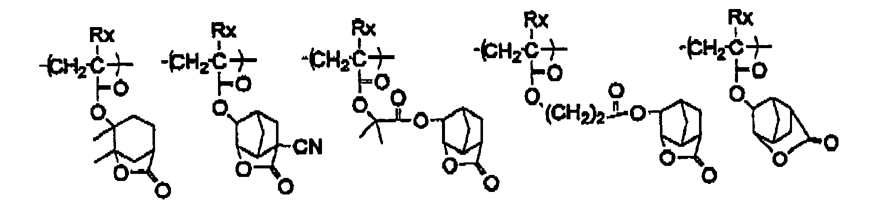

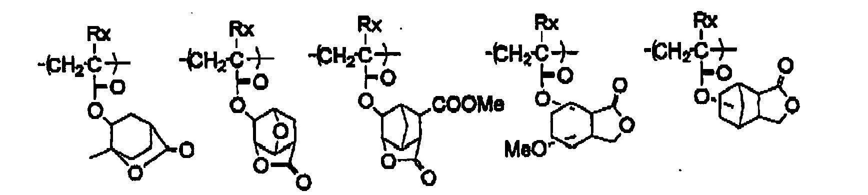

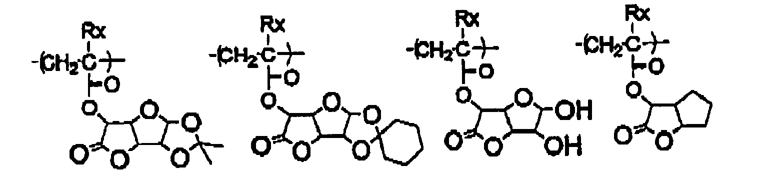

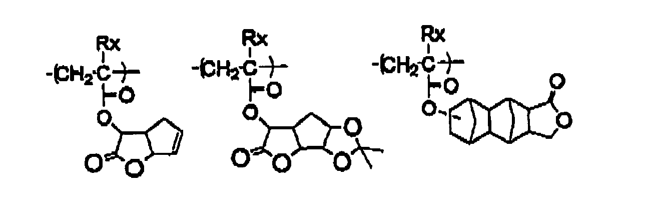

(In the formulae, Rx is H, CH₃, CH₂OH or CF₃.)

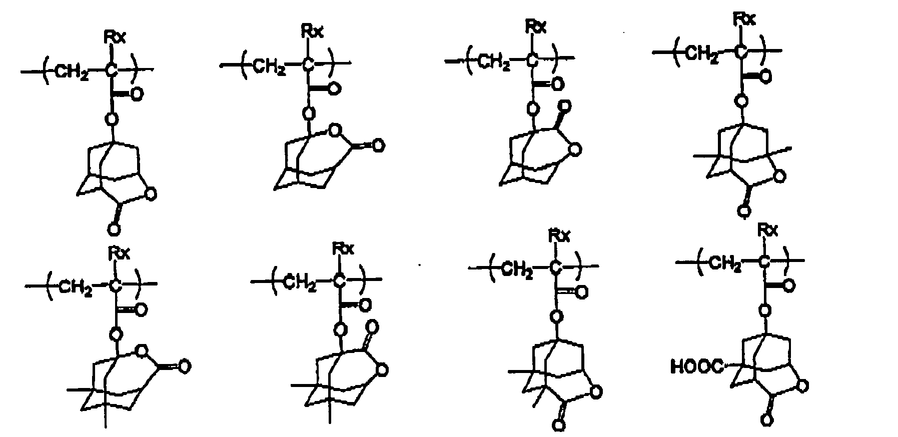

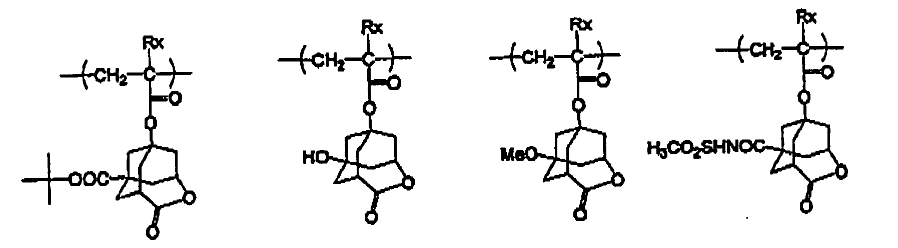

The alkali-soluble resin contains a repeating unit having an alkali-soluble group and a repeating unit having a reactive group or contains a repeating unit having an alkali-soluble•reactive group.

The alkali-soluble resin is preferably a copolymer containing a repeating unit having an alkali-soluble group and a repeating unit having a reactive group, and the copolymer is preferably used alone.

A copolymer further containing a repeating unit having an aliphatic group or a repeating unit having a lactone structure in addition to the above-described repeating units may also be used for the alkali-soluble resin.

The compositional ratio of the components in the repeating unit varies depending on the constituent unit but in all repeating units, the repeating unit having an alkali-soluble group preferably accounts for 1 to 90 mol%, more preferably from 15 to 80 mol%, still more preferably from 20 to 70 mol%, the repeating unit having a reactive group preferably accounts for 10 to 90 mol%, more preferably from 25 to 85 mol%, still more preferably from 30 to 70 mol%, the repeating unit having an alkali-soluble•reactive group preferably accounts for 1 to 90 mol%, more preferably from 15 to 85 mol%, still more preferably from 20 to 70 mol%, the repeating unit having an aliphatic group preferably accounts for 1 to 40 mol%, more preferably from 3 to 25 mol%, still more preferably from 5 to 20 mol%, and the repeating unit having a lactone structure preferably accounts for 15 to 60 mol%, more preferably from 20 to 50 mol%, still more preferably from 30 to 50 mol%.

The weight average molecular weight (Mw) of the alkali-soluble resin is from 1,000 to 100,000, preferably from 1,000 to 20,000, more preferably from 1,000 to 10,000, still more preferably from 1,000 to 8,000. Also, the value (dispersity, Mw/Mn) obtained by dividing the weight average molecular weight by the number average molecular weight is from 1 to 3, preferably from 1 to 2.5, more preferably from 1 to 1.8, still more preferably from 1 to 1.5.

The alkali-soluble resin can be synthesized by an ordinary method (for example, radical polymerization). Examples of the synthesis method in general include a batch polymerization method of dissolving the monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. Examples of the reaction solvent include tetrahydrofuran, 1,4-dioxane, ethers such as diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is described later, such as propylene glycol monomethyl ether acetate, propylene glycol monomethyl ether and cyclohexanone. The polymerization is more preferably performed using the same solvent as the solvent used in the resist composition of the present invention. By the use of this solvent, production of particles during storage can be suppressed.

The polymerization reaction is preferably performed in an inert gas atmosphere such as nitrogen and argon. As for the polymerization initiator, the polymerization is started using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methylpropionate). The initiator is added additionally or in parts, if desired. After the completion of reaction, the reactant is charged into a solvent, and the desired polymer is recovered by a method such as powder or solid recovery. The reaction concentration is from 5 to 50 mass%, preferably from 10 to 30 mass%, and the reaction temperature is usually from 10 to 150°C, preferably from 30 to 120°C, more preferably from 60 to 100°C.

The content of the alkali-soluble resin is preferably from 50 to 99.5 mass%, more preferably from 70 to 99 mass%, still more preferably from 80 to 98 mass%, based on the solid content of the negative resist composition.

### (C) Compound capable of generating an acid upon irradiation with actinic rays or radiation

The negative resist composition of the present invention contains a compound capable of generating an acid upon irradiation with actinic rays or radiation (hereinafter sometimes referred to as an "acid generator").

The acid generator which can be used may be appropriately selected from a photoinitiator for photocationic polymerization, a photoinitiator for photoradical polymerization, a photo-decoloring agent for coloring matters, a photo-discoloring agent, a compound known to generate an acid upon irradiation with actinic rays or radiation and used for microresist or the like, and a mixture thereof.

Examples thereof include a diazonium salt, a phosphonium salt, a sulfonium salt, an iodonium salt, an imidosulfonate, an oxime sulfonate, a diazodisulfone, a disulfone and an o-nitxobenzyl sulfonate.

Also, a compound where such a group or compound capable of generating an acid upon irradiation with actinic rays or radiation is introduced into the main or side chain of the polymer, for example, compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029, may be used.

Furthermore, compounds capable of generating an acid by the effect of light described, for example, in U.S. Patent 3,779,778 and European Patent 126,712 may also be used.

Out of the acid generators, the compounds represented by the following formulae (ZI), (ZII) and (ZIII) are preferred.

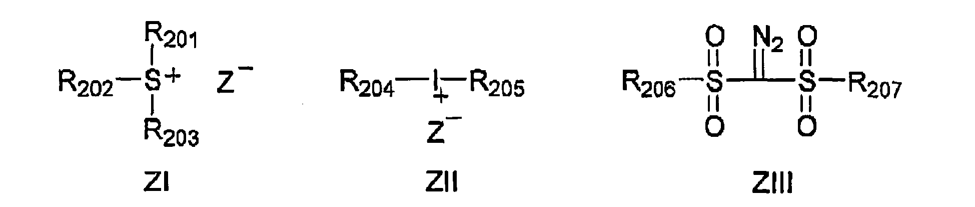

In formula (ZI), R₂₀₁, R₂₀₂ and R₂₀₃ each independently represents an organic group.

The carbon number of the organic group as R₂₀₁, R₂₀₂ and R₂₀₃ is generally from 1 to 30, preferably from I to 20.

Two members out of R₂₀₁ to R₂₀₃ may combine to form a ring structure, and the ring may contain an oxygen atom, a sulfur atom, an ester bond, an amide bond or a carbonyl group. Examples of the group formed by combining two members out of R₂₀₁ to R₂₀₃ include an alkylene group (e.g., butylene, pentylene).

Z⁻ represents a non-nucleophilic anion.

Examples of the non-nucleophilic anion as Z⁻ include sulfonate anion, carboxylate anion, sulfonylimide anion, bis(alkylsulfonyl)imide anion and tris(alkylsulfonyl)methyl anion.

The non-nucleophilic anion is an anion having an extremely low ability of causing a nucleophilic reaction and this anion can suppress the decomposition in aging due to intramolecular nucleophilic reaction. By virtue of this anion, the aging stability of the resist is enhanced.

Examples of the sulfonate anion include aliphatic sulfonate anion, aromatic sulfonate anion and camphorsulfonate anion.

Examples of the carboxylate anion include aliphatic carboxylate anion, aromatic carboxylate anion and aralkylcarboxylate anion.

The aliphatic moiety in the aliphatic sulfonate anion may be an alkyl group or a cycloalkyl group but is preferably an alkyl group having a carbon number of 1 to 30 or a cycloalkyl group having a carbon number of 3 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aromatic group in the aromatic sulfonate anion is preferably an aryl group having a carbon number of 6 to 14, and examples thereof include a phenyl group, a tolyl group and a naphthyl group.

The alkyl group, cycloalkyl group and aryl group in the aliphatic sulfonate anion and aromatic sulfonate anion each may have a substituent. Examples of the substituent for the alkyl group, cycloalkyl group and aryl group in the aliphatic sulfonate anion and aromatic sulfonate anion include a nitro group, a halogen atom (e.g., fluorine, chlorine, bromine, iodine), a carboxyl group, a hydroxyl group, an amino group, a cyano group, an alkoxy group (preferably having a carbon number of 1 to 15), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), an alkoxycarbonyloxy group (preferably having a carbon number of 2 to 7), an alkylthio group (preferably having a carbon number of 1 to 15), an alkylsulfonyl group (preferably having a carbon number of 1 to 15), an alkyliminosulfonyl group (preferably having a carbon number of 2 to 15), an aryloxysulfonyl group (preferably having a carbon number of 6 to 20), an alkylaryloxysulfonyl group (preferably having a carbon number of 7 to 20), a cycloalkylaryloxysulfonyl group (preferably having a carbon number of 10 to 20), an alkyloxyalkyloxy group (preferably having a carbon number of 5 to 20) and a cycloalkylakyloxyalkyloxy group (preferably having a carbon number of 8 to 20). As for the aryl group or ring structure in each group, examples of the substituent further include an alkyl group (preferably having a carbon number of 1 to 15).

Examples of the aliphatic moiety in the aliphatic carboxylate anion include the same alkyl groups and cycloalkyl groups as in the aliphatic sulfonate anion.

Examples of the aromatic group in the aromatic carboxylate anion include the same aryl groups as in the aromatic sulfonate anion.

The aralkyl group in the aralkylcarboxylate anion is preferably an aralkyl group having a carbon number of 6 to 12, and examples thereof include a benzyl group, a phenethyl group, a naphthylmethyl group, a naphthylethyl group and a naphthylmethyl group.

The alkyl group, cycloalkyl group, aryl group and aralkyl group in the aliphatic carboxylate anion, aromatic carboxylate anion and aralkylcarboxylate anion each may have a substituent. Examples of the substituent for the alkyl group, cycloalkyl group, aryl group and aralkyl group in the aliphatic carboxylate anion, aromatic carboxylate anion and aralkylcarboxylate anion include the same halogen atoms, alkyl groups, cycloalkyl groups, alkoxy groups and alkylthio groups as in the aromatic sulfonate anion.

Examples of the sulfonylimide anion include saccharin anion.

The alkyl group in the bis(alkylsulfonyl)imide anion and tris(alkylsulfonyl)methyl anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. Examples of the substituent for such an alkyl group include a halogen atom, a halogen atom-substituted alkyl group, an alkoxy group, an alkylthio group, an alkyloxysulfonyl group, an aryloxysulfonyl group and a cycloalkylaryloxysulfonyl group. Among these, an alkyl group substituted by a fluorine atom is preferred.

Other examples of the non-nucleophilic anion include fluorinated phosphorus, fluorinated boron and fluorinated antimony.

The non-nucleophilic anion of Z- is preferably an aliphatic sulfonate anion with the sulfonic acid being substituted by a fluorine atom at the α-position, an aromatic sulfonate anion substituted by a fluorine atom or a fluorine atom-containing group, a bis(alkylsulfonyl)imide anion with the alkyl group being substituted by a fluorine atom, or a tris(alkylsulfonyl)methide anion with the alkyl group being substituted by a fluorine atom, more preferably a perfluoroaliphatic sulfonate anion having a carbon number of 4 to 8, or a benzenesulfonate anion having a fluorine atom, still more preferably nonafluorobutanesulfonate anion, perfluorooctanesulfonate anion, pentafluorobenzenesulfonate anion or 3,5-bis(trifluoromethyl)benzenesulfonate anion.

Examples of the organic group as R₂₀₁, R₂₀₂ and R₂₀₃ include the corresponding groups in the compounds (ZI-1), (ZI-2) and (ZI-3) described later.

The compound may be a compound having a plurality of structures represented by formula (Z1), for example, may be a compound having a structure where at least one of R₂₀₁ to R₂₀₃ in the compound represented by formula (Z1) is bonded to at least one of R₂₀₁ to R₂₀₃ in another compound represented by formula (Z1).

The component (Z1) is more preferably a compound (ZI-1), (ZI-2) or (ZI-3) described below.

The compound (ZI-1) is an arylsulfonium compound where at least one of R₂₀₁ to R₂₀₃ in formula (Z1) is an aryl group, that is, a compound having arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group or a cycloalkyl group,

Examples of the arylsulfonium compound include a triarylsulfonium compound, a diarylalkylsulfonium compound, an aryldialkylsulfonium compound, a diarylcycloalkylsulfonium compound and an aryldicycloalkylsulfonium compound.

The aryl group in the arylsulfonium compound is preferably a phenyl group or a naphthyl group, more preferably a phenyl group. The aryl group may be an aryl group having a heterocyclic structure containing an oxygen atom, a nitrogen atom, a sulfur atom or the like, Examples of the aryl group having a heterocyclic structure include a pyrrole residue (a group formed by removing one hydrogen atom from pyrrole), a furan residue (a goup formed by removing one hydrogen atom from furan), a thiophene residue (a group formed by removing one hydrogen atom from thiophene), an indole residue (a group formed by removing one hydrogen atom from indole), a benzofuran residue (a group formed by removing one hydrogen atom from benzofuran) and a benzothiophene residue (a group formed by removing one hydrogen atom from benzothiophene). In the case where the arylsulfonium compound has two or more aryl groups, these two or more aryl groups may be the same or different.

The alkyl group or cycloalkyl group which is present, if desired, in the arylsulfonium compound is preferably a linear or branched alkyl group having a carbon number of 1 to 15 or a cycloalkyl group having a carbon number of 3 to 15, and examples thereof include a methyl group, an ethyl group, a propyl group, an n-butyl group, a sec-butyl group, a tert-butyl group, a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, more preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ are an aryl group, the substituent is preferably substituted at the p-position of the aryl group.

The compound (ZI-2) is described below.

The compound (ZI-2) is a compound where R₂₀₁ to R₂₀₃ in formula (ZI) each independently represents an aromatic ring-free organic group. The aromatic ring as used herein includes an aromatic ring containing a heteroatom.

The aromatic ring-free organic group as R₂₀₁ to R₂₀₃ has a carbon number of generally from 1 to 30, preferably from 1 to 20.

R₂₀₁ to R₂₀₃ each independently represents preferably an alkyl group, a cycloalkyl group, an allyl group or a vinyl group, more preferably a linear or branched 2-oxoalkyl group, a 2-oxocycloallcyl group or an alkoxycarbonylmethyl group, still more preferably a linear or branched 2-oxoalkyl group.

The alkyl group or cycloalkyl group of R₂₀₁ to R₂₀₃ is preferably a linear or branched alkyl group having a carbon number of 1 to 10 (e.g., methyl, ethyl, propyl, butyl, pentyl) or a cycloalkyl group having a carbon number of 3 to 10 (e.g., cyclopentyl, cyclohexyl, norbomyl). The alkyl group is more preferably a 2-oxoalkyl group or an alkoxycarbonylmethyl group. The cycloalkyl group is more preferably a 2-oxocycloalkyl group.

The 2-oxoallcyl group may be either linear or branched and is preferably a group having >C=O at the 2-position of the above-described alkyl group.

The 2-oxocycloaIkyl group is preferably a group having >C=O at the 2-position of the above-described cycloalkyl group.

The alkoxy group in the alkoxycarbonylmethyl group is preferably an alkoxy group having a carbon number of 1 to 5 (e.g., methoxy, ethoxy, propoxy, butoxy, pentoxy).

R₂₀₁ to R₂₀₃ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

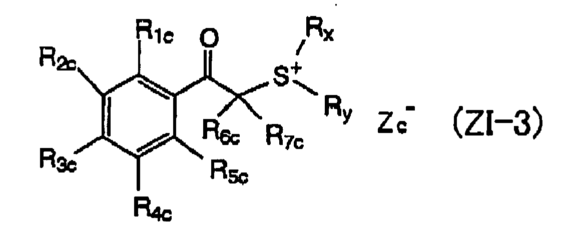

In formula (ZI-3), R_{1c} to R_{5c} each independently represents a hydrogen atom, an alkyl group, a cycloalkyl group, an alkoxy group or a halogen atom.

R_{6c} and R_{7c} each independently represents a hydrogen atom, an alkyl group or a cycloalkyl group.

Rₓ and R_{y} each independently represents an alkyl group, a cycloalkyl group, an allyl group or a vinyl group.

Any two or more members out of R_{1c} to R_{5c}, a pair of R_{6c} and R_{7c}, or a pair of Rₓ and Ry may combine with each other to form a ring structure. This ring structure may contain an oxygen atom, a sulfur atom, an ester bond or an amido bond. Examples of the group formed by combining any two or more members out of R_{1c} to R_{5c}, a pair of R_{6c} and R_{7c}, or a pair of Rₓ and R_{y} include a butylene group and a pentylene group.

Zc* represents a non-nucleophilic anion, and examples thereof are the same as those of the non-nucleophilic anion of Z' in formula (ZI).

The alkyl group as R_{1c} to R_{7c} may be either linear or branched and is, for example, an alkyl group having a carbon number of 1 to 20, preferably a linear or branched alkyl group having a carbon number from 1 to 12 (e.g., methyl group, ethyl group, linear or branched propyl group, linear or branched butyl group, linear or branched pentyl group). The cycloalkyl group includes, for example, a cycloalkyl group having a carbon number of 3 to 8 (e.g., cyclopentyl group, cyclohexyl goup),

The alkoxy group as R_{1c} to R_{5c} may be linear, branched or cyclic and is, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy) or a cyclic alkoxy group having a carbon number of 3 to 8 (e.g., cyclopentyloxy group, cyclohexyloxy group).

A compound where any one of R_{1c} to R_{5c}, is a linear or branched alkyl group, a cycloalkyl group or a linear, branched or cyclic alkoxy group is preferred, and a compound where the sum of carbon numbers of R_{1c} to R_{5c} is from 2 to 15 is more preferred. By virtue of such a compound, the solubility in a solvent is more enhanced and production of particles during storage can be suppressed.

Examples of the alkyl group and cycloalkyl group as Rₓ and Ry are the same as those of the alkyl group and cycloalkyl group in R_{1c} to R_{7c}. Among these, a 2-oxoalkyl group, a 2-oxocycloalkyl group and an alkoxycarbonylmethyl group are preferred.

The 2-oxoalkyl group or 2-oxocycloalkyl group includes a group having >C=O at the 2-position of the alkyl group or cycloalkyl group as R_{1c} to R_{7c}.

Examples of the alkoxy group in the alkoxycarbonylmethyl group are the same as those of the alkoxy group in R_{1c} to R_{5c}.

Rₓ and R_{y} each is preferably an alkyl or cycloalkyl group having a carbon number of 4 or more, more preferably 6 or more, still more preferably 8 or more.

In formulae (ZII) and (ZIII), R₂₀₄ to R₂₀₇ each independently represents an aryl group, an alkyl group or a cycloalkyl group.

The aryl group of R₂₀₄ to R₂₀₇ is preferably a phenyl group or a naphthyl group, more preferably a phenyl group. The aryl group of R₂₀₄ and R₂₀₇ may be an aryl group having a heterocyclic structure containing an oxygen atom, a nitrogen atom, a sulfur atom or the like. Examples of the aryl group having a heterocyclic structure include a pyrrole residue (a group formed by removing one hydrogen atom from pyrrole), a furan residue (a group formed by removing one hydrogen atom from furan), a thiophene residue (a group formed by removing one hydrogen atom from thiophene), an indole residue (a group formed by removing one hydrogen atom from indole), a benzofuran residue (a group formed by removing one hydrogen atom from benzofuran) and a benzothiophene residue (a group formed by removing one hydrogen atom from benzothiophene).

The alkyl group or cycloalkyl group in R₂₀₄ to R₂₀₇ is preferably a linear or branched alkyl group having a carbon number of 1 to 10 (e.g., methyl group, ethyl group, propyl group, butyl group, pentyl group) or a cycloalkyl group having a carbon number of 3 to 10 (e.g., cyclopentyl group, cyclohexyl group, norbornyl group).

The aryl group, alkyl group and cycloalkyl group of R₂₀₄ to R₂₀₇ each may have a substituent. Examples of the substituent which the aryl group, alkyl group and cycloalkyl group of R₂₀₄ to R₂₀₇ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

Z⁻ represents a non-nucleophilic anion, and examples thereof are the same as those of the non-nucleophilic anion of Z⁻ in formula (ZI).

Other examples of the acid generator include the compounds represented by the following formulae (ZIV), (ZV) and (ZVI).

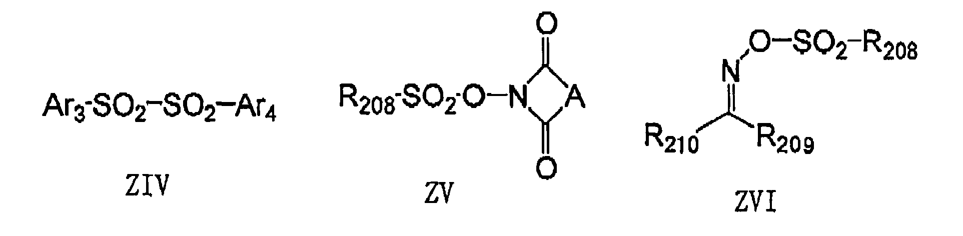

In formulae (ZIV) to (ZVI), Ar₃ and Ar₄ each independently represents an aryl group.

R₂₀₈, R₂₀₉ and R₂₁₀ each independently represents an alkyl group, a cycloalkyl group or an aryl group.

A represents an alkylene group, an alkenylene group or an arylene group.

Among the acid generators, more preferred are the compounds represented by formulae (ZI) to (ZIII).

The acid generator is preferably a compound capable of generating an acid having one sulfonic acid group or imide group, more preferably a compound capable of generating a monovalent perfluoroalkanesulfonic acid, a compound capable of generating a monovalent aromatic sulfonic acid substituted by a fluorine atom or a fluorine atom-containing group, or a compound capable of generating a monovalent imide acid substituted by a fluorine atom or a fluorine atom-containing group, still more preferably a sulfonium salt of fluoro-substituted alkanesulfonic acid, fluorine-substituted benzenesulfonic acid, fluorine-substituted imide acid or fluorine-substituted methide acid. In particular, the acid generated from the acid generator which can be used is preferably a fluoro-substituted alkanesulfonic acid, fluoro-substituted benzenesulfonic acid or fluoro-substituted imide acid having a pKa of -1 or less, and in this case, the sensitivity is enhanced.

Among the acid generators, particularly preferred compounds are set forth below.

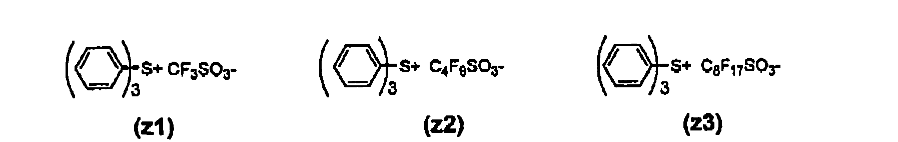

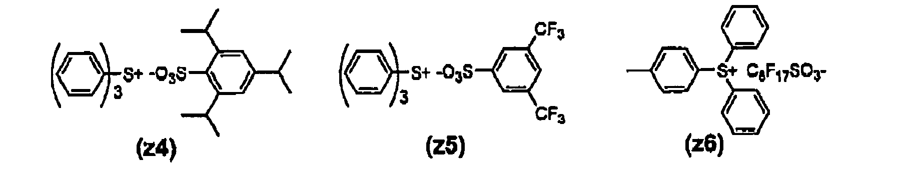

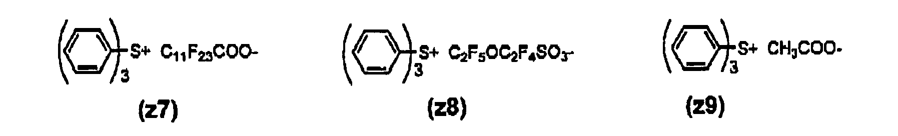

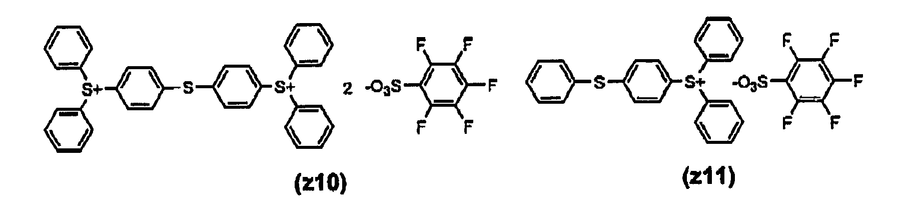

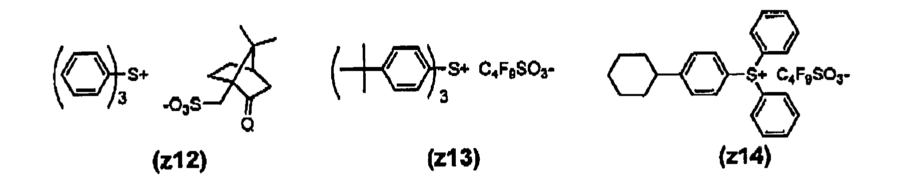

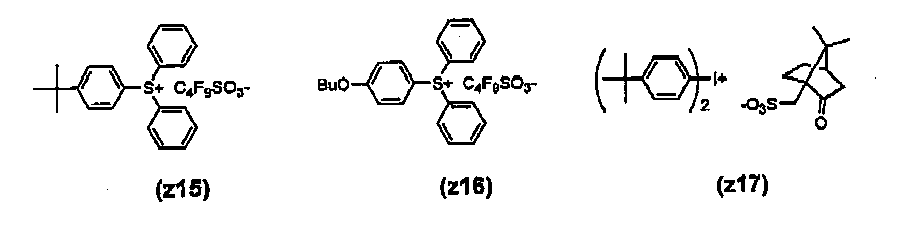

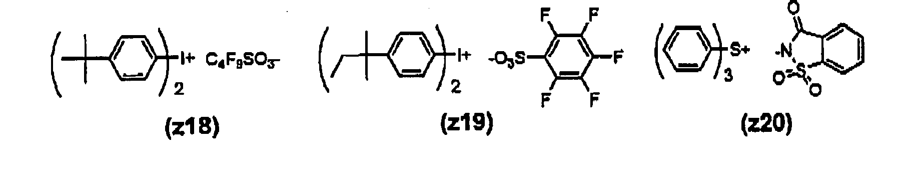

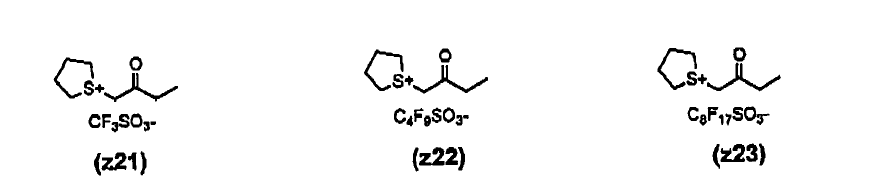

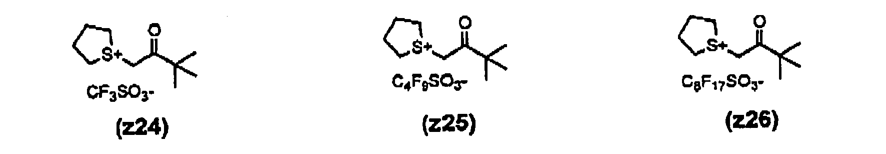

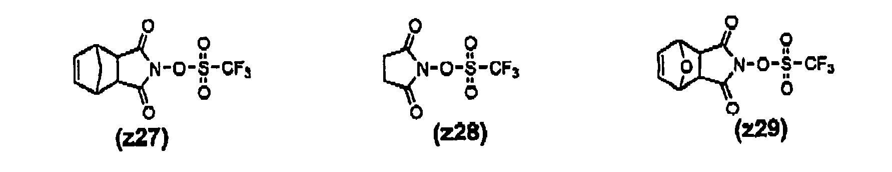

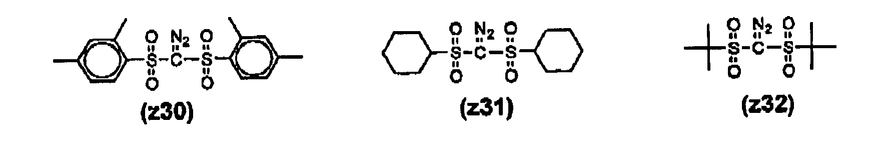

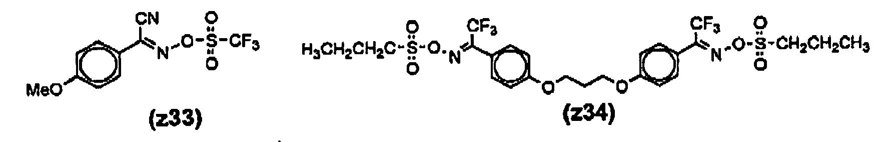

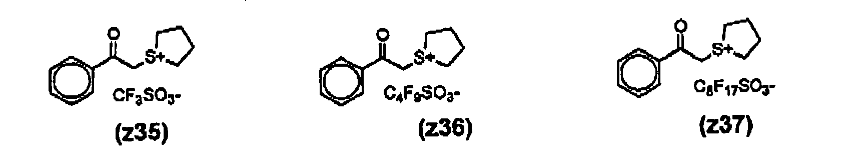

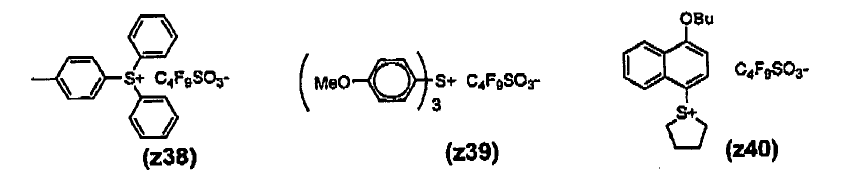

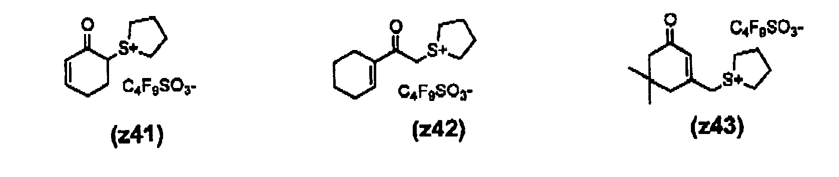

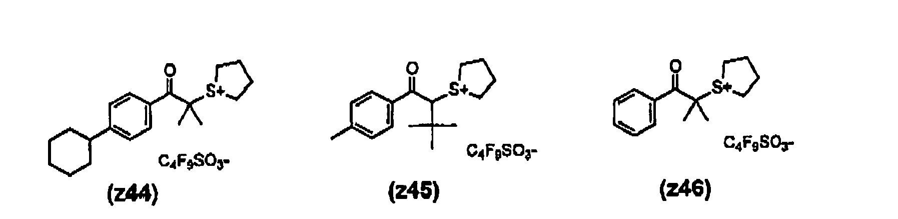

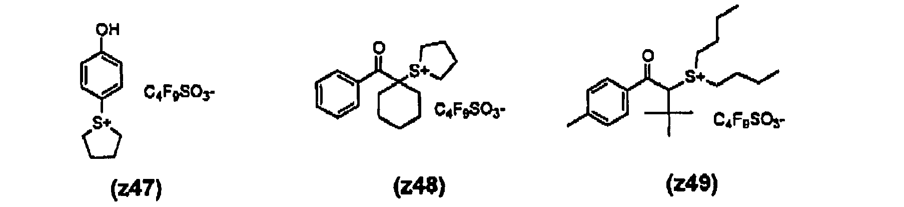

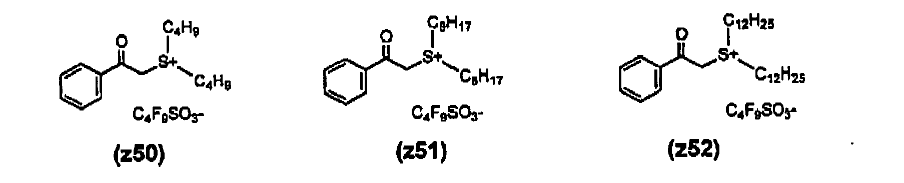

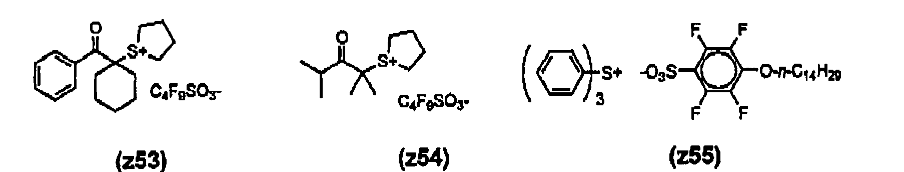

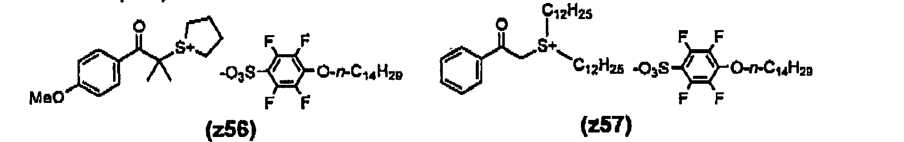

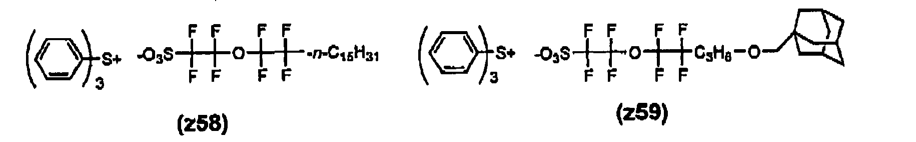

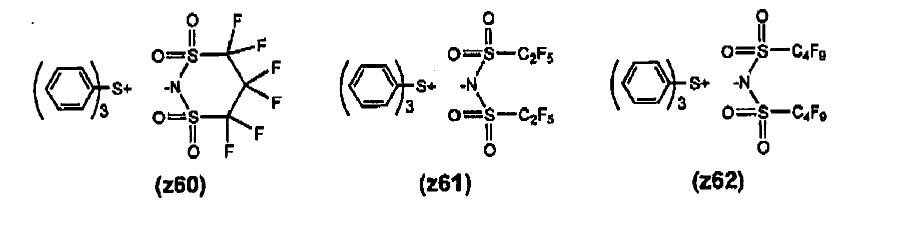

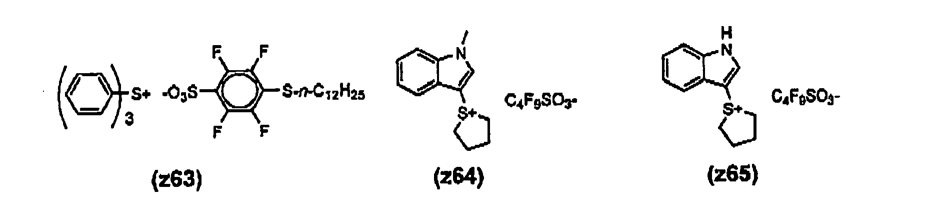

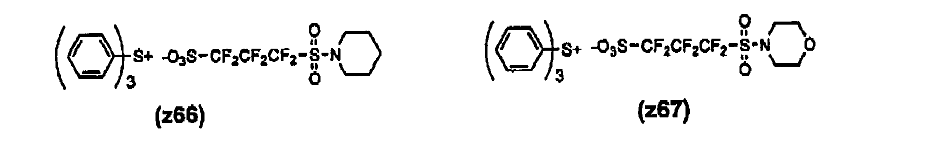

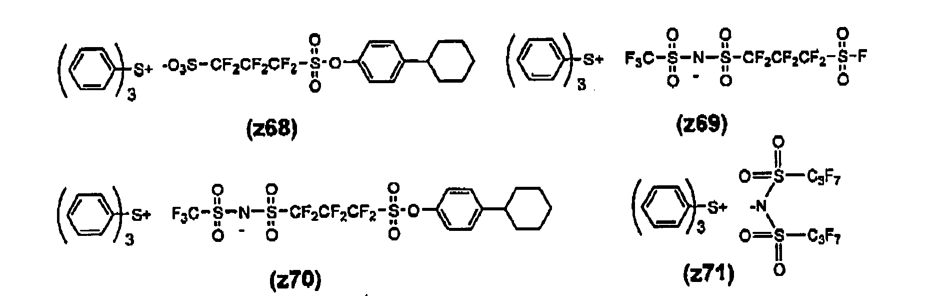

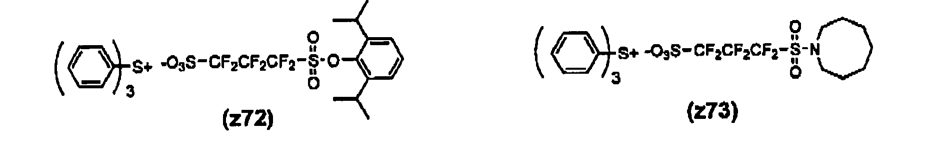

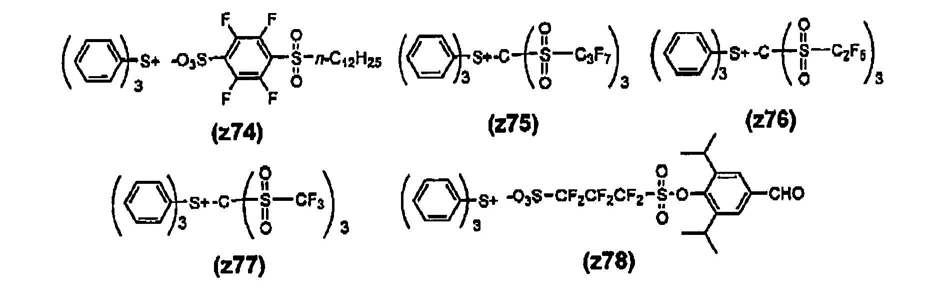

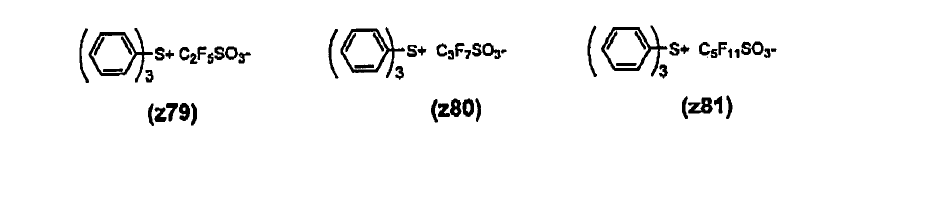

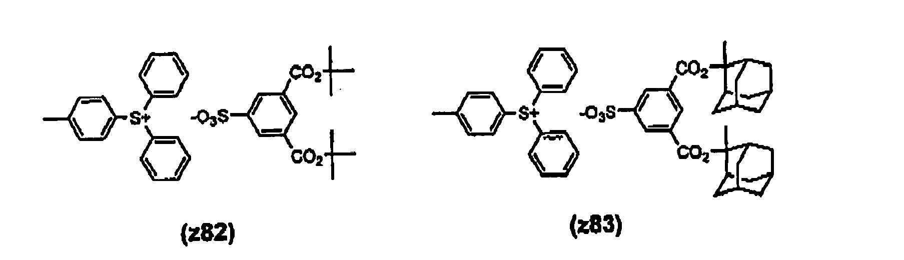

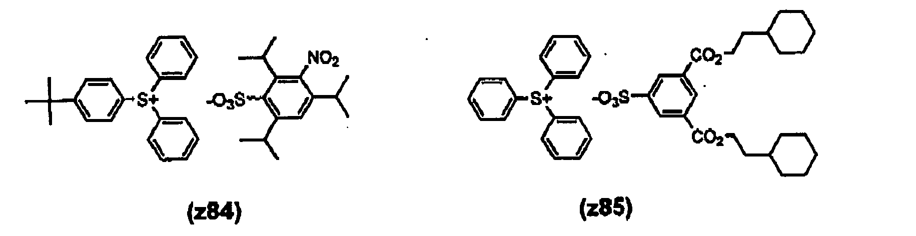

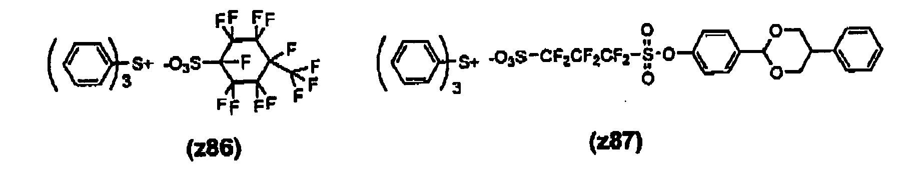

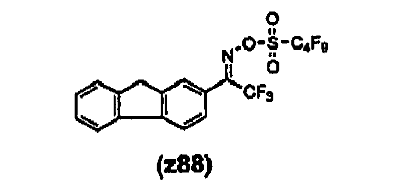

One kind of an acid generator may be used alone or two or more kinds of acid generators may be used in combination.

The content of the acid generator in the negative resist composition is preferably from 0.1 to 20 mass%, more preferably from 0.5 to 10 mass%, still more preferably from 1 to 7 mass%, based on the entire solid content of the negative resist composition.

### Basic Compound:

The negative resist composition of the present invention preferably contains a basic compound for reducing the change of performance in aging from exposure until heating.

Preferred examples of the basic compound include compounds having a structure represented by any one of the following formulae (A) to (E).

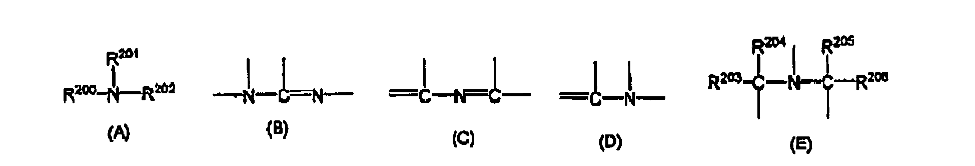

In formulae (A) to (E), R²⁰⁰, R²⁰¹ and R²⁰², which may be the same or different, each represents a hydrogen atom, an alkyl group (preferably having a carbon number of 1 to 20), a cycloalkyl group (preferably having a carbon number of 3 to 20) or an aryl group (having a carbon number of 6 to 20), and R²⁰¹ and R²⁰² may combine with each other to form a ring.

As for the alkyl group, the alkyl group having a substituent is preferably an aminoalkyl group having a carbon number of I to 20, a hydroxyalkyl group having a carbon number of 1 to 20, or a cyanoalkyl group having a carbon number of 1 to 20.

R²⁰³, R²⁰⁴, R²⁰⁵ and R²⁰⁶, which may be the same or different, each represents an alkyl group having a carbon number of 1 to 20.

The alkyl group in these formulae (A) to (E) is more preferably unsubstituted.

Preferred examples of the compound include guanidine, aminopyrrolidine, pyrazole, pyrazoline, piperazine, aminomorpholine, aminoalkylmorpholine and piperidine, More preferred examples of the compound include a compound having an imidazole structure, a diazabicyclo structure, an onium hydroxide structure, an onium carboxylate structure, a trialkylamine structure, an aniline structure or a pyridine structure; an alkylamine derivative having a hydroxyl group and/or an ether bond; and an aniline derivative having a hydroxyl group and/or an ether bond.

Examples of the compound having an imidazole structure include imidazole, 2,4,5-triphenylimidazole and benzimidazole. Examples of the compound having a diazabicyclo structure include 1,4-diazabzcyclo[2,2,2]ootaae, 1,5-diazabicyclo[4,3,0]non-5-ene and 1,8-diazabicyclo[5,4,0]undec-7-ene. Examples of the compound having an onium hydroxide structure include triarylsulfonium hydroxide, phenacylsulfonium hydroxide and sulfonium hydroxide having a 2-oxoalkyl group, specifically, triphenylsulfonium hydroxide, tris(tert-butylpheztyl)sulfonium hydroxide, bis(tert-butylphenyl)iodonium hydroxide, phenacylthiophenium hydroxide and 2-oxopropylthiophenium hydroxide. Examples of the compound having an onium carboxylate structure include a compound where the anion moiety of the compound having an onium hydroxide structure is changed to a carboxylate, such as acetate, adamantane-1-carboxylate and perfluoroalkyl carboxylate. Examples of the compound having a trialkylamine structure include tri(n-butyl)amine and tri(n-octyl)amine. Examples of the aniline compound include 2,6-diisopropylaniline, N,N-dimethylaniline, N,N-dibutylaniline and N,N-dihexylaniline. Examples of the alkylamine derivative having a hydroxyl group and/or an ether bond include ethanolamine, diethanolamine, triethanolamine and tris(methoxyethoxyethyl)amine. Examples of the aniline derivative having a hydroxyl group and/or an ether bond include N,N-bis(hydroxyethyl)aniline.

One of these basic compounds is used alone, or two or more species thereof are used in combination.

The amount of the basic compound used is usually from 0.001 to 10 mass%, preferably from 0.01 to 5 mass%, based on the solid content of the negative resist composition.

The ratio of the acid generator and the basic compound used in the composition is preferably acid generator/basic compound (by mol) = from 2.5 to 300. That is, the molar ratio is preferably 2.5 or more in view of sensitivity and resolution and preferably 300 or less from the standpoint of suppressing the reduction in resolution due to thickening of the resist pattern in aging after exposure until heat treatment. The acid generator/basic compound (by mol) is more preferably from 5.0 to 200, still more preferably from 7.0 to 150.

### Surfactant:

The negative resist composition of the present invention preferably further contains a surfactant, more preferably any one fluorine-containing and/or silicon-containing surfactant (a fluorine-containing surfactant, a silicon-containing surfactant or a surfactant containing both a fluorine atom and a silicon atom) or two or more species thereof.

When the negative resist composition of the present invention contains the above-described surfactant, a resist pattern with good sensitivity, resolution and adhesion as well as less development defect can be obtained on use of an exposure light source of 250 nm or less, particularly 220 nm or less.

Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing surfactant and a silicon-containing surfactant, such as EFtop EF301 and EF303 (produced by Shin-Akita Kasei K.K.); Florad FC430, 431 and 4430 (produced by Sumitomo 3M Inc.); Megafac F171, F173, F176, F189, F113, F110, F177, F120 and R08 (produced by Dainippon Ink & Chemicals, Inc.); Surflon S-382, SC101, 102, 103, 104, 105 and 106 (produced by Asahi Glass Co., Ltd.); Troysol S-366 (produced by Troy Chemical); GF-300 and GF-150 (produced by Toagosei Chemical Industry Co., Ltd.); Surflon S-393 (produced by Seimi Chemical Co., Ltd.); Eftop EF121, EF122A, EF122B, RF122C, EF125M, EF135M, EF351, 352, EF801, EF802 and EF601 (produced by JEMCO Inc.); PF636, PF656, PF6320 and PF6520 (produced by OMNOVA); and FTX-204D, 208G, 218G, 230G, 204D, 208D, 212D, 218 and 222D (produced by NEOS Co., Ltd.). In addition, polysiloxane polymer KP-341 (produced by Shin-Etsu Chemical Co., Ltd.) may also be used as a silicon-containing surfactant.

Other than those known surfactants, a surfactant using a polymer having a fluoro-aliphatic group derived from a fluoro-aliphatic compound which is produced by a telomerization process (also called a telomer process) or an oligomerization process (also called an oligomer process), may be used. The fluoro-aliphatic compound can be synthesized by the method described in JP-A-2002-90991.

The polymer having a fluoro-aliphatic group is preferably a copolymer of a fluoro-aliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoro-aliphatic group-containing monomer and a (poly(oxyalkylene)) acrylate (or methacrylate) is not limited only to a binary copolymer but may also be a ternary or greater copolymer obtained by simultaneously copolymerizing two or more different fluoro-aliphatic group-containing monomers or two or more different (poly(oxyalkylene)) acrylates (or methacrylates).

Examples thereof include, as the commercially available surfactant, Megafac F178, F-470, F-473, F-475, F-476 and F-472 (produced by Dainippon Ink & Chemicals, Inc.) and further include a copolymer of a C₆F₁₃ group-containing acrylate (or methacrylate) with a (poly(oxyalkylene)) acrylate (or methacrylate), and a copolymer of a C₃F₇ group-containing acrylate (or methacrylate) with a (poly(oxyethylene)) acrylate (or methacrylate) and a (poly(oxypropylene)) acrylate (or methacrylate).

In the present invention, a surfactant other than the fluorine-containing and/or silicon-containing surfactant may also be used. Specific examples thereof include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate), and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

One of these surfactants may be used alone, or several species thereof may be used in combination.

The amount of the surfactant used is preferably from 0.01 to 10 mass%, more preferably from 0.1 to 5 mass%, based on the entire amount of the negative resist composition (excluding the solvent).

### Hydrophobic Resin:

In the case where the resist composition comprising the negative resist composition of the present invention is exposed through an immersion medium, a hydrophobic resin (HR) is preferably further added to the negative resist composition. By this addition, a hydrophobic resin (HR) is unevenly distributed to the surface layer of the resist film and when the immersion medium is water, the resist film formed can be enhanced in the receding contact angle on the resist film surface for water as well as in the followability to the immersion liquid. The hydrophobic resin (HR) may be any resin as long as the receding contact angle on the surface is enhanced by its addition, but a resin having at least either a fluorine atom or a silicon atom is preferred. The receding contact angle of the resist film is preferably from 60 to 90°, more preferably 70° or more. The amount of the hydrophobic resin added may be appropriately adjusted to give a resist film having a receding contact angle in the range above but is preferably from 0.1 to 10 mass%, more preferably from 0.1 to 5 mass%, based on the entire solid content of the negative resist composition, The hydrophobic resin (HR) is, as described above, unevenly distributed to the interface but unlike a surfactant, need not have necessarily a hydrophilic group within the molecule and may not contribute to uniform mixing of polar/nonpolar substances.

The fluorine atom or silicon atom in the hydrophobic resin (HR) may be present in the main chain of the resin or may be substituted to the side chain.

The hydrophobic resin (HR) is preferably a resin having a fluorine atom-containing alkyl group, a fluorine atom-containing cycloalkyl group or a fluorine atom-containing aryl group, as a fluorine atom-containing partial structure.

The fluorine atom-containing alkyl group (preferably having a carbon number of 1 to 10, more preferably from 1 to 4) is a linear or branched alkyl group with at least one hydrogen atom being substituted by a fluorine atom and may further have another substituent.

The fluorine atom-containing cycloalkyl group is a monocyclic or polycyclic cycloalkyl group with at least one hydrogen atom being substituted by a fluorine atom and may further have another substituent.

The fluorine atom-containing aryl group is an aryl group (e.g., phenyl group, naphthyl group) with at least one hydrogen atom being substituted by a fluorine atom and may further have another substituent.

Preferred examples of the fluorine atom-containing alkyl group, fluorine atom-containing cycloalkyl group and fluorine atom-containing aryl group include the groups represented by the following formulae (F2) to (F4), but the present invention is not limited thereto.

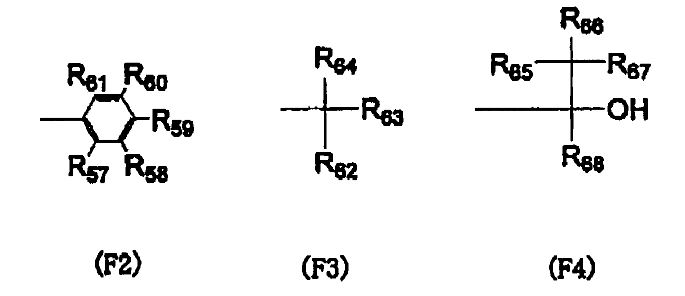

In formulae (F2) to (F4), R₅₇ to R₆₈ each independently represents a hydrogen atom, a fluorine atom or an alkyl group, provided that at least one of R₅₇ to R₆₁, at least one of R₆₂ to R₆₄ and at least one of R₆₅ to R₆₈ are a fluorine atom or an alkyl group (preferably having a carbon number of 1 to 4) with at least one hydrogen atom being substituted by a fluorine atom. It is preferred that R₅₇ to R₆₁ and R₆₅ to R₆₇ all are a fluorine atom. R₆₂, R₆₃ and R₆₈ each is preferably an alkyl group (preferably having a carbon number of 1 to 4) with at least one hydrogen atom being substituted by a fluorine atom, more preferably a perfluoroalkyl group having a carbon number of 1 to 4. R₆₂ and R₆₃ may combine with each other to form a ring.

Specific examples of the group represented by formula (F2) include p-fluorophenyl group, pentafluorophenyl group and 3,5-di(trifluoromethyl)phenyl group.

Specific examples of the group represented by formula (F3) include trifluoromethyl group, pentafluoropropyl group, pentafluoroethyl group, heptafluorobutyl group, hexafluoroisopropyl group, heptafluoroisopropyl group, hexafluoro(2-methyl)isopropyl group, nonafluorobutyl group, octafluoroisobutyl group, nonafluorohexyl group, nonafluoro-tert-butyl group, perfluoroisopentyl group, perfluorooctyl group, perfluoro(trimethyl)hexyl group, 2,2,3,3-tetrafluorocyclobutyl group and perfluorocyclohexyl group. Among these, hexafluoroisopropyl group, heptafluoroisopropyl group, hexafluoro(2-methyl)isopropyl group, octafluoroisobutyl group, nonafluoro-tert-butyl group and perfluoroisopentyl group are preferred, and hexafluoroisopropyl group and heptafluoroisopropyl group are more preferred.

Specific examples of the group represented by formula (F4) include -C(CF₃)₂OH, -C(C₂F₅)₂OH, -C(CF₃)(CH₃)OH and -CH(CF₃)OH, with -C(CF₃)₂OH being preferred.

Specific examples of the repeating unit having a fluorine atom are set forth below, but the present invention is not limited thereto.

In specific examples, X₁ represents a hydrogen atom, -CH₃, -F or -CF₃.

X₂ represents -F or -CF₃.

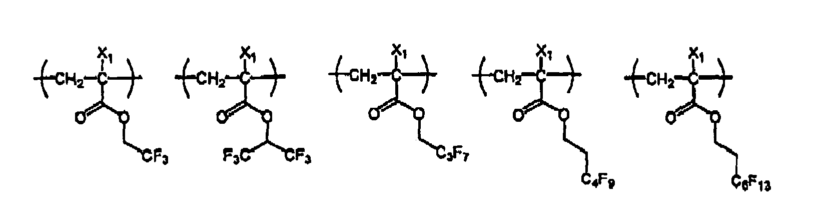

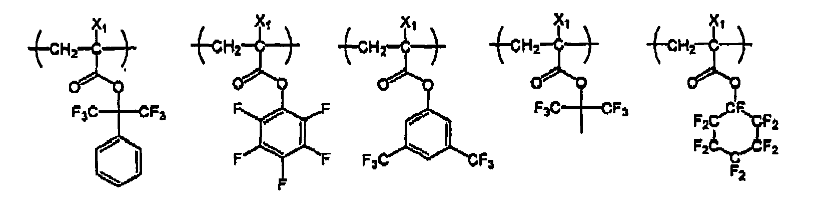

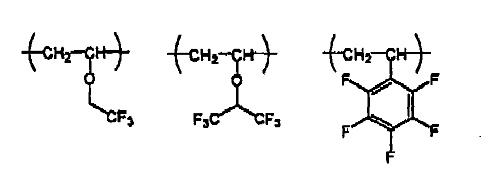

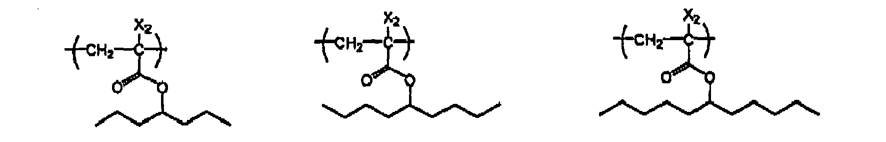

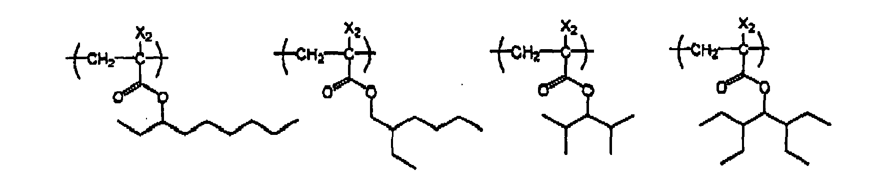

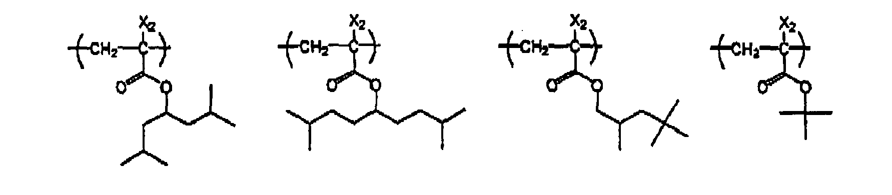

The hydrophobic resin (HR) is preferably a resin having an alkylsilyl structure (preferably a trialkylsilyl group) or a cyclic siloxane structure, as a silicon atom-containing partial structure.

Specific examples of the alkylsilyl structure and cyclic siloxane structure include the groups represented by the following formulae (CS-1) to (CS-3):

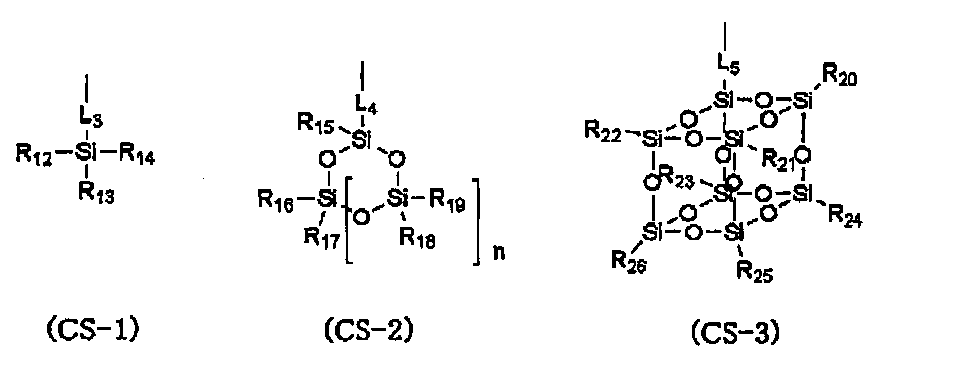

In formulae (CS-1) to (CS-3), R₁₂ to R₂₆ each independently represents a linear or branched alkyl group (preferably having a carbon number of 1 to 20) or a cycloalkyl group (preferably having a carbon number of 3 to 20).

L₃ to L₅ each represents a single bond or a divalent linking group. The divalent linking group is a sole group or a combination of two or more groups selected from the group consisting of an alkylene group, a phenyl group, an ether group, a thioether group, a carbonyl group, an ester group, an amide group, a urethane group and a urea group.
n represents an integer of 1 to 5.

Specific examples of the repeating unit having a silicon atom are set forth below, but the present invention is not limited thereto.

In specific examples, X₁ represents a hydrogen atom, -CH₃, -F or -CF₃.

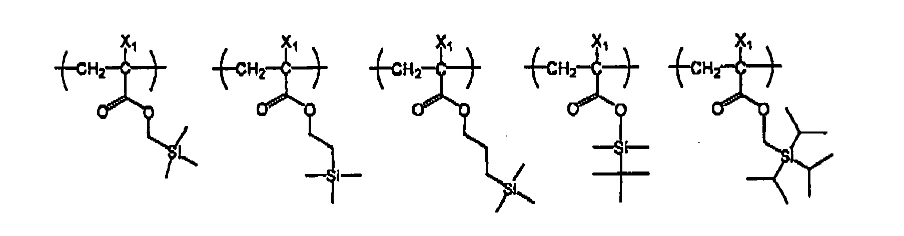

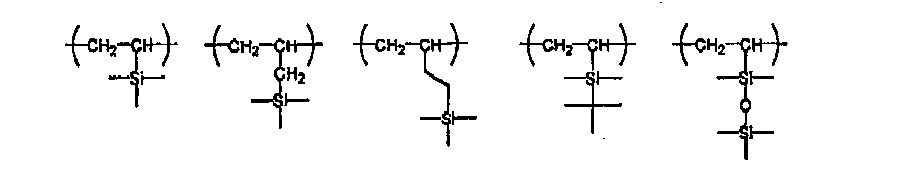

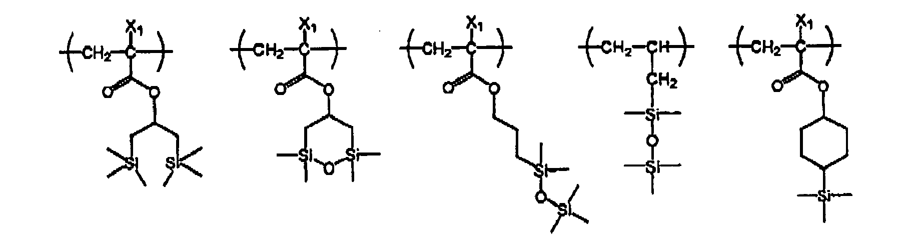

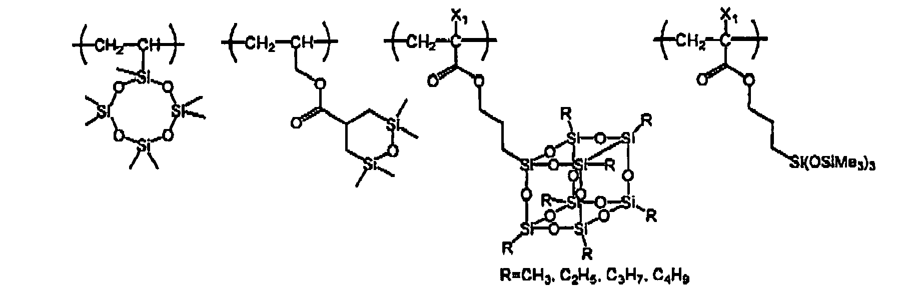

The hydrophobic resin (HR) may further contain at least one group selected from the group consisting of the following (x) to (z):
(x) an alkali-soluble group,
(y) a group which decomposes under the action of an alkali developer to increase the solubility in an alkali developer, and
(z) a group which decomposes under the action of an acid.

Examples of the (x) alkali-soluble group include groups having a phenolic hydroxyl group, a carboxylic acid group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)-imide group, a tris(allcylcarbonyl)methylene group or a tris(alkylsulfonyl)methylene group.

Preferred alkali-soluble groups are a fluorinated alcohol group (preferably hexafluoroisopropanol), a sulfonimide group and a bis(carbonyl)methylene group.

As for the repeating unit having (x) an alkali-soluble group, all of a repeating unit where an alkali-soluble group is directly bonded to the resin main chain, such as repeating unit by an acrylic acid or a methacrylic acid, a repeating unit where an alkali-soluble group is bonded to the resin main chain through a linking group, and a repeating unit where an alkali-soluble group is introduced into the polymer chain terminal by using an alkali-soluble group-containing polymerization initiator or chain transfer agent at the polymerization, are preferred.

The content of the repeating unit having (x) an alkali-soluble group is preferably from 1 to 50 mol%, more preferably from 3 to 35 mol%, still more preferably from 5 to 20 mol%, based on all repeating units in the polymer.

Specific examples of the repeating unit having (x) an alkali-soluble group are set forth below, but the present invention is not limited thereto.

In the formulae, Rx represents H, CH₃, CF₃ or CH₂OH.

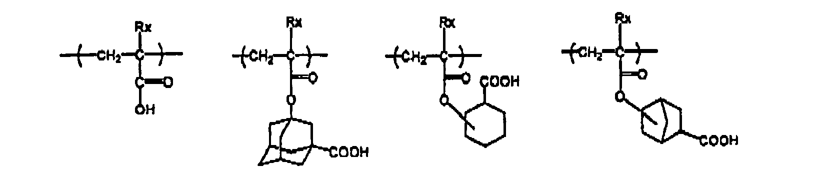

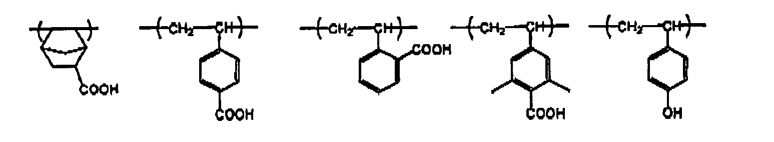

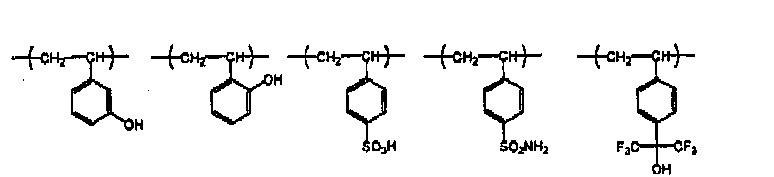

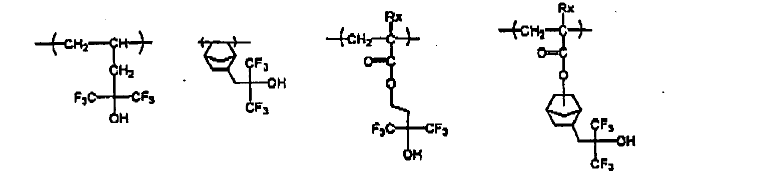

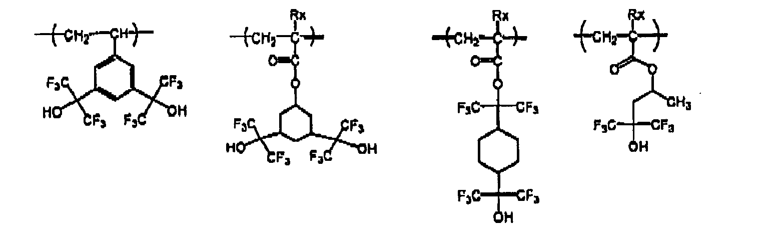

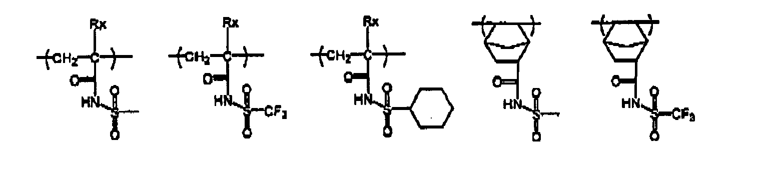

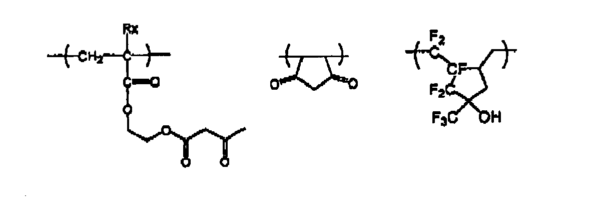

Examples of the (y) group which decomposes under the action of an alkali developer to increase the solubility in an alkali developer include a lactone structure-containing group, an acid anhydride and an acid imide group, with a lactone group being preferred.

As for the repeating unit having (y) a group which decomposes under the action of an alkali developer to increase the solubility in an alkali developer, both a repeating unit where (y) a group which decomposes under the action of an alkali developer to increase the solubility in an alkali developer is bonded to the resin main chain, such as repeating unit by an acrylic acid ester or a methacrylic acid ester, and a repeating unit where (y) a group which decomposes under the action of an alkali developer to increase the solubility in an alkali developer is introduced into the polymer chain terminal by using, at the polymerization, a polymerization initiator or chain transfer agent having the above-described group, are preferred.

The content of the repeating unit having (y) a group which increases the solubility in an alkali developer is preferably from 1 to 40 mol%, more preferably from 3 to 30 mol%, still more preferably from 5 to 15 mol%, based on all repeating units in the polymer.

Specific examples of the repeating unit having (y) a group which increases the solubility in an alkali developer are the same as those of the repeating unit having a lactone structure described for the component (B).

Examples of the repeating unit having (z) a group which decomposes under the action of an acid, contained in the hydrophobic resin (HR), are the same as those of the repeating unit having an acid-decomposable group described for the component (B). In the hydrophobic resin (HR), the content of the repeating unit having (z) a group which decomposes under the action of an acid is preferably from 1 to 80 mol%, more preferably from 10 to 80 mol%, still more preferably from 20 to 60 mol%.

The hydrophobic resin (HR) may further contain a repeating unit represented by the following formula (III).

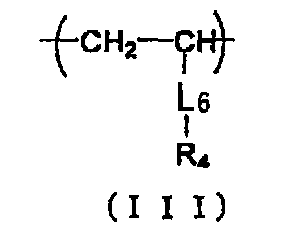

In formula (III), R₄ represents a group having an alkyl group, a cycloalkyl group, an alkenyl group or a cycloalkenyl group.

L₆ represents a single bond or a divalent linking group.

In formula (III), the alkyl group of R₄ is preferably a linear or branched alkyl group having a carbon number of 3 to 20.

The cycloalkyl group is preferably a cycloalkyl group having a carbon number of 3 to 20.

The alkenyl group is preferably an alkenyl group having a carbon number of 3 to 20.

The cycloalkenyl group is preferably a cycloalkenyl group having a carbon number of 3 to 20.

The divalent linking group of L₆ is preferably an alkylene group (preferably having a carbon number of 1 to 5) or an oxy group.

In the case where the hydrophobic resin (HR) contains a fluorine atom, the fluorine atom content is preferably from 5 to 80 mass%, more preferably from 10 to 80 mass%, based on the molecular weight of the hydrophobic resin (HR). Also, the fluorine atom-containing repeating unit preferably occupies from 10 to 100 mass%, more preferably from 30 to 100 mass%, in the hydrophobic resin (HR).

In the case where the hydrophobic resin (HR) contains a silicon atom, the silicon atom content is preferably from 2 to 50 mass%, more preferably from 2 to 30 mass%, based on the molecular weight of the hydrophobic resin (HR). Also, the silicon atom-containing repeating unit preferably occupies from 10 to 100 mass%, more preferably from 20 to 100 mass%, in the hydrophobic resin (HR).

The standard polystyrene-reduced weight average molecular of the hydrophobic resin (HR) is preferably from 1,000 to 100,000, more preferably from 1,000 to 50,000, still more preferably from 2,000 to 15,000.

Similarly to the component (B), it is preferred that, as a matter of course, the hydrophobic resin (HR) has less impurities such as metal and also, the content of the residual monomer or oligomer component is from 0 to 10 mass%, more preferably from 0 to 5 mass%, still more preferably from 0 to 1 mass%. When these conditions are satisfied, a resist free from foreign matters in liquid or change in the sensitivity and the like with the lapse of time can be obtained. Also, in view of the resolution, resist profile, and side wall, roughness or the like of the resist pattern, the molecular weight distribution (Mw/Mn, also called dispersity) is preferably from 1 to 5, more preferably from 1 to 3, still more preferably from 1 to 2.

As for the hydrophobic resin (HR), various commercially available products may be used or the resin may be synthesized by an ordinary method (for example, radical polymerization)). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours, A dropping polymerization method is preferred. Examples of the reaction solvent include tetrahydrofuran, 1,4-dioxane, ethers such as diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is described later, such as propylene glycol monomethyl ether acetate, propylene glycol monomethyl ether and cyclohexanone. The polymerization is more preferably performed using the same solvent as the solvent used in the negative resist composition of the present invention. By the use of this solvent, generation of particles during storage can be suppressed.

The polymerization reaction is preferably performed in an inert gas atmosphere such as nitrogen and argon. As for the polymerization initiator, the polymerization is initiated using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdiznethylvaleronitrile and dimethyl 2,2'-azobis(2-methylpropionate). The reaction concentration is from 5 to 50 mass%, preferably from 30 to 50 mass%, and the reaction temperature is usually from 10 to 150°C, preferably from 30 to 120°C, more preferably from 60 to 100°C.

After the completion of reaction, the reaction product is allowed to cool to room temperature and purified. The purification may be performed by a normal method, for example, a liquid-liquid extraction method of applying water washing or combining an appropriate solvent to remove residual monomers or oligomer components; a purification method in a solution sate, such as ultrafiltration of removing by extraction only polymers having a molecular weight not more than a specific molecular weight; a reprecipitation method of adding dropwise the resin solution in a bad solvent to solidify the resin in the bad solvent and thereby remove residual monomers or the like; and a purification method in a solid state, such as washing of the resin slurry with a bad solvent after separation by filtration. For example, the resin is precipitated as a solid matter through contact with a solvent in which the resin is sparingly soluble or insoluble (bad solvent) and which is in a volume amount of 10 times or less, preferably from 10 to 5 times, the reaction solution.

The solvent used at the operation of precipitation or reprecipitation from the polymer solution (precipitation or reprecipitation solvent) may be sufficient if it is a bad solvent to the polymer, and the solvent used may be appropriately selected, for example, from a hydrocarbon, a halogenated hydrocarbon, a nitro compound, an ether, a ketone, an ester, a carbonate, an alcohol, a carboxylic acid, water, and a mixed solvent containing such a solvent, according to the kind of the polymer. Among these solvents, the precipitation or reprecipitation solvent is preferably a solvent containing at least an alcohol (particularly methanol or the like) or water.

The amount of the precipitation or reprecipitation solvent used may be appropriately selected by taking into account the efficiency, yield and the like, but in general, the amount used is from 100 to 10,000 parts by mass, preferably from 200 to 2,000 parts by mass, more preferably from 300 to 1,000 parts by mass, per 100 parts by mass of the polymer solution.

The temperature at the precipitation or reprecipitation may be appropriately selected by taking into account the efficiency or operability, but the temperature is usually on the order of 0 to 50°C, preferably in the vicinity of room temperature (for example, approximately from 20 to 35°C). The precipitation or reprecipitation operation may be performed using a commonly employed mixing vessel such as stirring tank by a known method such as batch system or continuous system.

The precipitated or reprecipitated polymer is usually subjected to commonly employed solid-liquid separation such as filtration and centrifugation, then dried and used. The filtration is performed using a solvent-resistant filter element preferably under pressure. The drying is performed under atmospheric pressure or reduced pressure (preferably under reduced pressure) at a temperature of approximately from 30 to 100°C, preferably on the order of 30 to 50°C.

Incidentally, after the resin is once precipitated and separated, the resin may be again dissolved in a solvent and then put into contact with a solvent in which the resin is sparingly soluble or insoluble. More specifically, there may be used a method comprising, after the completion of radical polymerization reaction, bringing the polymer into contact with a solvent in which the polymer is sparingly soluble or insoluble, to precipitate a resin (step a), separating the resin from the solution (step b), anew dissolving the resin in a solvent to prepare a resin solution A (step c), bringing the resin solution A into contact with a solvent in which the resin is sparingly soluble or insoluble and which is in a volume amount of less than 10 times (preferably 5 times or less) the resin solution A, to precipitate a resin solid (step d), and separating the precipitated resin (step e).

Specific examples of the hydrophobic resin (HR) are set forth below. Also, the molar ratio of repeating units (corresponding to repeating units from the left), weight average molecular weight and dispersity of each resin are shown in Table 1 below.

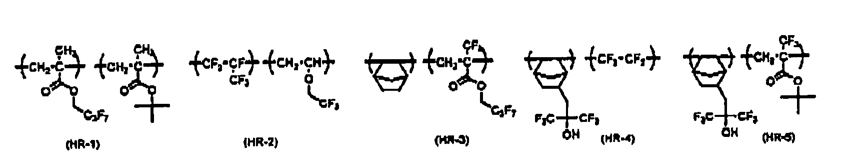

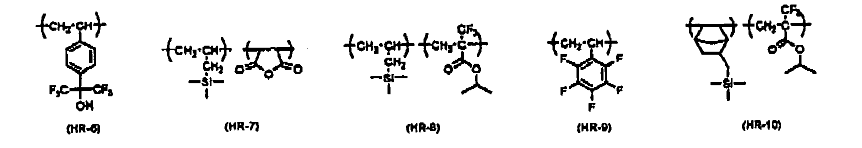

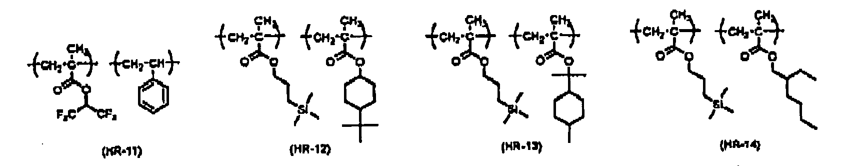

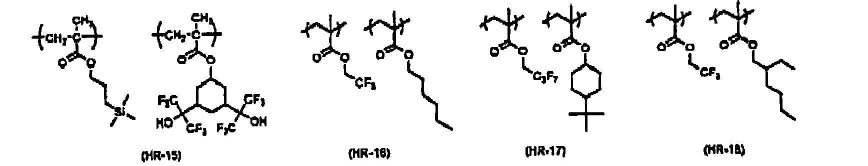

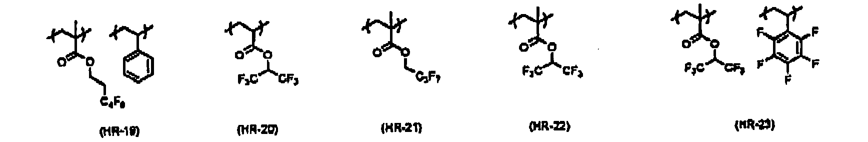

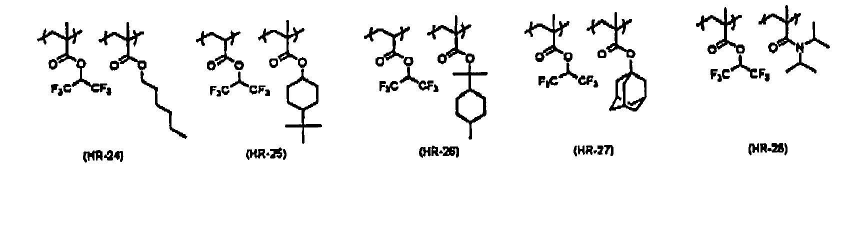

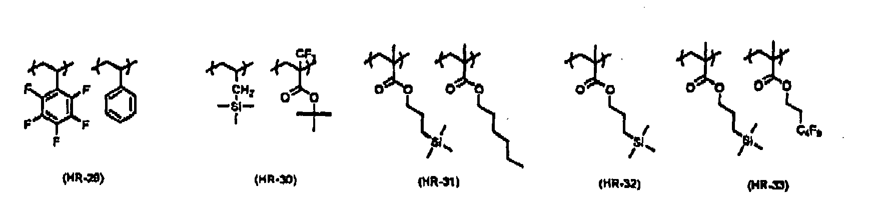

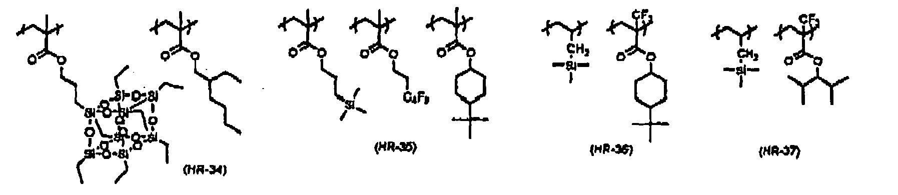

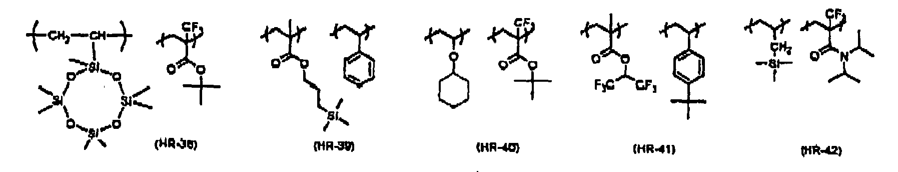

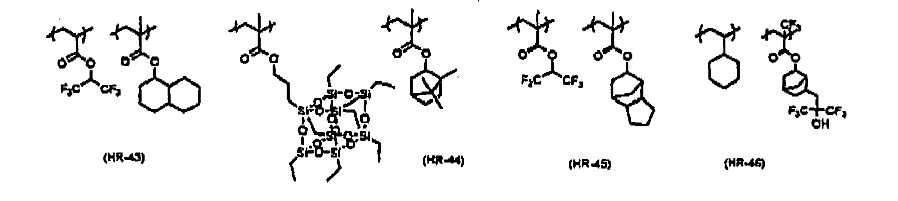

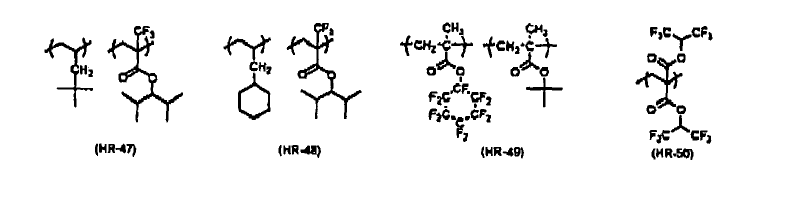

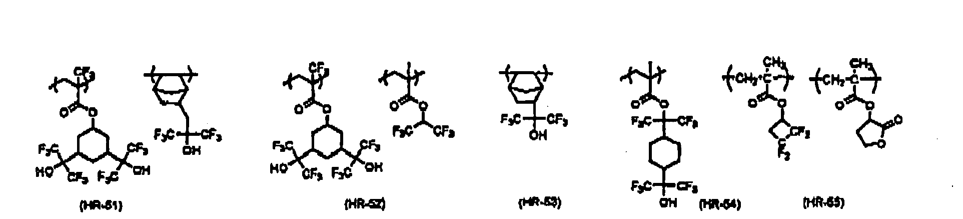

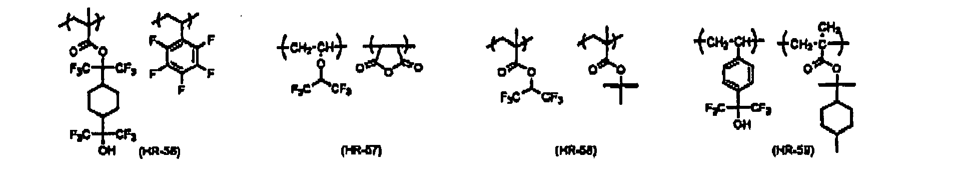

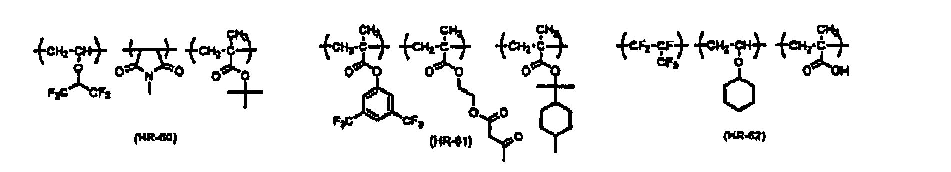

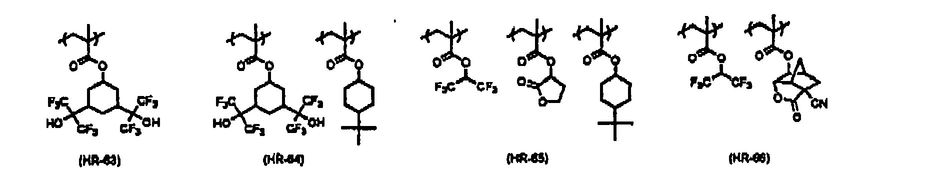

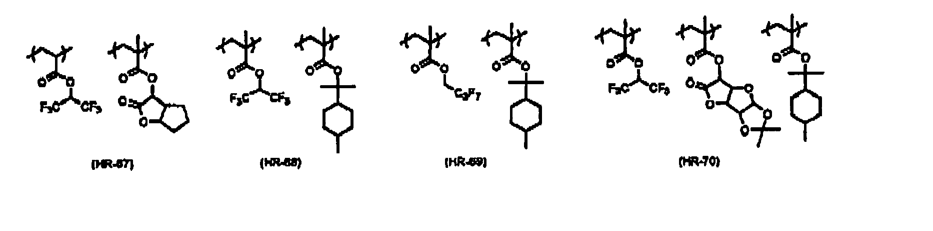

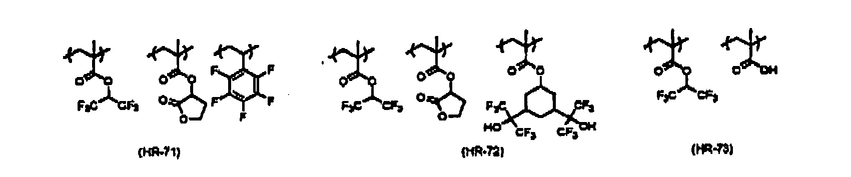

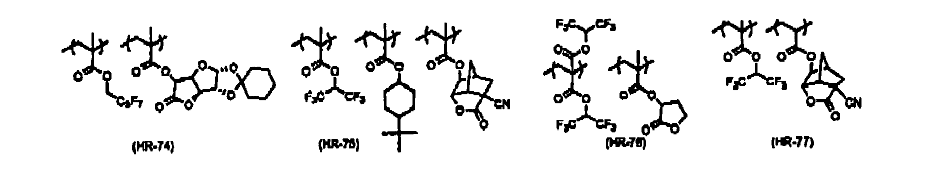

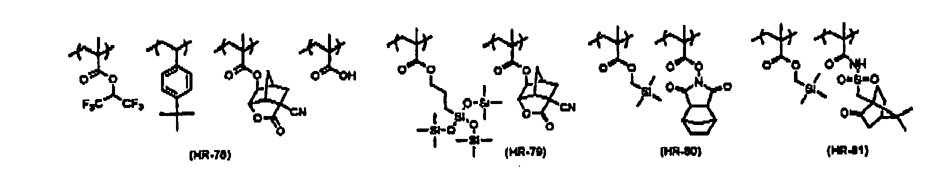

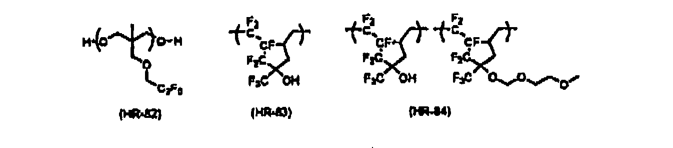

**Table 1**

| Resin | Composition | Mw | Mw/Mn | | Resin | Composition | Mw | Mw/Mn |
|---|---|---|---|---|---|---|---|---|
| HR-1 | 50/50 | 8800 | 2.1 | | HR-51 | 60/40 | 8800 | 1.5 |
| HR-2 | 50/50 | 5200 | 1.8 | | HR-52 | 68/32 | 11000 | 1.7 |
| HR-3 | 50/50 | 4800 | 1.9 | | HR-53 | 100 | 8000 | 1.4 |
| HR-4 | 50/50 | 5300 | 1.9 | | HR-54 | 100 | 8500 | 1.4 |
| HR-5 | 50/50 | 6200 | 1.9 | | HR-55 | 80/20 | 13000 | 2.1 |
| HR-6 | 100 | 12000 | 2.0 | | HR-56 | 70/30 | 18000 | 2.3 |
| HR-7 | 50/50 | 5800 | 1.9 | | HR-57 | 50/50 | 5200 | 1.9 |
| HR-8 | 50/50 | 6300 | 1.9 | | HR-58 | 50/50 | 10200 | 2.2 |
| HR-9 | 100 | 5500 | 2.0 | | HR-59 | 60/40 | 7200 | 2.2 |
| HR-10 | 50/50 | 7500 | 1.9 | | HR-60 | 32/32/36 | 5600 | 2.0 |
| HR-11 | 70/30 | 10200 | 2.2 | | HR-61 | 30/30/40 | 9600 | 1.6 |
| HR-12 | 40/60 | 15000 | 2.2 | | HR-62 | 40/40/20 | 12000 | 2.0 |
| HR-13 | 40/60 | 13000 | 2.2 | | HR-63 | 100 | 6800 | 1.6 |
| HR-14 | 80/20 | 11000 | 2.2 | | HR-64 | 50/50 | 7900 | 1.9 |
| HR-15 | 60/40 | 9800 | 2.2 | | HR-65 | 40/30/30 | 5600 | 2.1 |
| HR-16 | 50/50 | 8000 | 2.2 | | HR-66 | 50/50 | 6800 | 1.7 |
| HR-17 | 50/50 | 7600 | 2.0 | | HR-67 | 50/50 | 5900 | 1.6 |
| HR-18 | 50/50 | 12000 | 2.0 | | HR-68 | 49/51 | 6200 | 1.8 |
| HR-19 | 20/80 | 6500 | 1.8 | | HR-69 | 50/50 | 8000 | 1.9 |
| HR-20 | 100 | 6500 | 1.2 | | HR-70 | 30/40/30 | 9600 | 2.3 |
| HR-21 | 100 | 6000 | 1.6 | | HR-71 | 30/40130 | 9200 | 2.0 |
| HR-22 | 100 | 2000 | 1.6 | | HR-72 | 40/29/31 | 3200 | 2.1 |
| HR-23 | 50/50 | 6000 | 1.7 | | HR-73 | 90/10 | 6500 | 2.2 |
| HR-24 | 50/50 | 8800 | 1.9 | | HR-74 | 50/50 | 7900 | 1.9 |
| HR-25 | 50/50 | 7800 | 2.0 | | HR-75 | 20/30/50 | 10800 | 1.6 |
| HR-26 | 50/50 | 8000 | 2.0 | | HR-76 | 50/50 | 2200 | 1.9 |
| HR-27 | 80/20 | 8000 | 1.8 | | HR-77 | 50/50 | 5900 | 2.1 |
| HR-28 | 30/70 | 7000 | 1.7 | | HR-78 | 40/20/30/10 | 14000 | 2.2 |
| HR-29 | 50/50 | 6500 | 1.6 | | HR-79 | 50/50 | 5500 | 1.8 |
| HR-30 | 50/50 | 6500 | 1.6 | | Hk-80 | 50/50 | 10600 | 1.9 |
| HR-31 | 50/50 | 9000 | 1.8 | | HR-81 | 50/50 | 8600 | 2.3 |
| HR-32 | 100 | 10000 | 1.6 | | HR-82 | 100 | 15000 | 2.1 |
| HR-33 | 70/30 | 8000 | 2.0 | | HR-83 | 100 | 6900 | 2.5 |
| HR-34 | 10/90 | 8000 | 1.8 | | HR-84 | 50/50 | 9900 | 2.3 |
| HR-35 | 30/30/40 | 9000 | 2.0 | | | | | |
| HR-36 | 50/50 | 6000 | 1.4 | | | | | |
| HR-37 | 50/50 | 5500 | 1.5 | | | | | |
| HR-38 | 50/50 | 4800 | 1.8 | | | | | |
| HR-39 | 60/40 | 5200 | 1.8 | | | | | |
| HR-40 | 50/50 | 8000 | 1.5 | | | | | |
| HR-41 | 20/80 | 7500 | 1.8 | | | | | |
| HR-42 | 50/50 | 6200 | 1.6 | | | | | |
| HR-43 | 60/40 | 16000 | 1.8 | | | | | |
| HR-44 | 80/20 | 10200 | 1.8 | | | | | |
| HR-45 | 50/50 | 12000 | 2.6 | | | | | |
| HR-46 | 50/50 | 10900 | 1.9 | | | | | |
| HR-47 | 50/50 | 6000 | 1.4 | | | | | |
| HR-48 | 50/50 | 4500 | 1.4 | | | | | |
| HR-49 | 50/50 | 6900 | 1.9 | | | | | |
| HR-50 | 100 | 2300 | 2.6 | | | | | |

### Dissolution Inhibitor:

The negative resist composition of the present invention may contain a dissolution inhibiting compound capable of decomposing under the action of an acid to increase the solubility in an alkali developer and having a molecular weight of 3,000 or less.

As for the dissolution inhibiting compound capable of decomposing under the action of an acid to increase the solubility in an alkali developer and having a molecular weight of 3,000 or less (hereinafter sometimes referred to as a "dissolution inhibiting compound"), in order to prevent reduction in the transparency to light at 220 nm or less, an alicyclic or aliphatic compound containing an acid-decomposable group, such as acid-decomposable group-containing cholic acid derivative described in Proceeding of SPIE, 2724, 355 (1996) is preferred. Examples of the acid-decomposable group and alicyclic structure are the same as those described above for the component (B).

The molecular weight of the dissolution inhibiting compound for use in the present invention is 3,000 or less, preferably from 300 to 3,000, more preferably from 500 to 2,500.

The amount of the dissolution inhibiting compound added is preferably from 1 to 30 mass%, more preferably from 2 to 20 mass%, based on the solid content of the negative resist composition.

Specific examples of the dissolution inhibiting compound are set forth below, but the present invention is not limited thereto.

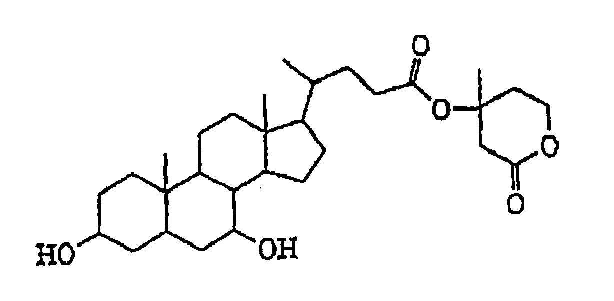

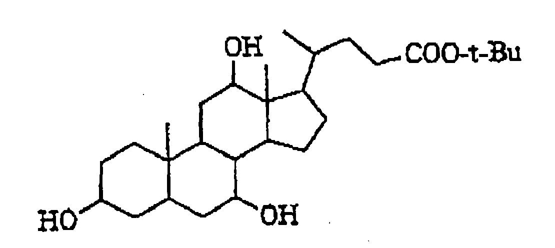

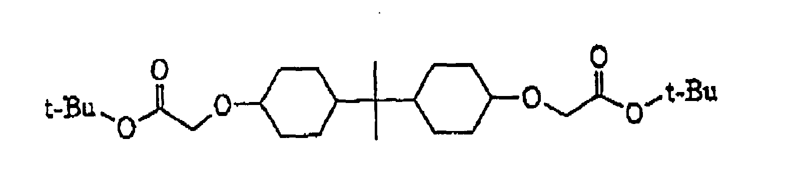

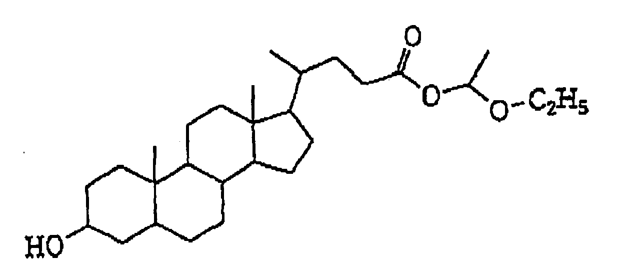

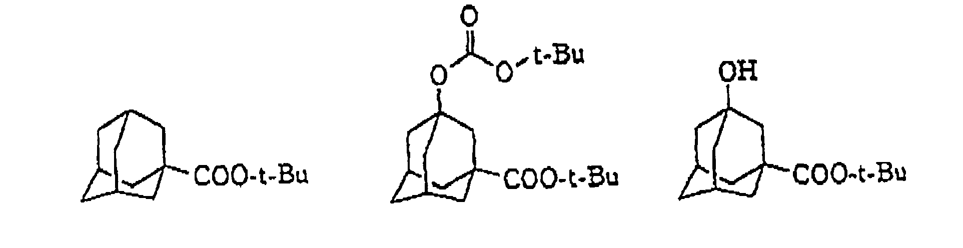

### Onium Carboxylate:

The negative resist composition of the present invention may contain an onium carboxylate,

Examples of the onium carboxylate include sulfonium carboxylate, iodonium carboxylate and ammonium carboxylate. In particular, the onium carboxylate is preferably an iodonium salt or a sulfonium salt. Furthermore, the carboxylate residue of the onium carboxylate for use in the present invention preferably contains no aromatic group and no carbon-carbon double bond. The anion moiety is preferably a linear, branched, monocyclic or polycyclic alkylcarboxylate anion having a carbon number of 1 to 30, more preferably an anion of carboxylic acid with the alkyl group being partially or entirely fluorine-substituted. The alkyl chain may contain an oxygen atom therein. By virtue of such a construction, the transparency to light of 220 nm or less is ensured, the sensitivity and resolution are enhanced, and the defocus latitude depended on line pitch and the exposure margin are improved.

Examples of the anion of fluorine-substituted carboxylic acid include anions of fluoroacetic acid, difluoroacetic acid, trifluoroacetic acid, pentafluoropropionic acid, heptafluorobutyric acid, nonafluoropentanoic acid, perl1uorododecanoic acid, perfluorotridecanoic acid, perfluorocyclohexanecarboxylic acid and 2,2-bistrifluoromethylpropionic acid.

These onium carboxylates can be synthesized by reacting a sulfonium, iodonium or ammonium hydroxide and a carboxylic acid with silver oxide in an appropriate solvent

The content of the onium carboxylate in the composition is generally from 0.1 to 20 mass%, preferably from 0.5 to 10 mass%, more preferably from 1 to 7 mass%, based on the entire solid content of the composition.

### Organic Solvent:

The negative resist composition of the present invention is used by dissolving the components described above in a predetermined organic solvent.

Examples of the organic solvent which can be used include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone, methoxybutanol and tetrahydrofuran.

In the present invention, a mixed solvent prepared by mixing a solvent having a hydroxyl group in the structure and a solvent having no hydroxyl group may be used as the organic solvent.

Examples of the solvent having a hydroxyl group include ethylene glycol, ethylene glycol monomethyl ether, ethylene glycol monoethyl ether, propylene glycol, propylene glycol monomethyl ether, propylene glycol monoethyl ether and ethyl lactate. Among these, propylene glycol monomethyl ether and ethyl lactate are preferred.

Examples of the solvent having no hydroxyl group include propylene glycol monomethyl ether acetate, ethyl ethoxypropionate, 2-heptanone, γ-butyrolactone, cyclohexanone, butyl acetate, N-methylpyrrolidone, N,N-dimethylacetamide and dimethylsulfoxide. Among these, propylene glycol monomethyl ether acetate, ethyl ethoxypropionate, 2-heptanone, γ-butyrolactone, cyclohexanone and butyl acetate are preferred, and propylene glycol monomethyl ether acetate, ethyl ethoxypropionate and 2-heptanone are more preferred.

The mixing ratio (by mass) of the solvent having a hydroxyl group and the solvent having no hydroxyl group is preferably from 1/99 to 99/1, more preferably from 10/90 to 90/10, still more preferably from 20/80 to 60/40. A mixed solvent containing 50 mass% or more of a solvent having no hydroxyl group is preferred in view of coating uniformity.

### Other Additives:

The negative resist composition of the present invention may further contain, for example, a dye, a plasticizer, a photosensitizer and a compound capable of accelerating dissolution in a developer, if desired.

The compound capable of accelerating the dissolution in a developer, which can be used in the present invention, is a low molecular compound having two or more phenolic OH groups or one or more carboxy groups and having a molecular weight of 1,000 or less. In the case of having a carboxyl group, an alicyclic or aliphatic compound is preferred.

The amount of the dissolution accelerating compound added is preferably from 2 to 50 mass%, more preferably from 5 to 30 mass%, based on the component (B). The amount in this range is preferred in view of development residue or pattern at the development.

The phenol compound having a molecular weight of 1,000 or less can be easily synthesized by one skilled in the art with reference to the method described, for example, in JP-A-4-122938, JP-A-2-28531, U.S. Patent 4,916,210 and European Patent 219294.

Specific examples of the alicyclic or aliphatic compound having a carboxy group include, but are not limited to, a carboxylic acid derivative having a steroid structure, such as cholic acid, deoxycholic acid and lithocholic acid, an adamantane carboxylic acid derivative, an adamantane dicarboxylic acid, a cyclohexanecarboxylic acid and a cyclohexanedicarboxylic acid.

### (Use Method)

From the standpoint of enhancing the resolution, the negative resist composition of the present invention is preferably used in a film thickness of 30 to 250 nm, more preferably from 30 to 200 nm. Such a film thickness can be obtained by setting the solid content concentration in the negative resist composition to fall within a proper range so as to impart an appropriate viscosity and enhance the coatability and film-forming property.

The entire solid content concentration in the negative resist composition is generally from 1 to 10 mass%, preferably from 1 to 8.0 mass%, more preferably from 1.0 to 6.0 mass%.

The negative resist composition of the present invention is used by dissolving the above-described components in a predetermined organic solvent, preferably a mixed solvent described above, filtering the solution through a filter, and coating it on a predetermined support as follows.

The filter used for filtration is preferably a filter made of polytetrafluoroethylene, polyethylene or nylon and having a pore size of 0.1 micron or less, more preferably 0.05 microns or less, still more preferably 0.03 microns or less.

For example, the negative resist composition is coated on a substrate (e.g., silicon/silicon dioxide-coated substrate) as those used in the production of a precision integrated circuit device, by an appropriate coating method such as spinner or coater, and dried to form a resist film.

The resist film formed is irradiated with actinic rays or radiation through a predetermined mask and preferably after baking (heating), subjected to development and rinsing, whereby a good pattern can be obtained.

Examples of the actinic rays or radiation include infrared light, visible light, ultraviolet light, far ultraviolet light, X-ray and electron beam, but the radiation is preferably far ultraviolet light at a wavelength of 250 nm or less, more preferably 220 nm or less, still more preferably from 1 to 200 nm. Specific examples thereof include KrF excimer laser light (248 nm), ArF excimer laser light (193 nm), F₂ excimer laser light (157 nm), X-ray and electron beam. ArF excimer laser light, F₂ excimer laser light, EUV (13 nm) and electron beam are preferred.

Before forming the resist film, an antireflection film may be previously provided by coating on the substrate.

The antireflection film used may be either an inorganic film type such as titanium, titanium dioxide, titanium nitride, chromium oxide, carbon and amorphous silicon, or an organic film type comprising a light absorbent and a polymer material. Also, the organic antireflection film may be a commercially available organic antireflection film such as DUV30 Series and DUV-40 Series produced by Brewer Science, Inc., and AR-2, AR-3 and AR-5 produced by Shipley Co., Ltd.

The exposure may be performed by filling a liquid (immersion medium) having a refractive index higher than that of air between the resist film and a lens at the irradiation with actinic rays or radiation (immersion exposure). By this exposure, the resolution can be enhanced. The immersion medium used may be any liquid as long as it has a refractive index higher than that of air, but pure water is preferred.

The immersion liquid used in the immersion exposure is described below.

The immersion liquid is preferably a liquid transparent to light at the exposure wavelength and having a temperature coefficient of refractive index as small as possible so as to minimize the distortion of an optical image projected on the resist film. Particularly, when the exposure light source is an ArF excimer laser (wavelength: 193 nm), water is preferably used in view of easy availability and easy handleability, in addition to the above-described aspects.

Furthermore, a medium having a refractive index of 1.5 or more may also be used because the refractive index can be more increased. This medium may be either an aqueous solution or an organic solvent.

In the case of using water as the immersion liquid, for the purpose of decreasing the surface tension of water and increasing the surface activity, an additive (liquid) which does not dissolve the resist film on a wafer and at the same time, gives only a negligible effect on the optical coat at the undersurface of the lens element, may be added in a small ratio. The additive is preferably an aliphatic alcohol having a refractive index nearly equal to that of water, and specific examples thereof include methyl alcohol, ethyl alcohol and isopropyl alcohol. By adding an alcohol having a refractive index nearly equal to that of water, even when the alcohol component in water is evaporated and its concentration is changed, the change in the refractive index of the liquid as a whole can be advantageously made very small. On the other hand, if a substance opaque to light at 193 nm or an impurity greatly differing in the refractive index from water is mingled, this incurs distortion of the optical image projected on the resist. Therefore, water used is preferably distilled water. Pure water after further filtration through an ion exchange filter or the like may also be used.

The electrical resistance of water is preferably 18.3 MQcm or more, and TOC (organic material concentration) is preferably 20 ppb or less. Also, the water is preferably subjected to a deaeration treatment.

The lithography performance can be enhanced by increasing the refractive index of the immersion liquid. From such an aspect, an additive capable of increasing the refractive index may be added to water, or heavy water (D₂O) may be used in place of water.

In order to prevent the resist film from directly contacting with the immersion liquid, an immersion liquid sparingly soluble film (hereinafter sometimes referred to as "a topcoat") may be provided between the immersion liquid and the resist film formed from the negative resist composition of the present invention. Functions required of the topcoat are suitability for coating on the resist upper layer part, transparency to radiation particularly at 193 nm, and difficult solubility in the immersion liquid. It is preferred that the topcoat does not intermix with the resist and can be uniformly coated on the resist upper layer.

In view of transparency to light at 193 nm, the topcoat is preferably an aromatic-poor polymer, and specific examples thereof include a hydrocarbon polymer, an acrylic acid ester polymer, a polymethacrylic acid, a polyacrylic acid, a polyvinyl ether, a silicon-containing polymer and a fluorine-containing polymer. The hydrophobic resin (HR) described above is suitable also as a topcoat. From the standpoint that an impurity when dissolved out from the topcoat into the immersion liquid contaminates the optical lens, the amount of the residual monomer component of the polymer contained in the topcoat is preferably smaller.

At the time of peeling off the topcoat, a developer may be used or a releasing agent may be separately used. The releasing agent is preferably a solvent less permeating into the resist film. From the standpoint that the peeling step can be performed simultaneously with the development step of the resist film, the topcoat is preferably peelable with an alkali developer and in view of peeling with an alkali developer, the topcoat is preferably acidic, but in terms of non-intermixing with the resist film, the topcoat may be neutral or alkaline.

With no difference in the refractive index between the topcoat and the immersion liquid, the resolving power is enhanced. In the case where water is used as the immersion liquid at the exposure with an ArF excimer laser (wavelength: 193 nm), the topcoat for ArF immersion exposure preferably has a refractive index close to the refractive index of the immersion liquid. From the standpoint of having a refractive index close to that of the immersion liquid, a fluorine atom is preferably contained in the topcoat. Also, in view of transparency and refractive index, the topcoat is preferably a thin film.

The topcoat is preferably not mixed with the resist film and further not mixed with the immersion liquid. In this respect, when the immersion liquid is water, the solvent used for the topcoat is preferably a water-insoluble medium sparingly soluble in the solvent used for the negative resist composition. In the case where the immersion liquid is an organic solvent, the topcoat may be water-soluble or water-insoluble.

The negative resist composition of the present invention may be applied to a multilayer resist process (particularly, a three-layer resist process). The multilayer resist process comprises the following steps:
(a) forming a lower resist layer comprising an organic material on a substrate to be processed,
(b) sequentially stacking on the lower resist layer an intermediate layer and an upper resist layer comprising an organic material capable of crosslinking or decomposing upon irradiation with radiation, and
(c) forming a predetermined pattern on the upper resist layer and then sequentially etching the intermediate layer, the lower layer and the substrate.

An organopolysiloxane (silicone resin) or SiO₂ coating solution (SOG) is generally used for the intermediate layer. As for the lower layer resist, an appropriate organic polymer film is used, but various known photoresists may be used. Examples thereof include various series such as FH Series and FHi Series produced by Fujifilm Arch Co., Ltd., and PFI Series produced by Sumitomo Chemical Co., Ltd,

The film thickness of the lower resist layer is preferably from 0.1 to 4.0 µm, more preferably from 0.2 to 2.0 µm, still more preferably from 0.25 to 1.5 µm. The film thickness is preferably 0.1 µm or more in view of antireflection or dry etching resistance and preferably 4.0 µm or less in view of aspect ratio or pattern collapse of the fine pattern formed.

In the development step, an alkali developer is used as follows. The alkali developer which can be used for the negative resist composition is an alkaline aqueous solution of inorganic alkalis such as sodium hydroxide, potassium hydroxide, sodium carbonate, sodium silicate, sodium metasilicate and aqueous ammonia, primary amines such as ethylamine and n-propylamine, secondary amines such as diethylamine and di-n-butylamine, tertiary amines such as triethylamine and methyldiethylamine, alcohol amines such as dimethylethanolamine and triethanolamine, quaternary ammonium salts such as tetramethylammonium hydroxide and tetraethylammonium hydroxide, and cyclic amines such as pyrrole and piperidine.

Furthermore, this alkali developer may be used after adding thereto an appropriate amount of alcohols or a surfactant.

The alkali concentration of the alkali developer is usually from 0.1 to 20 mass%.

The pH of the alkali developer is usually from 10.0 to 15.0.

Also, the above-described alkaline aqueous solution may be used after adding thereto an appropriate amount of alcohols or a surfactant.

As for the rinsing solution, pure water is used and the pure water may be used after adding thereto an appropriate amount of a surfactant.

After the development or rinsing, the developer or rinsing solution adhering on the pattern may removed by a supercritical fluid.

### [Examples]

The present invention is described in greater detail below by referring to Examples, but the present invention should not be construed as being limited thereto.

### Synthesis Example 1 (Synthesis of Resin (15)):

Under a nitrogen stream, 6.83 g of cyclohexanone was charged into a three-neck flask and heated at 80°C. Thereto, a solution prepared by dissolving 7.81 g of 2-hydroxyethyl methacrylate (produced by Wako Pure Chemical Industries, Ltd.), 6.93 g of 4,4-dimethyl-2-oxotetrahydrofuranyl methacrylate (produced by Aldrich), 1.18 g of 3-hydroxyadamantyl methacrylate (produced by Idemitsu Kosan Co., Ltd.), and polymerization initiator V-601 (produced by Wako Pure Chemical Industries, Ltd.) in an amount of 5 mol% based on the total monomer amount, in 61.48 g of cyclohexanone was added dropwise over 6 hours. After the completion of dropwise addition, the reaction was further allowed to proceed at 80°C for 2 hours. The reaction solution was left standing to cool and then added dropwise to a mixed solution of 800-ml hexane/200-ml ethyl acetate over 20 minutes, and the precipitated powder material was collected by filtration and dried to obtain 10.12 g of Resin (15). The compositional ratio of the obtained resin was 60/34/6, the weight average molecular weight was 8,000 in terms of standard polystyrene, and the dispersity (Mw/Mn) was 2.0.

Other resins were synthesized in the same manner. The structures of Resins (1) to (18) synthesized are shown below.

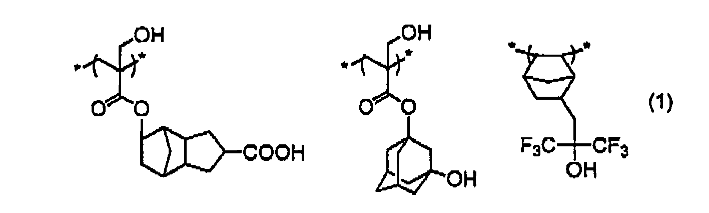

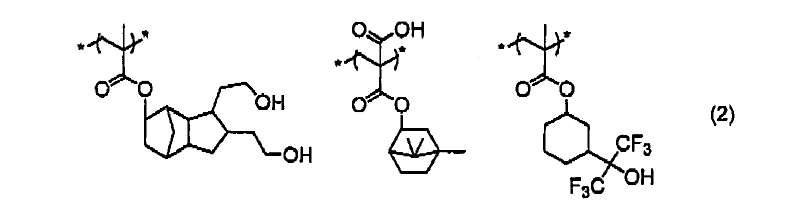

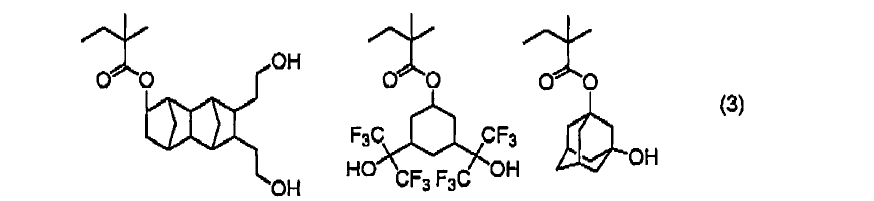

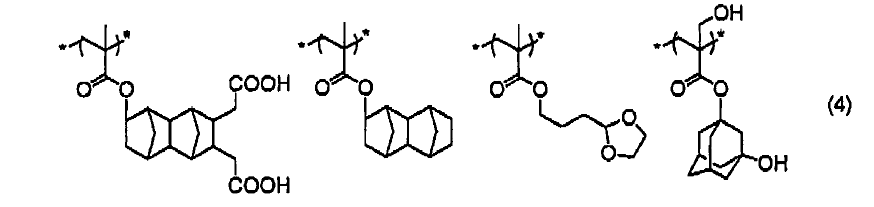

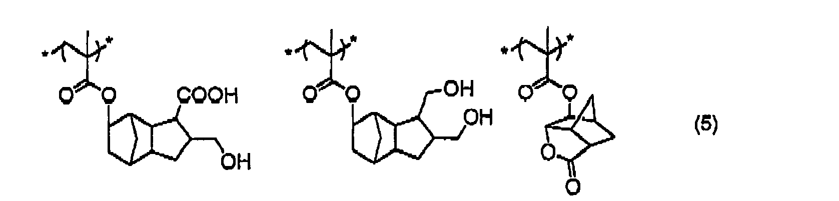

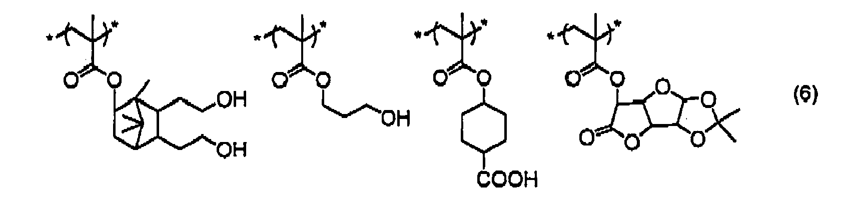

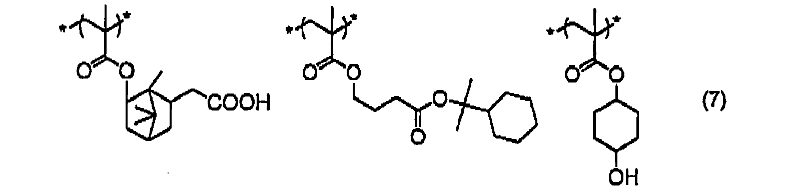

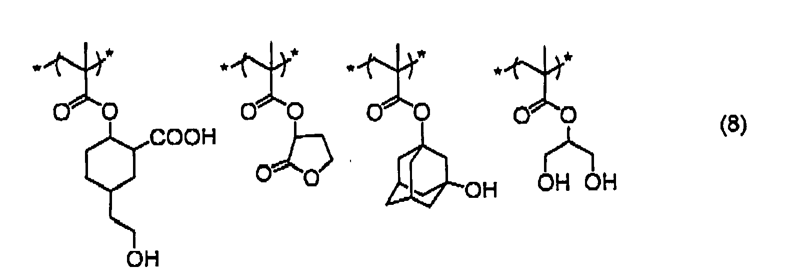

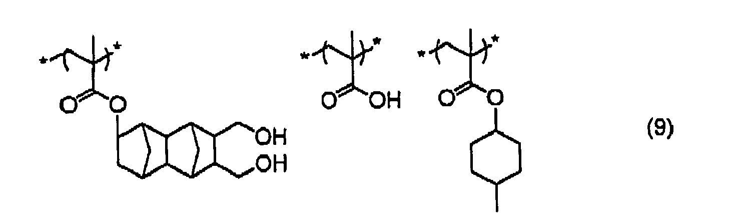

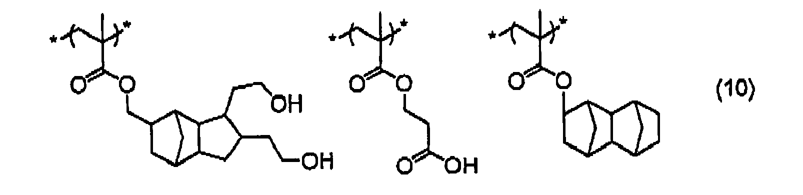

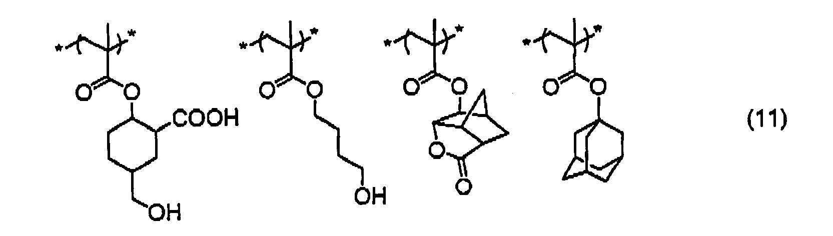

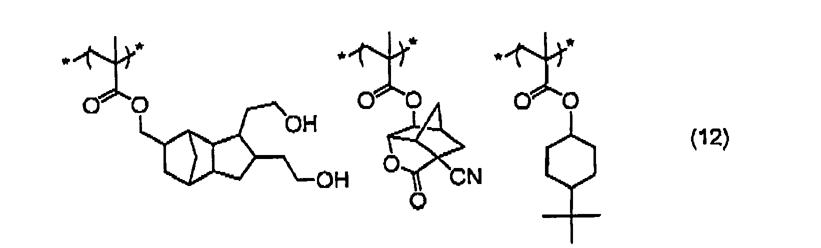

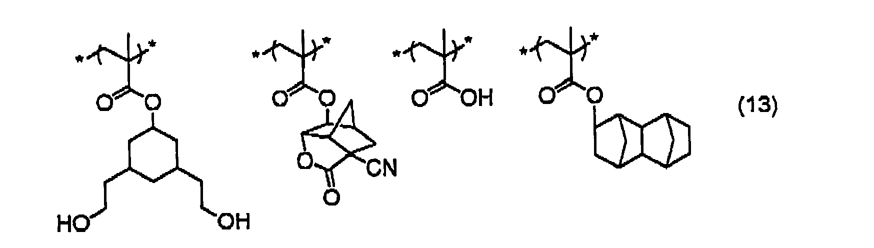

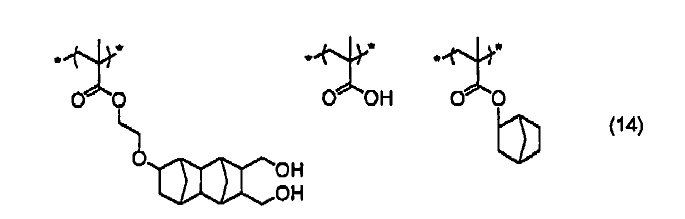

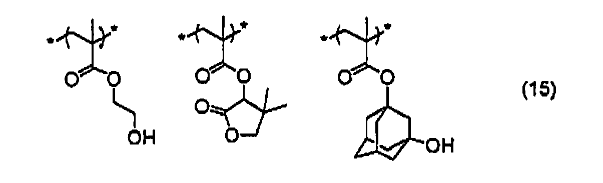

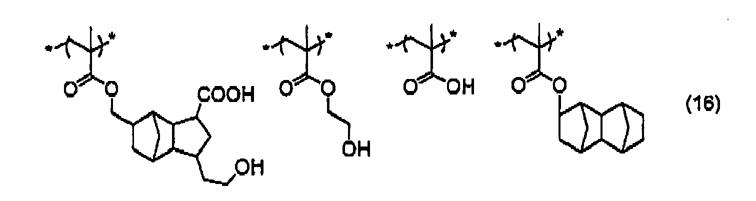

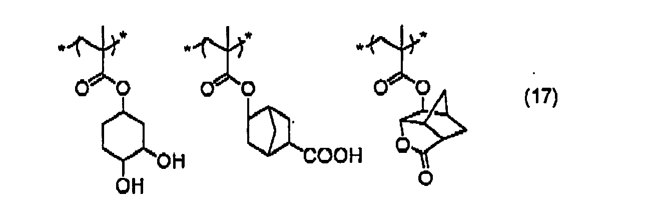

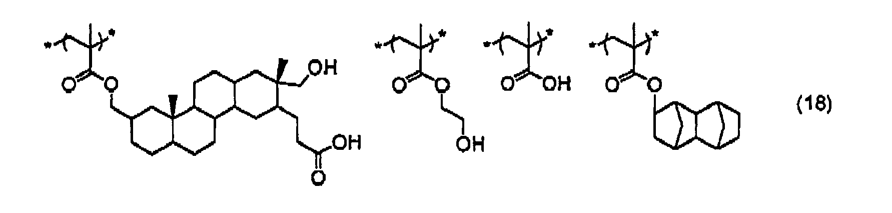

The compositional ratio (molar ratio, corresponding to repeating units from the left), weight average molecular weight and dispersity of each of Resins (1) to (18) are shown in Table 2 below.

**Table 2**

| Resin | Compositional Ratio (by mol) | Mw | Mw/Mn |
|---|---|---|---|
| 1 | 28/50/22 | 12300 | 1.9 |
| 2 | 71/14/15 | 10200 | 2.0 |
| 3 | 65/24/11 | 9600 | 1.7 |
| 4 | 65/5/20/10 | 8700 | 1.9 |
| 5 | 17/63/20 | 12500 | 2.3 |
| 6 | 62/11/8/19 | 7900 | 2.1 |
| 7 | 25/15/60 | 8500 | 1.8 |
| 8 | 28/10/5/57 | 11000 | 2.4 |
| 9 | 60/30/10 | 7600 | 2.1 |
| 10 | 65/20/15 | 9800 | 2.3 |
| 11 | 22/46/28/4 | 6100 | 1.8 |
| 12 | 35/45/20 | 5200 | 2.1 |
| 13 | 65/19/11/5 | 8600 | 2.3 |
| 14 | 70/25/5 | 12000 | 2.1 |
| 15 | 60/34/6 | 8000 | 2.0 |
| 16 | 30/50/11/9 | 8500 | 1.5 |
| 17 | 65/15/20 | 9800 | 1.8 |
| 18 | 31/44/10/15 | 9500 | 1.9 |

### Examples 1 to 31 and Comparative Examples 1 to 4:

### <Preparation of Resist>

The components shown in Table 3 below (in Examples 29 to 31, 0.1 g of Hydrophobic Resin (HR-22) was further added) were dissolved in a solvent to prepare a solution having a solid content concentration of 6 mass%, and the obtained solution was filtered through a 0.1-µm polyethylene filter to prepare a negative resist solution. The negative resist compositions prepared were evaluated by the following methods, and the results are shown in Table 3. As for each component in Table 3, the ratio when a plurality of species were used is a ratio by mass.

### <Image Performance Test>

### Exposure Condition (1):

In Examples 1 to 28 and Comparative Examples 1 to 4, an organic antireflection film, ARC29A (produced by Nissan Chemical Industries, Ltd.), was coated on a silicon wafer and baked at 205°C for 60 seconds to form a 78-nm antireflection film, and the negative resist composition prepared was coated thereon and baked at 130°C for 60 seconds to form a 250-nm resist film. The obtained wafer was pattern-exposed using an ArF excimer laser scanner (PAS5500/1100, manufactured by ASML, NA: 0.75, σo/σi = 0.85/0.55) and thereafter, the resist film was heated at 130°C for 60 seconds, developed with an aqueous tetramethylammonium hydroxide solution (2.38 mass%) for 30 seconds, rinsed with pure water and spin-dried to obtain a resist pattern.

### Exposure Condition (2):

This condition is to form a resist pattern by the immersion exposure method using pure water.

In Examples 29 to 31, an organic antireflection film, ARC29A (produced by Nissan Chemical Industries, Ltd.), was coated on a silicon wafer and baked at 205°C for 60 seconds to form a 78-nm antireflection film, and the negative resist composition prepared was coated thereon and baked at 130°C for 60 seconds to form a 250-nm resist film. The obtained wafer was pattern-exposed using an ArF excimer laser immersion scanner (NA: 0.85). The immersion liquid used was ultrapure water. Thereafter, the resist film was heated at 130°C for 60 seconds, developed with an aqueous tetramethylammonium hydroxide solution (2.38 mass%) for 30 seconds, rinsed with pure water and spin-dried to obtain a resist pattern.

With respect to the resist patterns obtained in Exposure Condition (1) and Exposure Condition (2), the pattern profile and pattern collapse were evaluated.

### Pattern Profile:

An exposure dose for reproducing a line-and-space (1/1) pattern with a mask size of 130 nm was taken as an optimal exposure dose, and the profile at the optimal exposure dose was observed by a scanning electron microscope (SEM).

### Pattern Collapse:

The exposure dose for reproducing a 1:1 line-and-space mask pattern of 130 nm was taken as an optimal exposure dose and when a dense 1:1 mask-and-space pattern was exposed with the optimal exposure dose, the line width (CDmin) at which the pattern in a finer mask size was resolved without collapsing was taken as a limit line width (CDmin) of pattern collapse. A smaller value indicates that a finer pattern can be resolved without collapse of the pattern and the pattern collapse less occurs.

**Table 3**

| Example | Resin (g) | | Episulfide Compound (g) | | Acid Generator (g) | | solvent (ratio by mass) | Basic Compound (0.02g) | Surfactant (5mg) | Pattern Profile | CDmin (nm) |
|---|---|---|---|---|---|---|---|---|---|---|---|
| 1 | 11 | 1.63 | EPS-1 | 0.75 | z38 | 0.12 | At/B1(80/20) | PEA | W-1 | Rectangular | 60 |
| 2 | 11 | 1.63 | EPS-2 | 0.75 | z38 | 0.11 | Af/B1(80/20) | PEA | W-1 | Rectangular | 65 |
| 3 | 11 | 1.54 | EPS-3 | 0.86 | z38 | 0.13 | A1/B1(60/40) | PEA | W-1 | Rectangular | 76 |
| 4 | 11 | 0.89 | EPS-4 | 1.50 | z38 | 0.11 | A1/B1(60/40) | PEA | W-1 | Rectangular | 80 |
| 5 | 3 | 0.89 | EPS-4 | 1.50 | z60 | 0.13 | A1/B2(6D/40) | TOA | W-2 | Rectangular | 87 |
| 6 | 4 | 2.01 | EPS-4 | 0.38 | z64 | 0.11 | A1/A3(60/40) | TOA | W-3 | Rectangular | 90 |
| 7 | 6 : | 1.77 | EPS-3 | 0.63 | z70 | 0.12 | A1/B2(60/40) | DIA | W-3 | Rectangular | 87 |
| 8 | 7 | 1.78 | EPS-4 | 0.63 | z70 | 0.11 | A1/B2(80/20) | DIA | W-2 | Rectangular | 76 |
| 9 | 9 | 0.89 | EPS-1 | 1.50 | z72 | 0.11 | A1/B1(80/20) | PEA | W-4 | Rectangular | 70 |
| 10 | 13 | 1.40 | EPS-1 | 1.00 | z72 | 0.13 | A1/B1(80/20) | PEA | W-6 | Rectangular | 59 |
| 11 | 13 | 1.89 | EPS-2 | 0.62 | z38 | 0.11 | A1/B1(80/20) | PBI | W-6 | Rectangular | 64 |
| 12 | 13 | 2.01 | EPS-3 | 0.38 | z38 | 0.11 | A1/B1(80/20) | PBI | W-1 | Rectangular | 71 |
| 13 | 13 | 2.00 | EPS-4 | 0.45 | z69 | 0.11 | A1/B2(80/20) | PBl | W-1 | Rectangular | 75 |
| 14 | 12 | 1.90 | EPS-3 | 0.50 | z60 | 0.12 | A1/B1(80/20) | PEA | W-2 | Rectangular | 74 |
| 15 | 18 | 1.68 | EPS-2 | 0.80 | z60 | 0.11 | A1/B1(80/20) | PEA | W-1 | Rectangular | 75 |
| 16 | 18 | 1.40 | EPS-1 | 1.00 | z60 | 0.13 | A1/B1(80/20) | PEA | W-4 | Rectangular | 67 |
| 17 | 19 | 1.63 | EPS-3 | 0.75 | z60 | 0.11 | A1/B1(80/20) | PEA | W-6 | Rectangular | 73 |
| 18 | 19 | 0.89 | EPS-1 | 1.51 | z68 | 0.12 | A1/B1(80/20) | PEA | W-4 | Rectangular | 65 |
| 19 | 18 | 2.01 | EPS-2 | 0.38 | z68 | 0.11 | A1/B1(80/20) | PEA | W-1 | Rectangular | 69 |
| 20 | 20 | 2.02 | EPS-3 | 0.38 | z38 | 0.13 | A1/A3(80/20) | DIA | W-3 | Rectangular | 74 |
| 21 | 15 | 1.77 | EPS-4 | 0.63 | z38 | 0.11 | A1/A3(80/20) | DIA | W-2 | Rectangular | 78 |
| 22 | 15 | 1.90 | EPS-3 | 0.52 | z38 | 0.11 | A1/B1(80/20) | PEA | W-4 | Rectangular | 69 |
| 23 | 14 | 1.77 | EPS-1 | 0.64 | z68 | 0.11 | A1/B1(80/20) | PEA | W-1 | Rectangular | 58 |
| 24 | 14 | 1.54 | EPS-2 | 0.86 | z38 | 0.12 | A1/B1(80/20) | TOA | W-1 | Rectangular | 63 |
| 25 | 14 | 1.89 | EPS-4 | 0.61 | z38 | 0.13 | A1/B2(80/20) | PEA | W-4 | Rectangular | 75 |
| 26 | 15 | 1.77 | EPS-1 | 0.63 | z68 | 0.12 | A1/B1(80/20) | PEA | W-4 | Rectangular | 62 |
| 27 | 15 | 1.57 | EPS-2 | 0.87 | z38 | 0.11 | A1/B1(80/20) | PEA | W-4 | Rectangular | 67 |
| 28 | 15 | 1.89 | EPS-3 | 0.37 | z38 | 0.12 | A1/B1(80/20) | PEA | W-4 | Rectangular | 75 |
| 29* | 14 | 2.14 | EPS-1 | 0.25 | z60 | 0.11 | A1/B1(80/20) | PEA | W-4 | Rectangular | 59 |
| 30* | 15 | 1.78 | EPS-1 | 0.63 | z60 | 0.11 | A1/B1(80/20) | PEA | W-4 | Rectangular | 58 |
| 31* | 11 | 1.93 | EPS-1 | 0.50 | z60 | 0.11 | Al/B1(80/20) | PEA | W-4 | Rectangular | 62 |

| Comparative Example | | | | | | | | | | | |
|---|---|---|---|---|---|---|---|---|---|---|---|
| 1 | 1 | 2.00 | - | - | z38 | 0.12 | A1/B1(80/20) | PEA | W-1 | × | - |
| 2 | 3 | 2.00 | - | - | z38 | 0.11 | A1/B1(80/20) | PEA | W-1 | × | - |
| 3 | 3 | 2.00 | - | - | z60 | 0.12 | A1/B1(80/20) | PEA | W-4 | Slightly tapered | 128 |
| 4 | 15 | 1.50 | EPO-1 | 0.89 | z38 | 0.13 | A1/B1(80/20) | PEA | W-4 | Rectangular | 100 |

### The abbreviations in the Table are as follows.

### [Episulfide Compound and Comparative Compound Thereof]

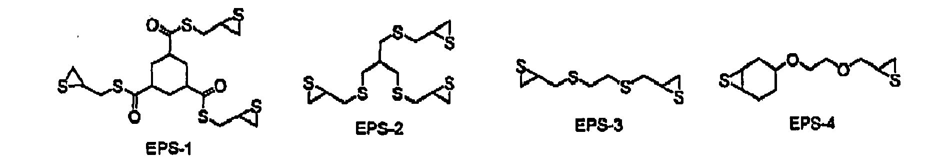

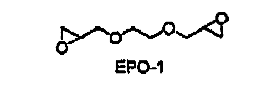

### [Basic Compound]

TPI: 2,4,5-triphenylimidazole
TPSA: triphenylsulfonium acetate
HEP: N-hydroxyethylpiperidine
DIA: 2,6-diisopropylaniline
DCMA: dicyclohexylmethylamine
TPA; tripentylamine
HAP: hydroxyantipyrine
TBAH: tetrabutylammonium hydroxide
TMEA: tris(methoxyethoxyethyl)amine
PEA: N-phenyldiethanolamine
TOA: trioctylamine
DBN: 1,5-duazabicyclo [4.3. 0] non-5-ene
PBI: 2-phenylbenzimidazole
DHA: N,N-dihexylaniline

### [Surfactant]

W-1: Megafac F176 (produced by Dainippon Ink & Chemicals, Inc.) (fluorine-containing)
W-2: Megafac R08 (produced by Dainippon Ink & Chemicals, Inc.) (fluorine- and silicon-containing)
W-3: polysiloxane polymer KP-341 (produced by Shin-Etsu Chemical Co., Ltd,) (silicon-containing)
W-4: Troysol S-366 (produced by Troy Chemical)
W-5: PF656 (produced by OMNOVA, fluorine-containing)
W-6: PF6320 (produced by OMNOVA, fluorine-containing)

### [Solvent]

A1: propylene glycol monomethyl ether acetate
A2: 2-heptanone
A3: cyclohexanone
A4: γ-butyrolactone
B1: propylene glycol monomethyl ether
B2: ethyl lactate
B3: propylene carbonate

It is seen from the results in Table 3 that the negative resist composition of the present invention exhibits good performance in terms of pattern profile and pattern collapse not only in normal exposure but also in immersion exposure.

According to the present invention, a negative resist composition enabling formation of a fine good pattern, exhibiting good resolution and ensuring excellent pattern collapse margin, and a pattern forming method using the composition can be provided. Furthermore, a negative resist composition capable of elevating the refractive index of a resist film by virtue of containing a compound having an episulfide structure and in turn applicable to the formation of a finer pattern, and a pattern forming method using the composition can be provided.

The entire disclosure of each and every foreign patent application from which the benefit of foreign priority has been claimed in the present application is incorporated herein by reference, as if fully set forth.

## Claims

1. A negative resist composition, comprising:
(A) a compound having at least one episulfide structure represented by formula (1);
(B) an alkali-soluble resin; and
(C) a compound capable of generating an acid upon irradiation with actinic rays or radiation:

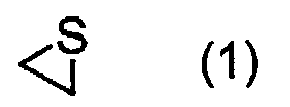

2. The negative resist composition according to claim 1,
wherein the compound as the component (A) is a compound represented by formula (2): 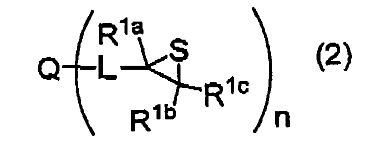 wherein R^{1a} to R^{1c} each independently represents a hydrogen atom, an alkyl group, a cycloalkyl group or an aryl group;
L represents a single bond or a divalent organic group;
Q represents an O atom, an S atom or an n-valent organic group;
R^{1a}, R^{1b} or R^{1c} and L may combine with each other to form a ring;
n represents an integer of 1 or more, provided that when Q is an O atom or an S atom, n is 2; and
when n is an integer of 2 or more, a plurality of R^{1a}'s, R^{1b}'s, R^{1c}'s and L's may be the same or different.

3. The negative resist composition according to claim 2,
wherein in formula (2), Q has an S atom and/or L has an S atom.

4. The negative resist composition according to claim 2,
wherein in formula (2), n is an integer of 2 or more.

5. The negative resist composition according to claim 1,
wherein the resin as the component (B) has solubility in an alkali developer and contains a repeating unit having a group capable of reacting with the compound having at least one episulfide structure represented by formula (1) under an action of an acid.

6. The negative resist composition according to claim 1,
wherein the resin as the component (B) contains a repeating unit having at least one of a carboxyl group and a hydroxyl group.

7. A pattern forming method, comprising:
forming a resist film from the negative resist composition according to claim 1; and
exposing and developing the resist film.
